# EUROPEAN PATENT APPLICATION

(11) **EP 3 208 864 A1**
(43) Date of publication of application: **23.08.2017**
(21) Application number: 16200082.2
(22) Date of filing: 22.11.2016
(51) Int. Cl.: H01L 51/54

(54) **ORGANIC LIGHT-EMITTING DEVICE**

(30) Priority: 18.02.2016 KR 20160019160
(71) Applicant: Samsung Display Co., Ltd., Gyeonggi-Do (KR)
(72) Inventor: KIM, Seulong, Gyeonggi-do, (KR); KIM, Younsun, Gyeonggi-do, (KR); SHIN, Dongwoo, Gyeonggi-do, (KR); LEE, Jungsub, Gyeonggi-do, (KR); LIM, Jino, Gyeonggi-do, (KR); JEONG, Hyein, Gyeonggi-do, (KR)
(74) Representative: Leanse, Thomas Gordon Hamilton

(57) **Abstract**

An organic light-emitting device comprising a first electrode, a second electrode facing the first electrode, an emission layer between the first electrode and the second electrode, a hole transport region between the first electrode and the emission layer, and an electron transport region between the emission layer and the second electrode; wherein the electron transport region comprises at least one compound represented by Formula 1, and the emission layer comprises at least one compound represented by one selected from Formulae 2-1, 2-2, and 2-3:

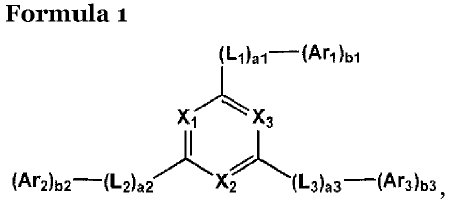

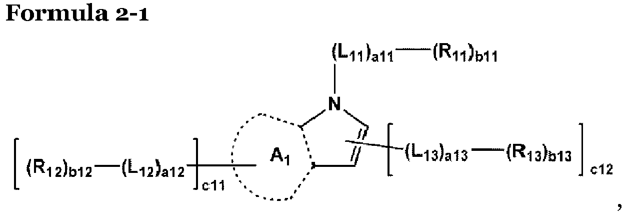

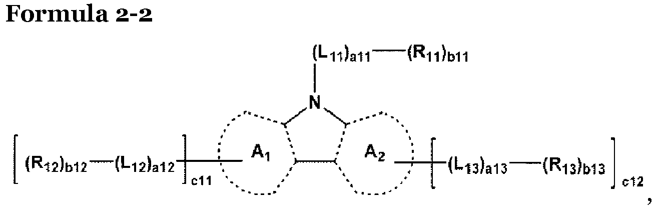

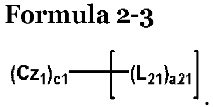

## Description

### FIELD OF THE INVENTION

The present invention is related to an organic light-emitting device.

### BACKGROUND OF THE INVENTION

Organic light-emitting devices are self-emission devices that have may wide viewing angles, high contrast ratios, short response times, and/or excellent brightness, driving voltage, and/or response speed characteristics, and may produce full-color images.

An organic light-emitting device may comprise a first electrode on a substrate, and a hole transport region, an emission layer, an electron transport region, and a second electrode sequentially stacked on the first electrode in this stated order. Holes provided by the first electrode may move through the hole transport region toward the emission layer, and electrons provided by the second electrode may move through the electron transport region toward the emission layer. Carriers (such as holes and electrons) may recombine in the emission layer to produce excitons. These excitons may transition (e.g., radiatively decay) from an excited state to the ground state to thereby generate light.

### SUMMARY OF THE INVENTION

The present invention provides an organic light-emitting device having high efficiency and a long lifespan.

Accordingly, the present invention provides an organic light-emitting device comprising:
a first electrode;
a second electrode facing the first electrode;
an emission layer between the first electrode and the second electrode;
a hole transport region between the first electrode and the emission layer; and
an electron transport region between the emission layer and the second electrode,
wherein the electron transport region comprises at least one compound represented by Formula 1, and
the emission layer comprises at least one compound represented by one selected from Formulae 2-1, 2-2, and 2-3:

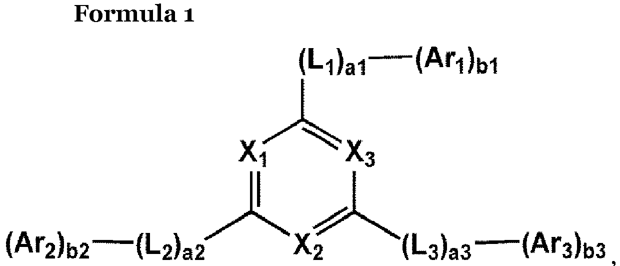

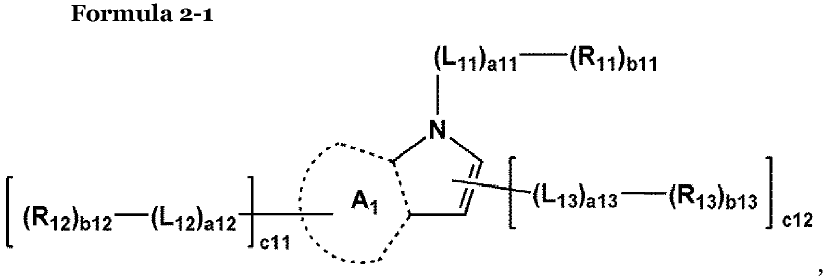

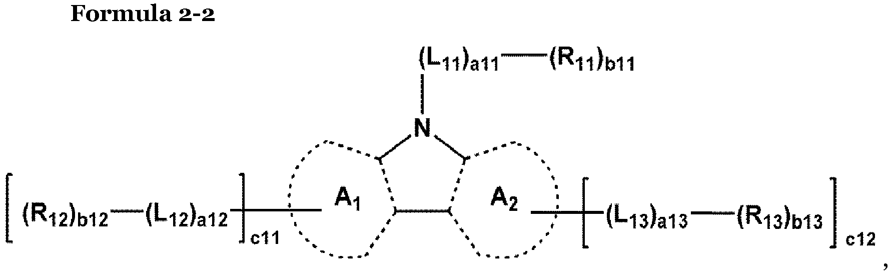

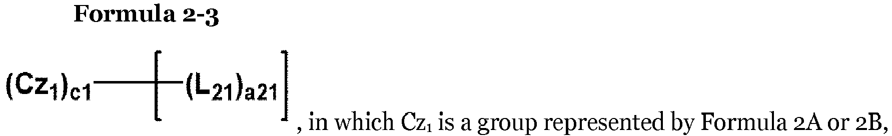

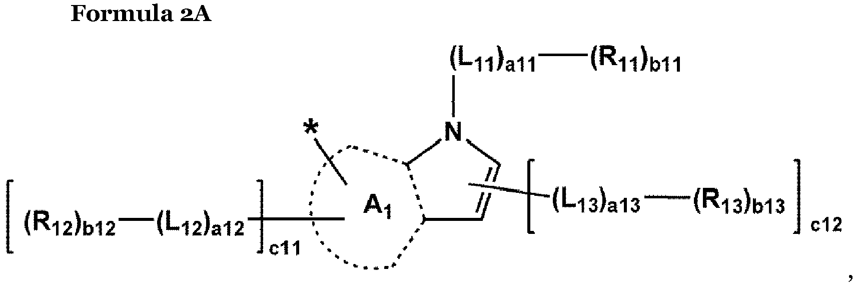

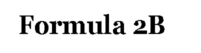

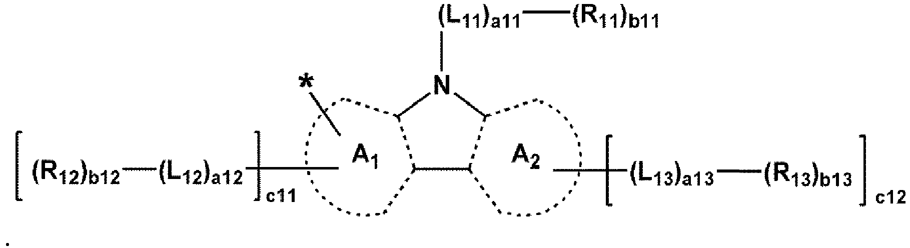

In Formula 1, X₁ is N or C(R₁), X₂ is N or C(R₂), X₃ is N or C(R₃), provided at least one selected from X₁ to X₃ is N,
R₁ to R₃ areeach independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₃-C₁₀ cycloalkenyl group, a substituted or unsubstituted C₆-C₆₀ aryl group, and -Si(Q₁)(Q₂)(Q₃),
L₁ to L₃ in Formula 1 are each independently selected from a substituted or unsubstituted C₃-C₁₀ cycloalkylene group, a substituted or unsubstituted C₃-C₁₀ cycloalkenylene group, a substituted or unsubstituted C₆-C₆₀ arylene group, a substituted or unsubstituted divalent non-aromatic condensed C8-C60 polycyclic group, and a group represented by any of Formulae 3A to 3G, 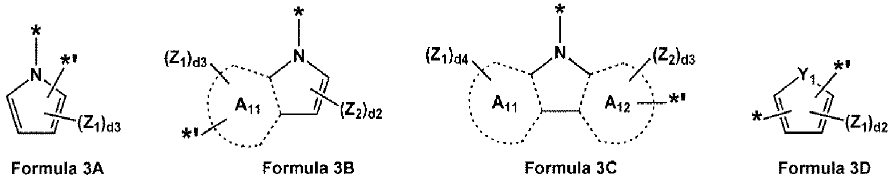 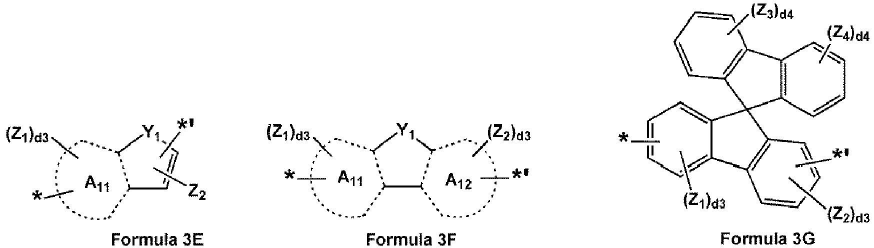 a1 to a3 in Formula 1 are each independently 0, 1, 2, 3, 4, or 5,
Ar₁ to Ar₃ in Formula 1 are each independently selected from a substituted or unsubstituted C₁-C₆₀ alkyl group, a substituted or unsubstituted C₃-C₁₀ cycloalkyl group, a substituted or unsubstituted C₃-C₁₀ cycloalkenyl group, a substituted or unsubstituted C₆-C₆₀ aryl group, a substituted or unsubstituted monovalent non-aromatic condensed C8-C60 polycyclic group, -Si(Q₁₎(Q₂)(Q₃), and a group represented by any of Formulae 4A to 4G, 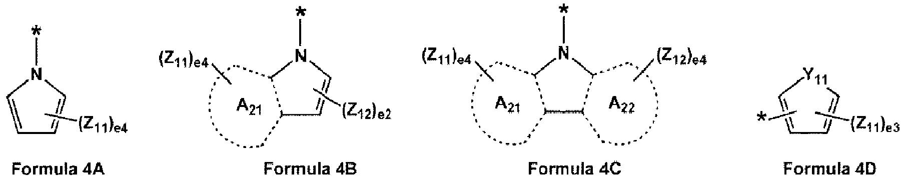 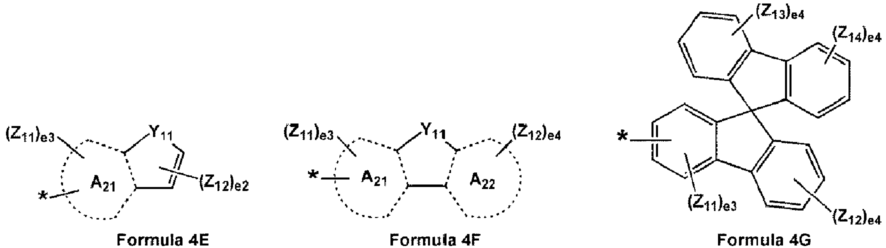 provided that at least one selected from Ar₁ to Ar₃ is a substituted or unsubstituted aryl group having three or more rings condensed (e.g., fused) with one another, or a substituted or unsubstituted monovalent non-aromatic condensed C8-C60 polycyclic group having three or more rings condensed (e.g., fused) with one another,
b1 to b3 in Formula 1 are each independently 1, 2, or 3, provided that each of b1 to b3 is 1 when each respective a1 to a3 is zero,
rings A₁₁, A₁₂, A₂₁, and A₂₂ in Formulae 3B, 3C, 3E, 3F, 4B, 4C, 4E, and 4F are each independently a C₅-C₆₀ carbocyclic group,
Y₁ in Formulae 3D to 3F is oxygen (O), sulfur (S), C(Z₃)(Z₄), N(Z₅), or Si(Z₆)(Z₇),
Y₁₁ in Formulae 4D to 4F is O, S, C(Z₁₃)(Z₁₄), N(Z₁₅), or Si(Z₁₆)(Z₁₇),
Z₁ to Z₇ and Z₁₁ to Z₁₇ in Formulae 3A to 3G and 4A to 4G are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃),
* and *' in Formulae 3A to 3G and 4A to 4G each indicate a binding site to a neighboring atom,
c1 is 2, 3, 4, or 5, provided that c1 is 2 when a21 is zero, and two or more Cz₁(s) may be identical to or different from each other,
in Formulae 2-1, 2-2, 2A, and 2B, rings A₁ and A₂ are each independently a C₅-C₆₀ carbocyclic group or a C₂-C₆₀ heterocyclic group,
in Formulae 2-1 to 2-3, 2A, and 2B, L₁₁ to L₁₃ and L₂₁ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
in Formulae 2-1 to 2-3, 2A, and 2B, a11 to a13 and a21 are each independently 0, 1, 2, 3, 4, or 5,
in Formulae 2-1, 2-2, 2A, and 2B R₁₁ to R₁₃ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃),-N(Q₁)(Q₂), -B(Q₁)(Q₂), -C(=O)(Q₁), -S(=O)₂(Q₁), and -P(=O)(Q₁)(Q₂),
b11 to b13 in Formulae 2-1, 2-2, 2A, and 2B are each independently be 1, 2, 3, 4, or 5, provided that each of b11 to b13 is 1 when each respective a11 to a13 is zero,
c11 and c12 in Formulae 2-1, 2-2, 2A, and 2B are each independently 0, 1, or 2,
provided that the compound represented by one selected from Formulae 2-1, 2-2, and 2-3 is not CBP,
d2 in Formulae 3B and 3D is an integer selected from 0 to 2,
d3 in Formulae 3A to 3C and 3E to 3G is an integer selected from 0 to 3,
d4 in Formulae 3C and 3G is an integer selected from 0 to 4,
e2 in Formulae 4B and 4E is an integer selected from 0 to 2,
e3 in Formulae 4D to 4G is an integer selected from 0 to 3,
e4 in Formulae 4A to 4C, 4F, and 4G is an integer selected from 0 to 4, and
the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed C8-C60 polycyclic group, the substituted divalent non-aromatic condensed 8- to 60-membered heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed C8-C60 polycyclic group, and the substituted monovalent non-aromatic condensed 8- to 60-membered heteropolycyclic group are each independently substituted with one or more substituent selected from the group consisting of:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂),
wherein Q₁ to Q₃, Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C8-C60 polycyclic group, and a monovalent non-aromatic condensed 8- to 60-membered heteropolycyclic group.

### BRIEF DESCRIPTION OF THE DRAWINGS

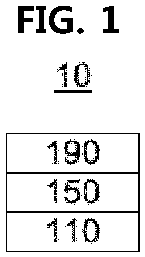

FIGS. 1-3 are schematic views of organic light-emitting devices according to embodiments of the present disclosure.

### DETAILED DESCRIPTION OF THE INVENTION

Expressions such as "at least one of", "one of", and "selected from", when preceding a list of elements, modify the entire list of elements and do not modify the individual elements of the list.

The thicknesses of layers, films, panels, regions, etc., may be exaggerated in the drawings for clarity. It will be understood that when an element such as a layer, film, region, or substrate is referred to as being "on" another element, it can be directly on the other element or intervening element(s) may also be present. In contrast, when an element is referred to as being "directly on" another element, no intervening elements are present.

An organic light-emitting device according to the present invention comprises: a first electrode; a second electrode facing the first electrode; an emission layer between the first electrode and the second electrode; a hole transport region between the first electrode and the emission layer; and an electron transport region between the emission layer and the second electrode, wherein the electron transport region comprises at least one compound represented by Formula 1, and the emission layer comprises at least one compound represented by one selected from Formulae 2-1, 2-2, and 2-3:

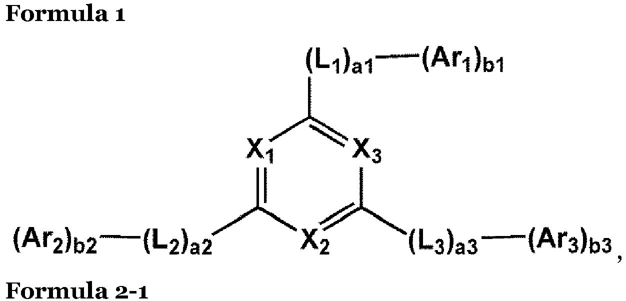

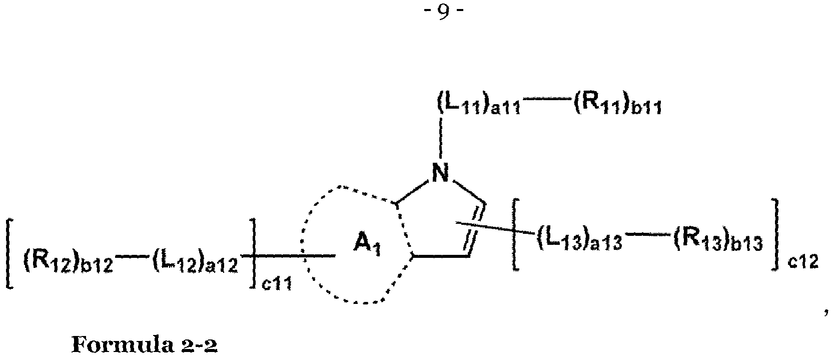

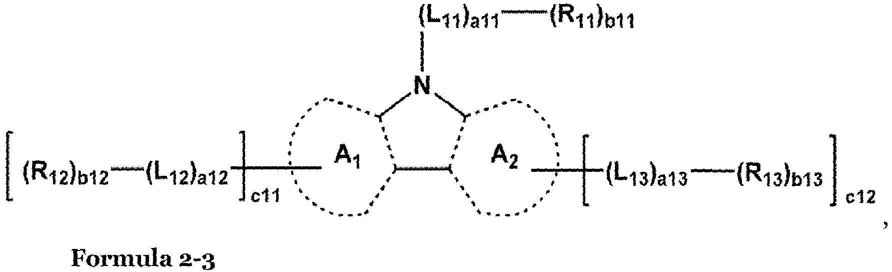

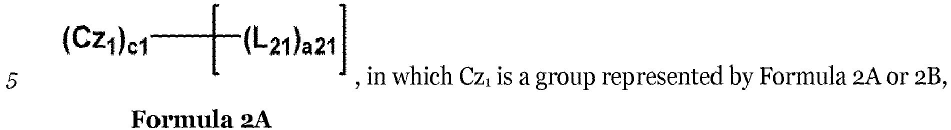

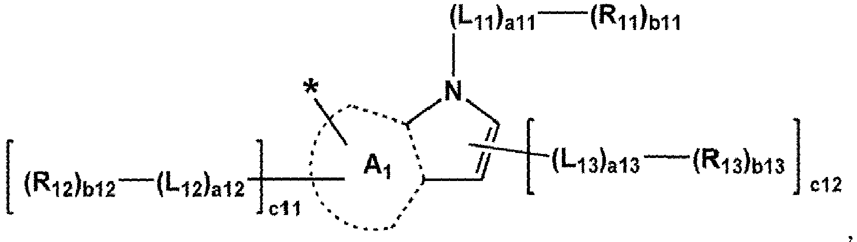

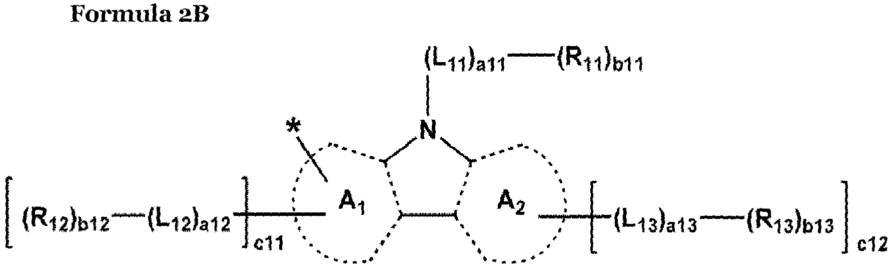

X₁ in Formula 1 is N or C(R₁), X₂ is N or C(R₂), X₃ is N or C(R₃), provided at least one selected from X₁ to X₃ is N.

In one or more embodiments, two or three selected from X₁ to X₃ in Formula 1 may be N, but embodiments of the present disclosure are not limited thereto. R₁ to R₃ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₃-C₁₀ cycloalkenyl group, a substituted or unsubstituted C₆-C₆₀ aryl group, and -Si(Q₁)(Q₂)(Q₃). Q₁ to Q₃ are each independently the same as described above.

In one or more embodiments, R₁ to R₃ in Formula 1 may each independently be selected from hydrogen, deuterium, a C₁-C₂₀ alkyl group, a C₁-C₂₀ alkoxy group, a phenyl group, a biphenyl group, and a terphenyl group, but embodiments of the present disclosure are not limited thereto.

L₁ to L₃ in Formula 1 are each independently selected from a substituted or unsubstituted C₃-C₁₀ cycloalkylene group, a substituted or unsubstituted C₃-C₁₀ cycloalkenylene group, a substituted or unsubstituted C₆-C₆₀ arylene group, a substituted or unsubstituted divalent non-aromatic condensed C8-C60 polycyclic group, and a group represented by any of Formulae 3A to 3G. Formulae 3A to 3G are described above.

In one or more embodiments, L₁ to L₃ in Formula 1 may each independently be selected from the group consisting of:
a phenylene group, a naphthylene group, a phenanthrenylene group, an anthracenylene group, a fluoranthenylene group, a triphenylenylene group, a pyrenylene group, and a chrysenylene group;
a phenylene group, a naphthylene group, a phenanthrenylene group, an anthracenylene group, a fluoranthenylene group, a triphenylenylene group, a pyrenylene group, and a chrysenylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃); and
a group represented by any of Formulae 3A to 3G,
wherein Q₃₁ to Q₃₃ may each independently be selected from the group consisting of:
   a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
   a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
   but embodiments of the present disclosure are not limited thereto.
   a1 to a3 in Formula 1 are each independently be 0, 1, 2, 3, 4, or 5. a1 indicates the number of L₁(s). When a1 is zero, *-(L₁)ₐ₁-*' may be a single bond, and when a1 is two or more, the two or more L₁(s) may be identical to or different from each other. a2 and a3 may each independently be the same as described herein in connection with a1 and the structure of Formula 1.

In one or more embodiments, a1 to a3 in Formula 1 may each independently be 0, 1, or 2, but embodiments of the present disclosure are not limited thereto.

Ar₁ to Ar₃ in Formula 1 are each independently selected from a substituted or unsubstituted C₁-C₆₀ alkyl group, a substituted or unsubstituted C₃-C₁₀ cycloalkyl group, a substituted or unsubstituted C₃-C₁₀ cycloalkenyl group, a substituted or unsubstituted C₆-C₆₀ aryl group, a substituted or unsubstituted monovalent non-aromatic condensed C8-C60 polycyclic group, a group represented by any of Formulae 4A to 4G, and - Si(Q₁)(Q₂)(Q₃), and at least one selected from Ar₁ to Ar₃ may be a substituted or unsubstituted aryl group having three or more rings condensed (e.g., fused) with one another or a substituted or unsubstituted monovalent non-aromatic condensed C8-C60 polycyclic group having three or more rings condensed (e.g., fused) with one another. Q₁ to Q₃ and Formulae 4A to 4G are described above.

In one or more embodiments, Ar₁ to Ar₃ in Formula 1 may each independently be selected from the group consisting of:
a phenyl group, a naphthyl group, a phenanthrenyl group, an anthracenyl group, a fluoranthenyl group, a triphenylenyl group, a pyrenyl group, and a chrysenyl group;
a phenyl group, a naphthyl group, a phenanthrenyl group, an anthracenyl group, a fluoranthenyl group, a triphenylenyl group, a pyrenyl group, and a chrysenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃);
a group represented by any of Formulae 4A to 4G; and -Si(Q₁)(Q₂)(Q₃), and
at least one selected from Ar₁ to Ar₃ may be selected from the group consisting of:
   a phenanthrenyl group, an anthracenyl group, a fluoranthenyl group, a triphenylenyl group, a pyrenyl group, and a chrysenyl group;
   a phenanthrenyl group, an anthracenyl group, a fluoranthenyl group, a triphenylenyl group, a pyrenyl group, and a chrysenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃); and
   a group represented by any of Formulae 4C, 4F, and 4G,
   but embodiments of the present disclosure are not limited thereto. Q₁ to Q₃ and Q₃₁ to Q₃₃ may each independently be the same as described above.
   b1 to b3 in Formula 1 may each independently be 1, 2, or 3 provided that each of b1 to b3 is 1 when each respective a1 to a3 is zero. b1 indicates the number of Ar₁(s) in Formula 1, wherein when b1 is two or more, two or more Ar₁(s) may be identical to or different from each other. When a1 is zero (i.e. when L1 is a single bond), b1 is 1 (i.e. only one Ar₁ is present). b2 and b3 may each independently be the same as described herein in connection with b1 and the structure of Formula 1.

In one or more embodiments, b1 to b3 in Formula 1 may each independently be 1 or 2, but embodiments of the present disclosure are not limited thereto.

Rings A₁₁, A₁₂, A₂₁, and A₂₂ in Formulae 3B, 3C, 3E, 3F, 4B, 4C, 4E, and 4F are independently be a C₅-C₆₀ carbocyclic group.

In one or more embodiments, rings A₁₁, A₁₂, A₂₁, and A₂₂ in Formulae 3B, 3C, 3E, 3F, 4B, 4C, 4E, and 4F may each independently be a cyclohexane group, a cyclohexene group, a benzene group, a naphthalene group, or a phenanthrene group.

Y₁ in Formulae 3D to 3F is oxygen (O), sulfur (S), C(Z₃)(Z₄), N(Z₅), or Si(Z₆)(Z₇), and Y₁₁ in Formulae 4D to 4F is O, S, C(Z₁₃)(Z₁₄), N(Z₁₅), or Si(Z₁₆)(Z₁₇).

Z₁ to Z₇ and Z₁₁ to Z₁₇ in Formulae 3A to 3G and 4A to 4G are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃). Q₃₁ to Q₃₃ may each independently be the same as described above.

In one or more embodiments, Z₁ to Z₇ and Z₁₁ to Z₁₇ in Formulae 3A to 3G and 4A to 4G may each independently be selected from hydrogen, deuterium, -F, -Cl, -Br, -I, a cyano group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃), but embodiments of the present disclosure are not limited thereto.
d2 in Formulae 3B and 3D is an integer selected from 0 to 2,
d3 in Formulae 3A to 3C and 3E to 3G is an integer selected from 0 to 3,
d4 in Formulae 3G is an integer selected from 0 to 4,
e2 in Formulae 4B is an integer selected from 0 to 2,
e3 in Formulae 4D is an integer selected from 0 to 3,
e4 in Formulae 4A to 4C, 4F, and 4G is an integer selected from 0 to 4, and
* and *' in Formulae 3A to 3G and 4A to 4G each indicate a binding site to a neighboring atom.

In one or more embodiments, Ar₁ to Ar₃ in Formula 1 may each independently be selected from groups represented by Formulae 4-1 to 4-52 and -Si(Q₁)(Q₂)(Q₃), and at least one selected from Ar₁ to Ar₃ may be selected from Formulae 4-4 to 4-52, but embodiments of the present disclosure are not limited thereto:

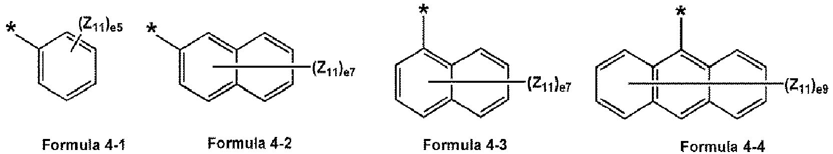

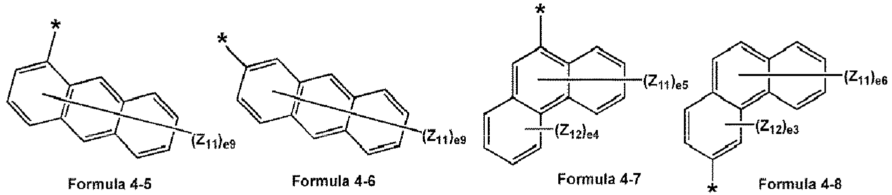

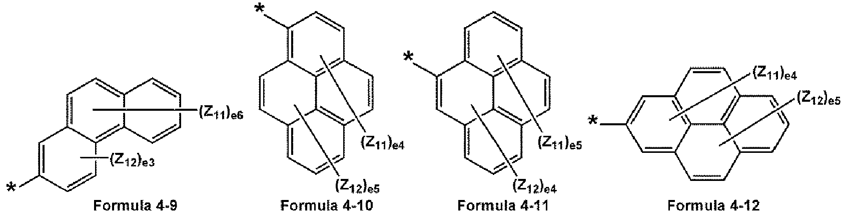

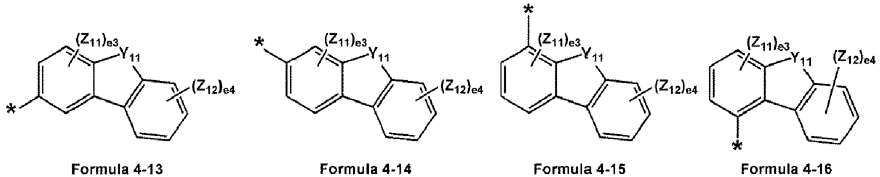

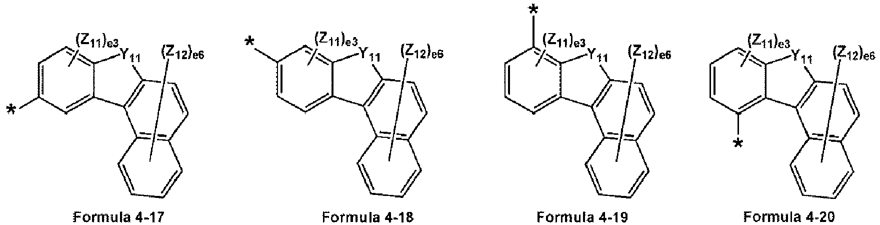

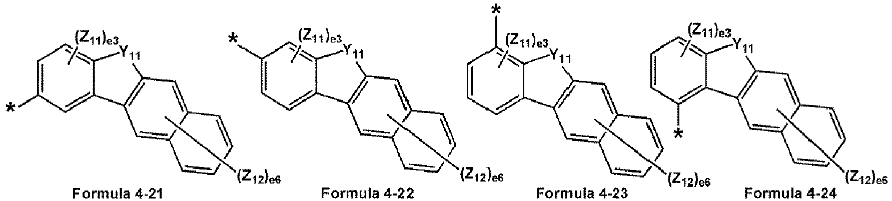

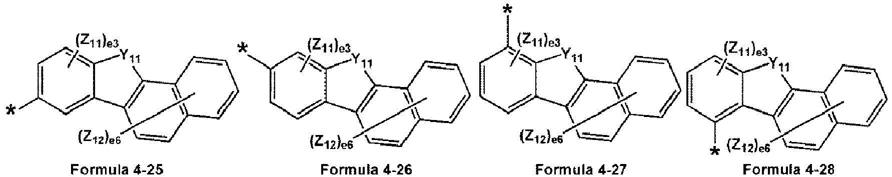

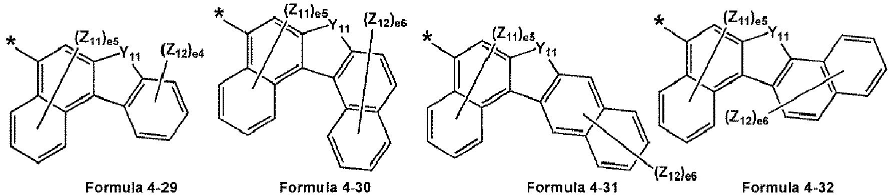

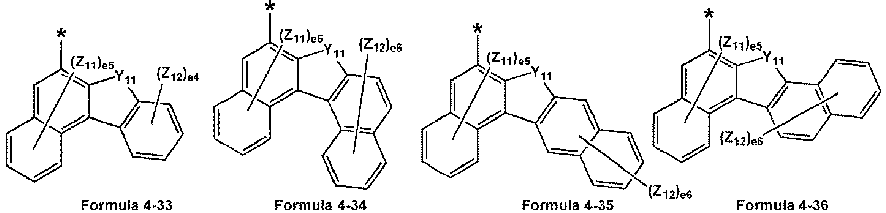

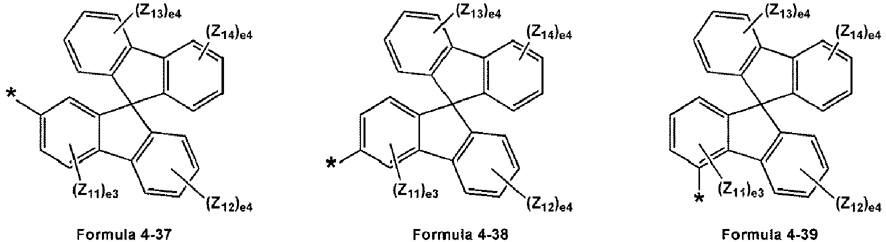

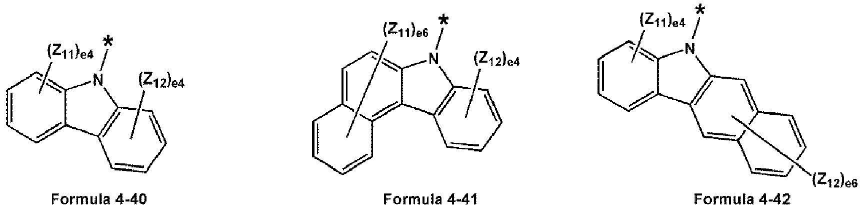

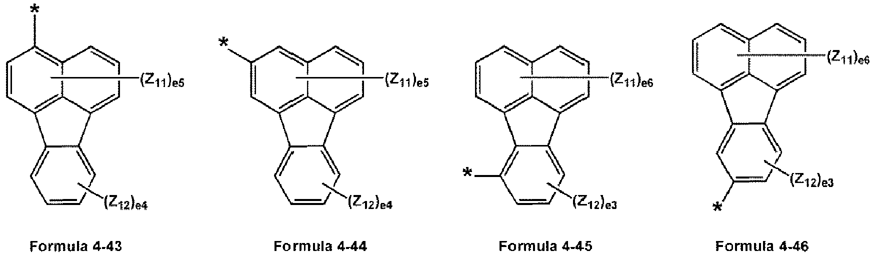

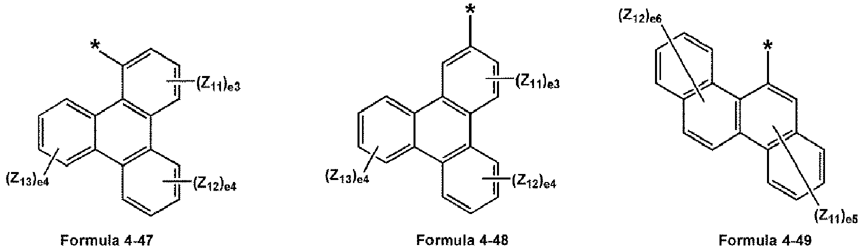

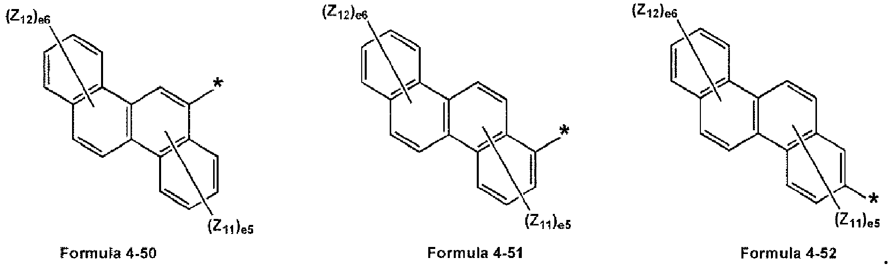

In Formulae 4-1 to 4-52,
Y₁₁ and Z₁₁ to Z₁₄ may each independently be the same as described above,
e2 may be an integer selected from 0 to 2,
e3 may be an integer selected from 0 to 3,
e4 may be an integer selected from 0 to 4,
e5 may be an integer selected from 0 to 5,
e6 may be an integer selected from 0 to 6,
e7 may be an integer selected from 0 to 7,
e9 may be an integer selected from 0 to 9, and
_{*} may indicate a binding site to a neighboring atom;
provided that at least one selected from Ar₁ to Ar₃ is a substituted or unsubstituted aryl group having three or more rings condensed with one another or a substituted or unsubstituted monovalent non-aromatic condensed polycyclic group having three or more rings condensed with one another.
Cz₁ in Formula 2-3 is a group represented by Formula 2A or 2B, c1 may be 2, 3, 4, or 5, provided that c1 is 2 when a21 is zero. Two or more Cz₁(s) may be identical to or different from each other.

In one or more embodiments, c1 in Formula 2-3 may be two.

For example, the emission layer may comprise a compound represented by Formula 2-3. In Formula 2-3, c1 may be two and a21 may be zero. When c1 is two and a21 is zero in Formula 2-3, *-(L₂₁)ₐ₂₁-*' in Formula 2-3 refers to a single bond. Therefore, two Cz₁(s) in Formula 2-3 may be connected (e.g., coupled) via a single bond. When a21 is 1, the Cz₁s in formula 2-3 are connected via a single group L₂₁. When a21 is 2 or more, the Cz₁s in formula 2-3 are connected via a plurality of L₂₁s (e.g. a plurality of concatenated L₂₁s). Rings A₁ and A₂ in Formulae 2-1, 2-2, 2A, and 2B are each independently a C₅-C₆₀ carbocyclic group or a C₂-C₆₀ heterocyclic group.

In one or more embodiments, rings A₁ and A₂ in Formulae 2-1, 2-2, 2A, and 2B may each independently be a cyclohexane group, a cyclohexene group, a benzene group, a naphthalene group, a phenanthrene group, a pyridine group, a pyrimidine group, a pyrazine group, a quinoline group, an isoquinoline group, a quinoxaline group, a quinazoline group, a benzoquinoline group, a benzoisoquinoline group, a benzoquinoxaline group, a benzoquinazoline group, or a phenanthroline group.

L₁₁ to L₁₃ and L₂₁ in Formulae 2-1 to 2-3, 2A, and 2B are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group.

In one or more embodiments, L₁₁ to L₁₃ and L₂₁ in Formulae 2-1 to 2-3, 2A, and 2B may each independently be selected from the group consisting of:
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₂₀ cycloalkyl group, a C₆-C₂₀ aryl group, a C₃-C₂₀ heteroaryl group, a biphenyl group, - Si(Q₃₁)(Q₃₂)(Q₃₃), -S(=O)₂(Q₃₁), and -P(=O)(Q₃₁)(Q₃₂),
wherein Q₃₁ to Q₃₃ may each independently be the same as described above.

In one or more embodiments,
L₁ to L₃ in Formula 1 may each independently be selected from groups represented by Formulae 3-1 to 3-14 and 3-17 to 3-24, and
L₁₁ to L₁₂ and L₂₁ in Formulae 2-1 to 2-3, 2A, and 2B may each independently be selected from groups represented by Formulae 3-1 to 3-100, but embodiments of the present disclosure are not limited thereto: 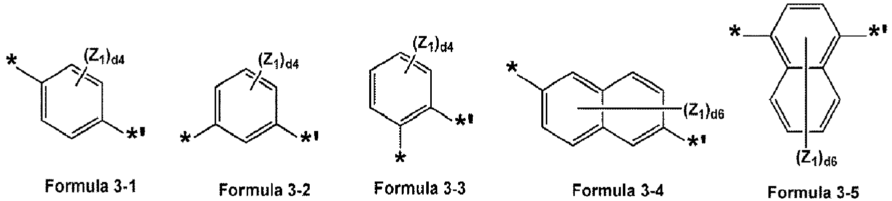 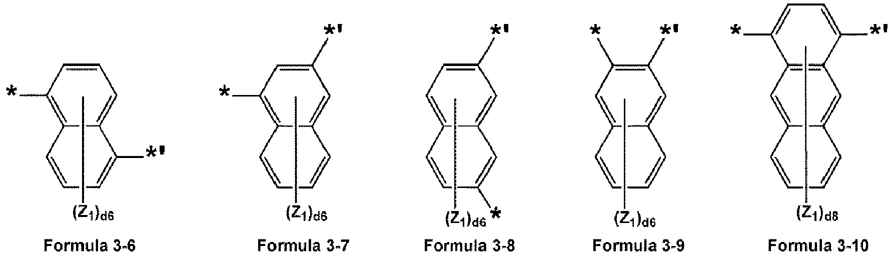 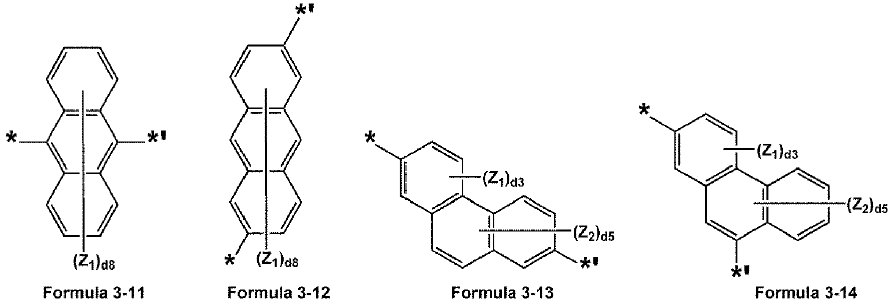 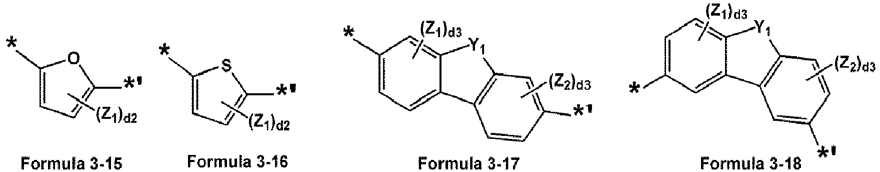 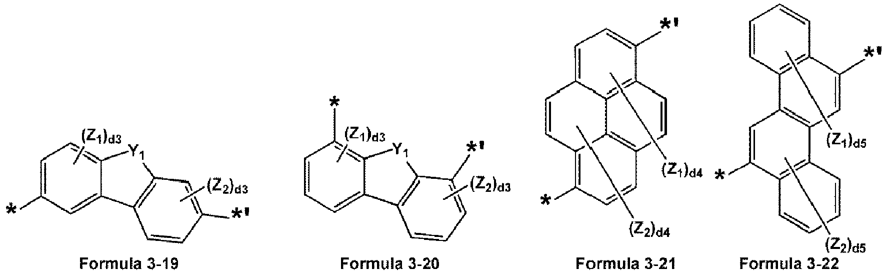 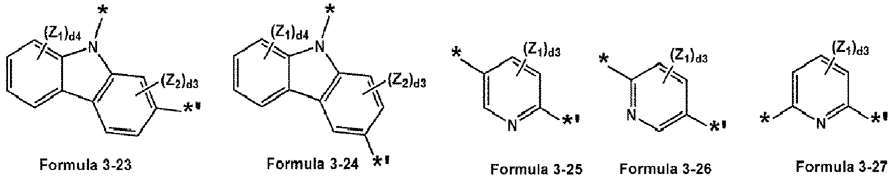 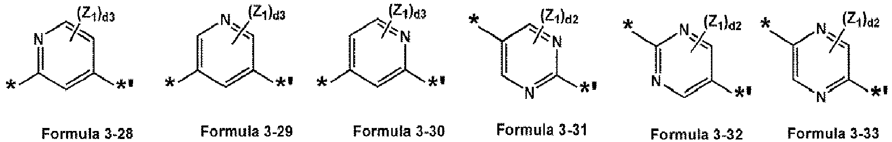 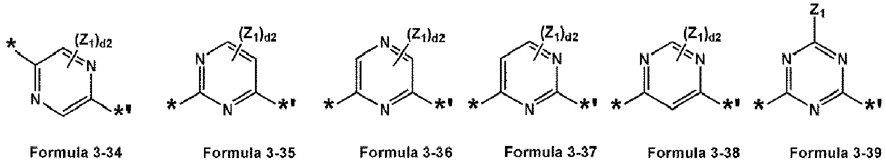 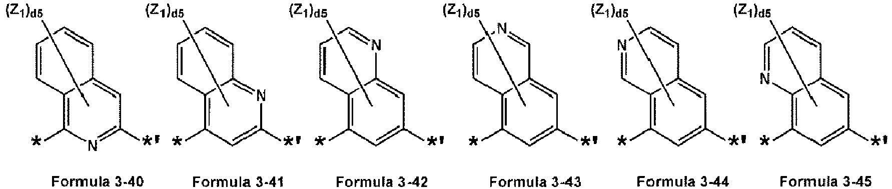 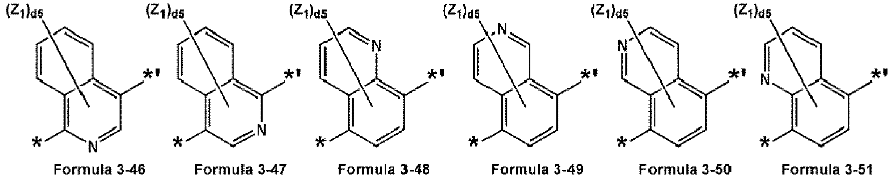 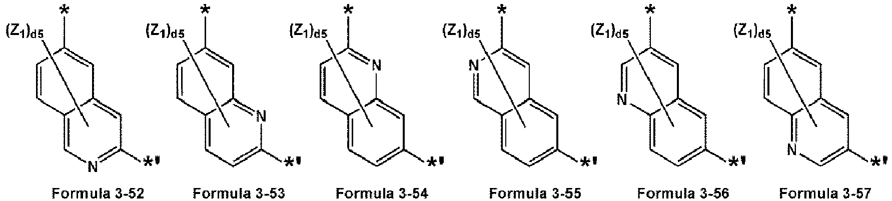 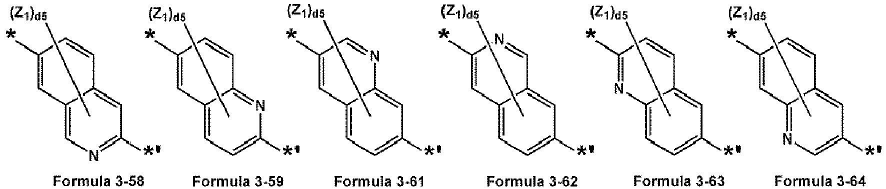 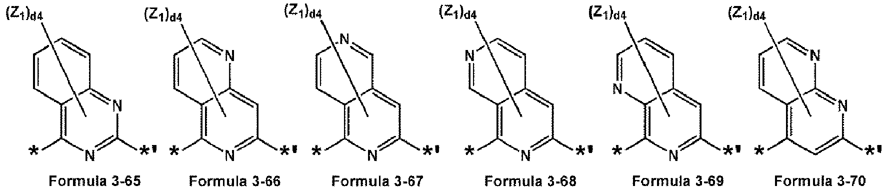 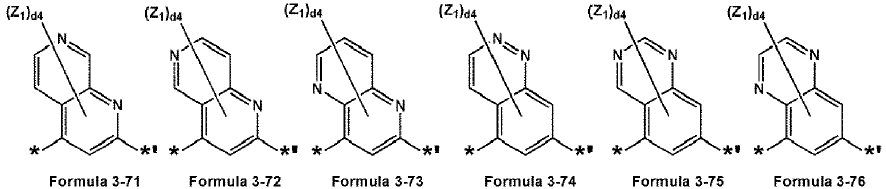 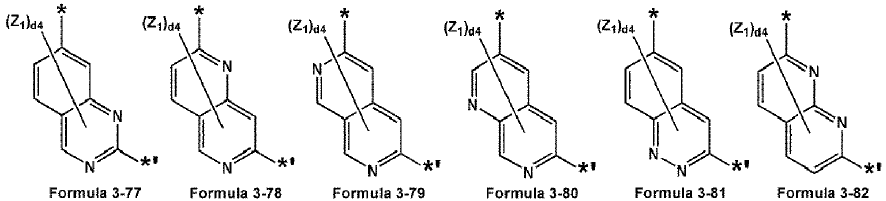 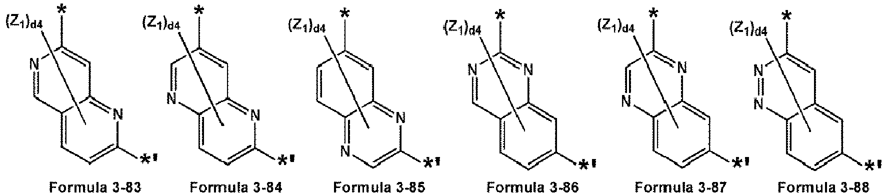 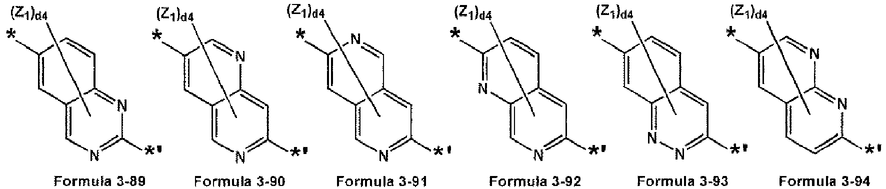 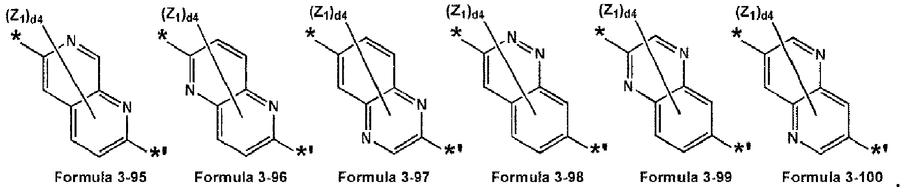 In Formulae 3-1 to 3-100,
Y₁ and Z₁ to Z₂ may each independently be the same as described above,
d2 may be an integer selected from 0 to 2,
d3 may be an integer selected from 0 to 3,
d4 may be an integer selected from 0 to 4,
d5 may be an integer selected from 0 to 5,
d6 may be an integer selected from 0 to 6,
d8 may be an integer selected from 0 to 8, and
_{*} and *' may each indicate a binding site to a neighboring atom.
a11 to a13 and a21 in Formulae 2-1 to 2-3, 2A, and 2B are each independently 0, 1, 2, 3, 4, or 5. a11 indicates the number of L₁₁(s), wherein when a11 is zero, *-(L₁₁)ₐ₁₁-*' refers to a single bond, and when a11 is two or more, two or more L₁₁(s) may be identical to or different from each other. a12, a13, and a21 may each independently be the same as described herein in connection with a11 and the structures of Formulae 2-1 to 2-3, 2A, and 2B.

In one or more embodiments, a11 in Formulae 2-1 to 2-3, 2A, and 2B may be 0, 1, 2, or 3, and a12, a13, and a21 may each independently be 0 or 1, but embodiments of the present disclosure are not limited thereto.
R₁₁ to R₁₃ in Formulae 2-1, 2-2, 2A, and 2B are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂). Q₁ to Q₃ may each independently be the same as described above.

In one or more embodiments, in Formulae 2-1, 2-2, 2A, and 2B,
R₁₁ to R₁₃ may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, and a hydrazono group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₂₀ cycloalkyl group, a C₆-C₂₀ aryl group, a C₃-C₂₀ heteroaryl group, a biphenyl group, -Si(Q₃₁)(Q₃₂)(Q₃₃),-S(=O)₂(Q₃₁), and -P(=O)(Q₃₁)(Q₃₂); and
-Si(Q₁)(Q₂)(Q₃), -S(=O)₂(Q₁), and -P(=O)(Q₁)(Q₂). Q₁ to Q₃ and Q₃₁ to Q₃₃ may each independently be the same as described above.

In one or more embodiments, in Formulae 1, 2-1, 2-2, 2A, and 2B,
R₁₁ may be selected from a group represented by any of Formulae 5-1 to 5-52, a group represented by any of Formulae 6-1 to 6-96, -Si(Q₁)(Q₂)(Q₃), -S(=O)₂(Q₁), and-P(=O)(Q₁)(Q₂),
R₁₂ and R₁₃ may each independently be selected from hydrogen, deuterium, -F,-Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a group represented by any of Formulae 5-1 to 5-52, a group represented by any of Formulae 6-1 to 6-96, -Si(Q₁)(Q₂)(Q₃), -S(=O)₂(Q₁), and -P(=O)(Q₁)(Q₂), but embodiments of the present disclosure are not limited thereto:

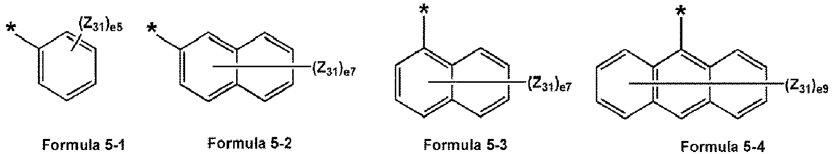

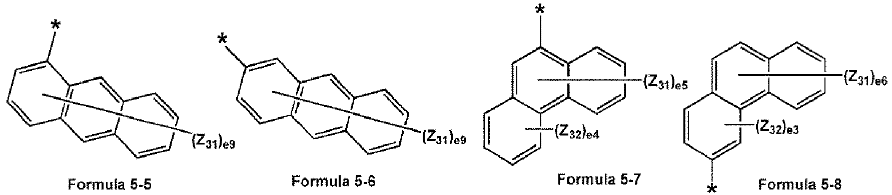

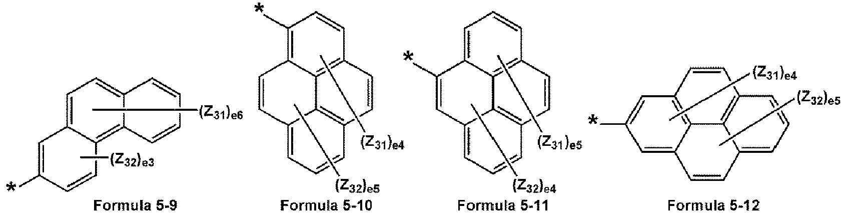

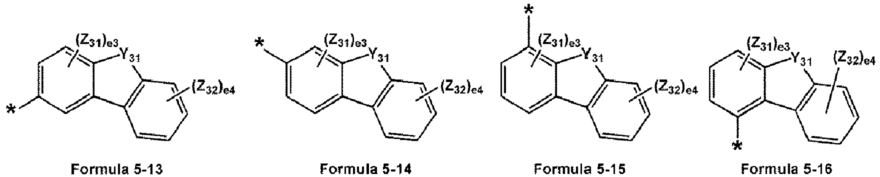

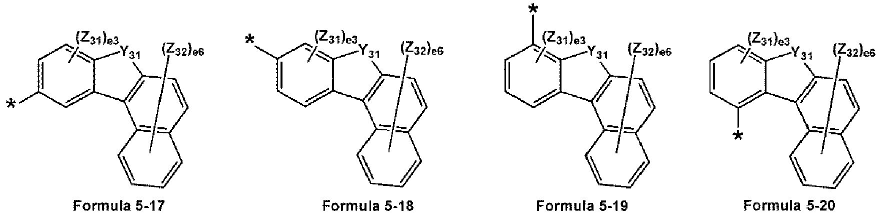

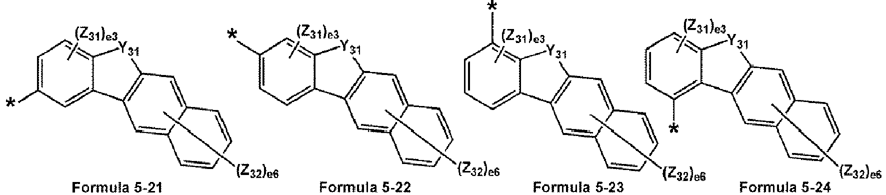

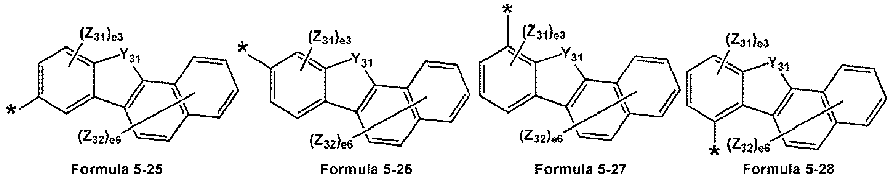

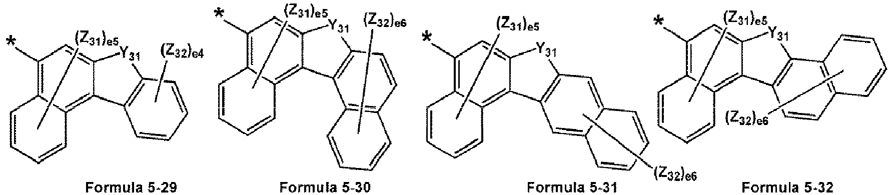

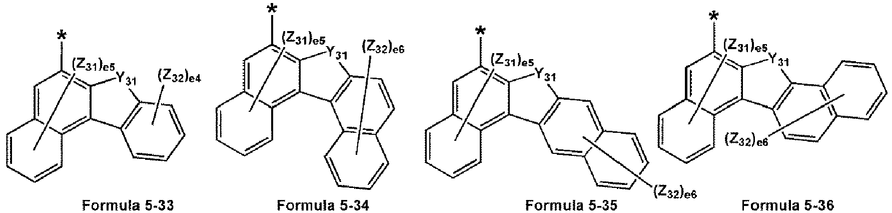

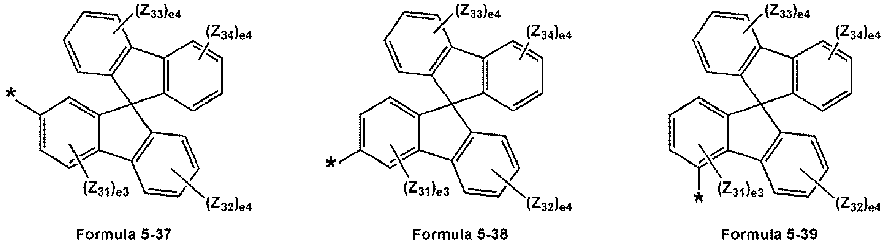

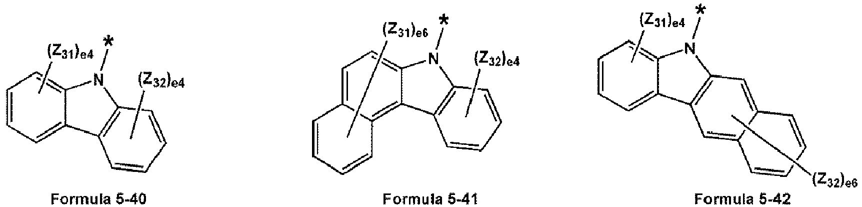

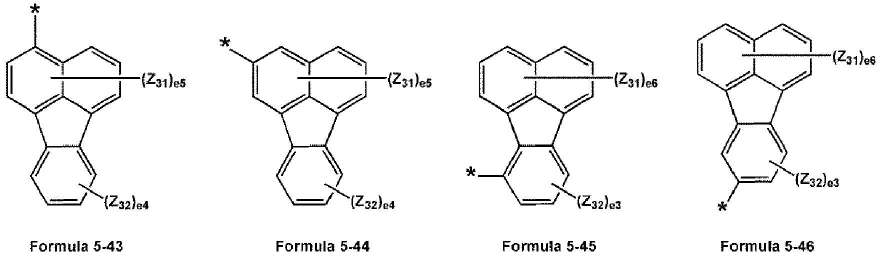

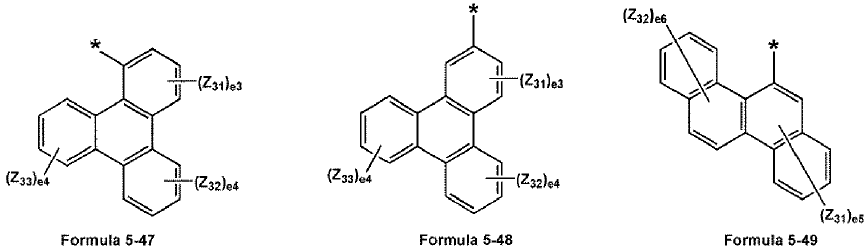

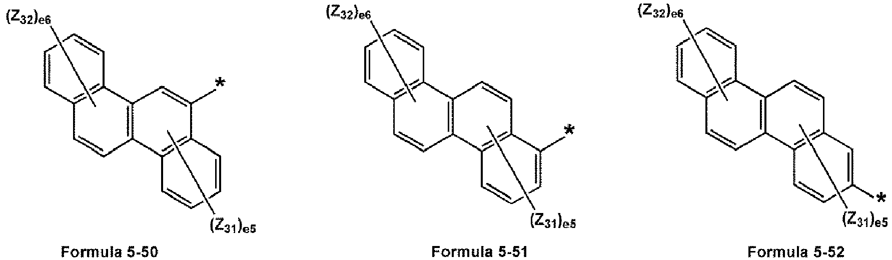

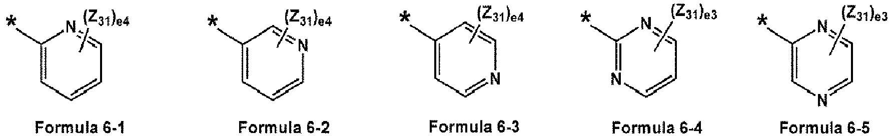

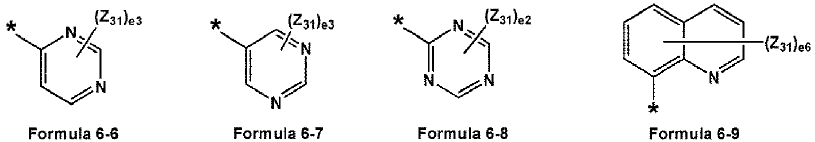

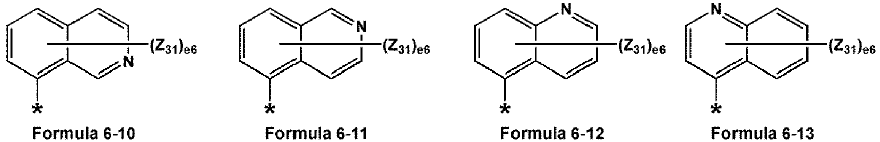

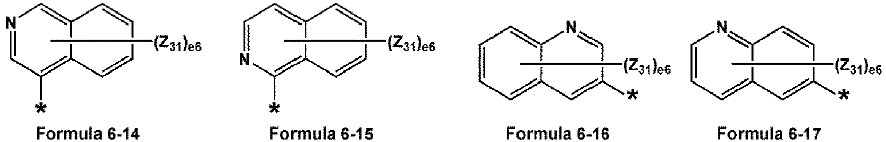

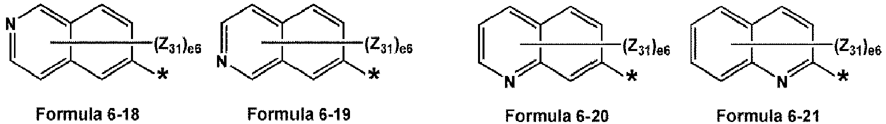

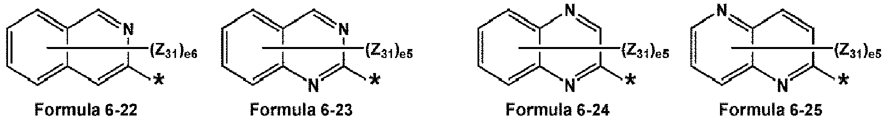

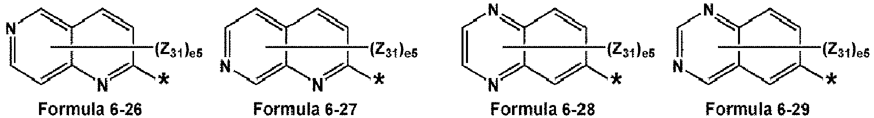

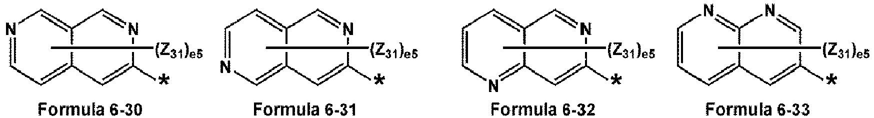

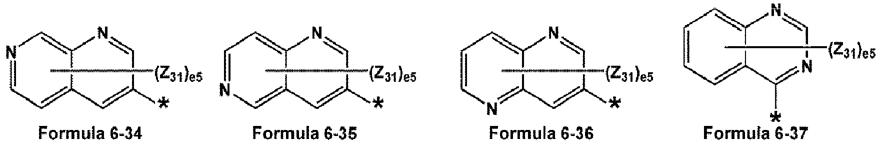

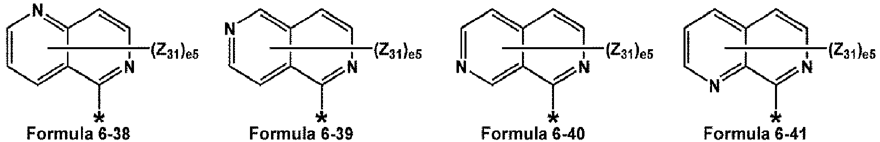

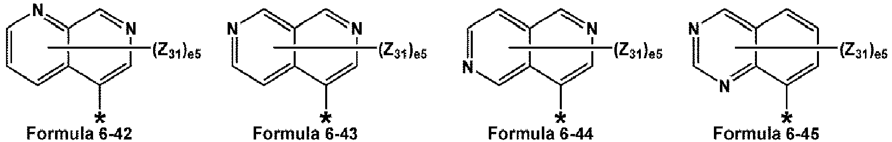

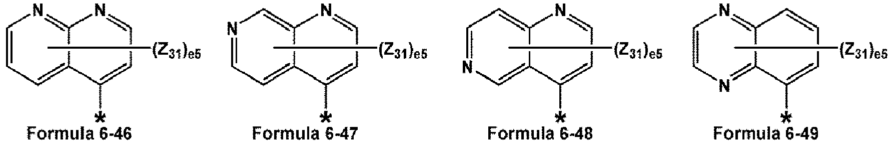

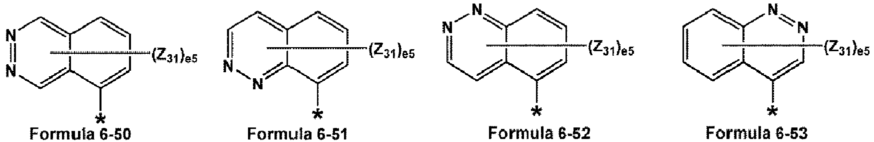

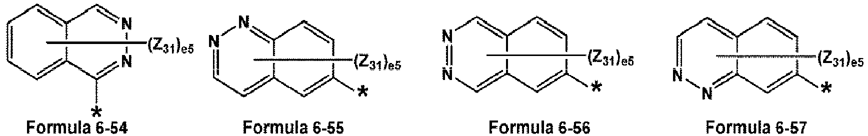

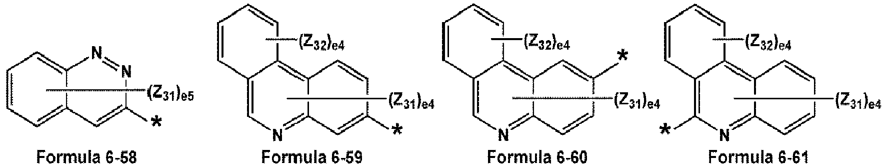

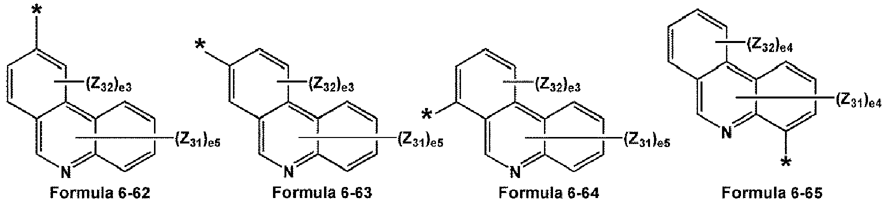

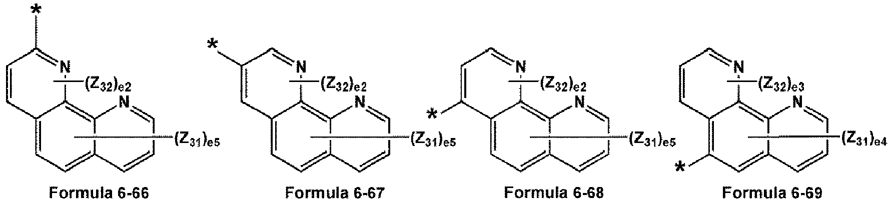

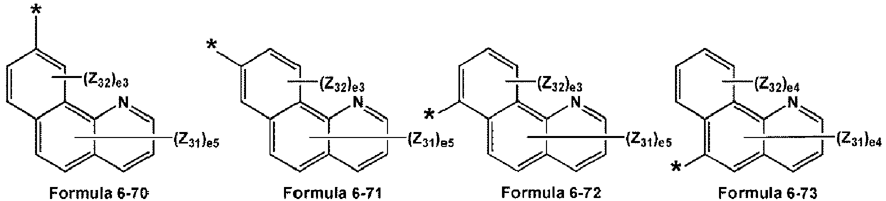

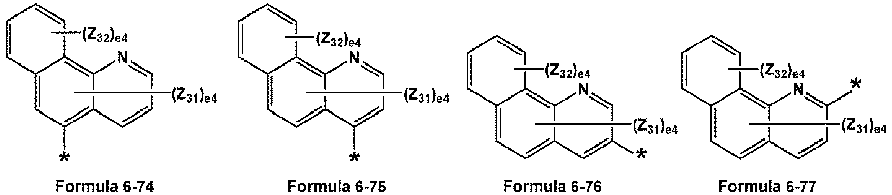

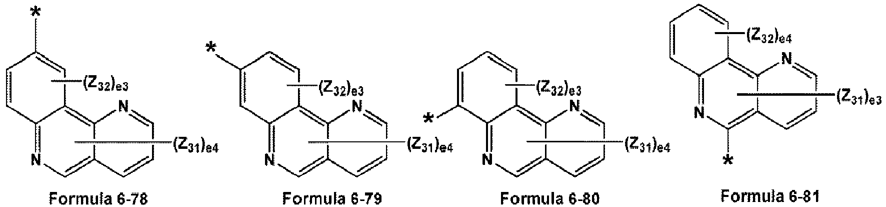

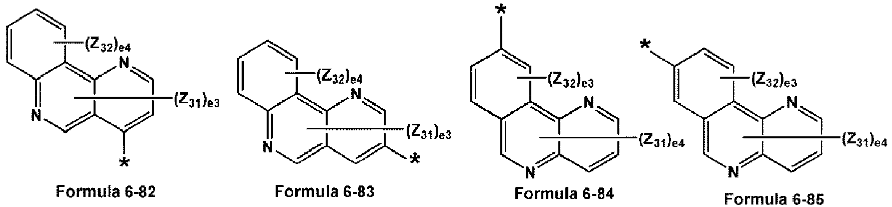

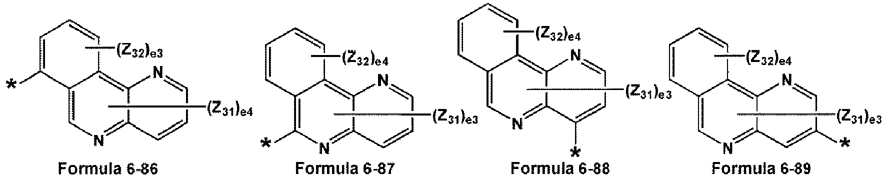

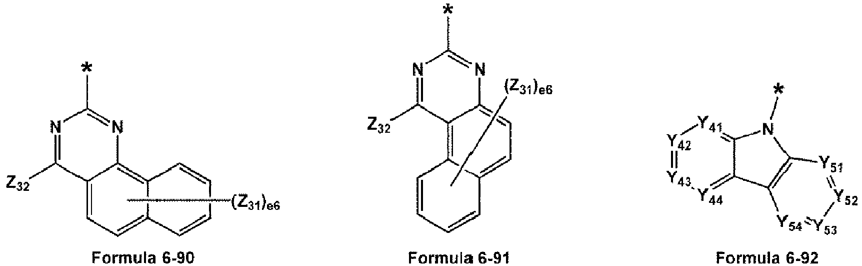

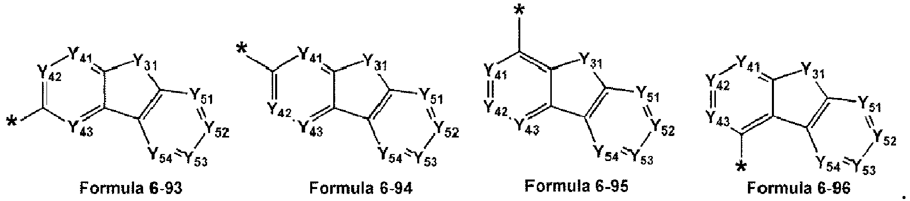

In Formulae 5-1 to 5-52 and 6-1 to 6-96,
Y₃₁ maybe O, S, C(Z₃₃)(Z₃₄), N(Z₃₅), or Si(Z₃₆) (Z₃₇),
Y₄₁ may be N or C(Z₄₁), Y₄₂ may be N or C(Z₄₂), Y₄₃ may be N or C(Z₄₃), Y₄₄ may be N or C(Z₄₄), Y₅₁ may be N or C(Z₅₁), Y₅₂ may be N or C(Z₅₂), Y₅₃ may be N or C(Z₅₃), Y₅₄ may be N or C(Z₅₄), at least one selected from Y₄₁ to Y₄₄ and Y₅₁ to Y₅₄ in Formula 6-92 may be N, and at least one selected from Y₄₁ to Y₄₃ and Y₅₁ to Y₅₄ in Formulae 6-93 to 6-96 may be N,
Z₃₁ to Z₃₇, Z₄₁ to Z₄₄, and Z₅₁ to Z₅₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, and -Si(Q₃₁)(Q₃₂)(Q₃₃);
wherein Q₁ to Q₃ and Q₃₁ to Q₃₃ may each independently be selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
e2 may be an integer selected from 0 to 2,
e3 may be an integer selected from 0 to 3,
e4 may be an integer selected from 0 to 4,
e5 may be an integer selected from 0 to 5,
e6 may be an integer selected from 0 to 6,
e7 may be an integer selected from 0 to 7,
e9 may be an integer selected from 0 to 9, and
* may indicate a binding site to a neighboring atom.
b11 to b13 in Formulae 2-1, 2-2, 2A, and 2B are each independently 1, 2, 3, 4, or 5, provided that each of b11 to b13 is 1 when each respective a11 to a13 is zero. b11 indicates the number of R₁₁(s), wherein when b11 is two or more, two or more R₁₁(s) may be identical to or different from each other. When a11 is zero (i.e. when L₁₁ is a single bond), b11 is 1 (i.e. only one R₁₁ is present). b12 and b13 may each independently be the same as described herein in connection with b11 and the structures of Formulae 2-1, 2-2, 2A, and 2B.

In one or more embodiments, b11 in Formulae 2-1, 2-2, 2A, and 2B may be 1, 2, or 3, and b12 and b13 may each independently be 1, but embodiments of the present disclosure are not limited thereto.
c11 and c12 in Formulae 2-1, 2-2, 2A, and 2B may each independently be o, 1, or 2. For example, c11 and c12 may each independently be 0 or 1.

In one or more embodiments,
the emission layer may comprise at least one compound represented by one selected from Formulae 2-1(1) and 2-2(1) to 2-2(18), or at least one compound represented by Formula 2-3 in which Cz₁ is selected from groups represented by Formulae 2A(1) to 2A(4) and 2B(1) to 2B(20):

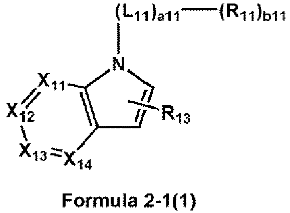

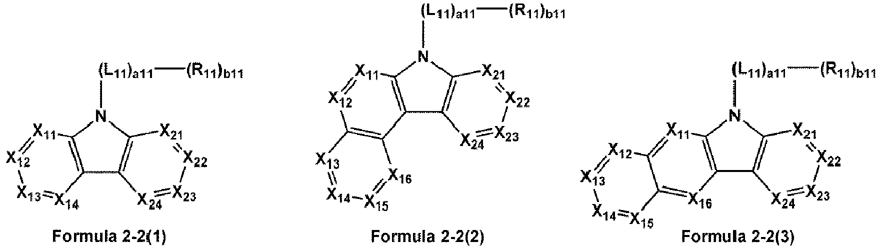

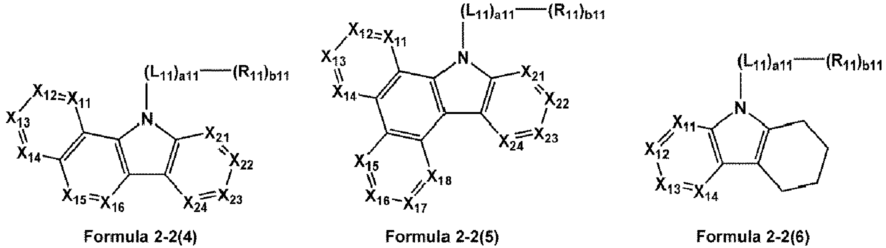

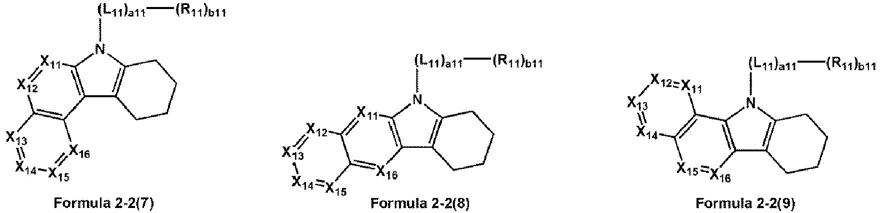

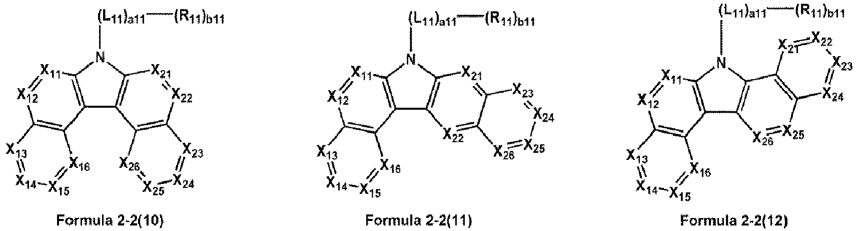

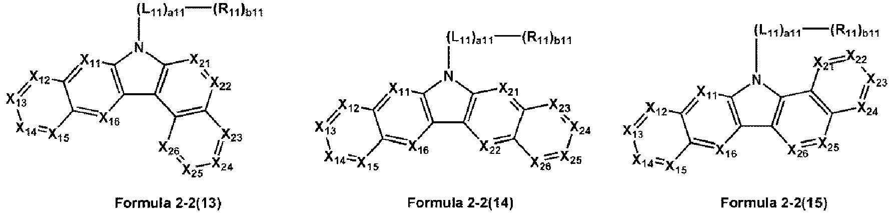

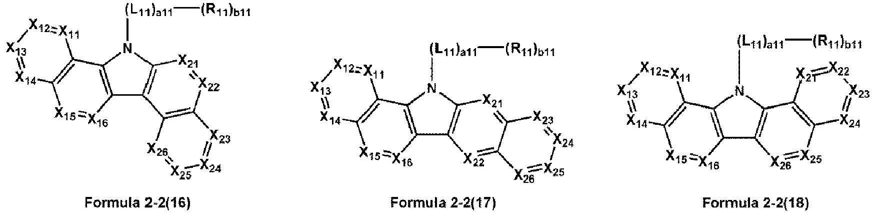

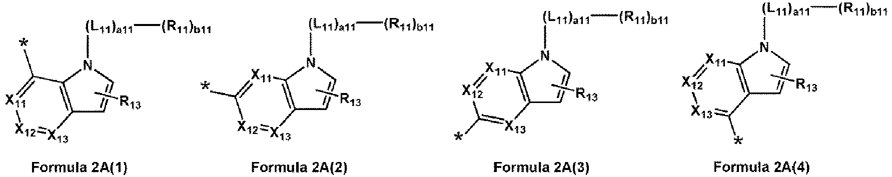

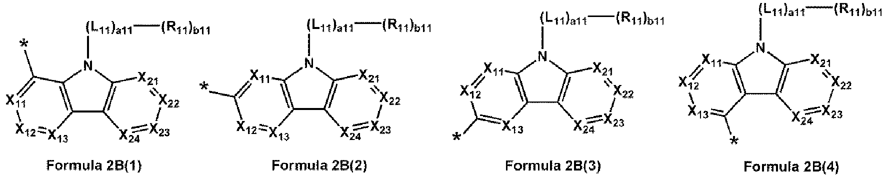

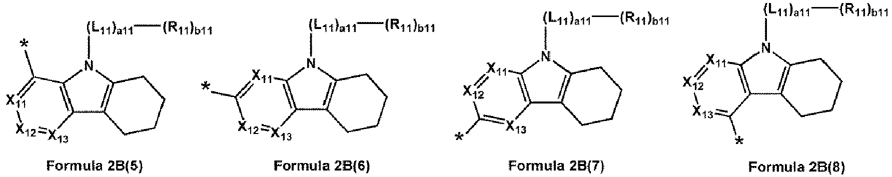

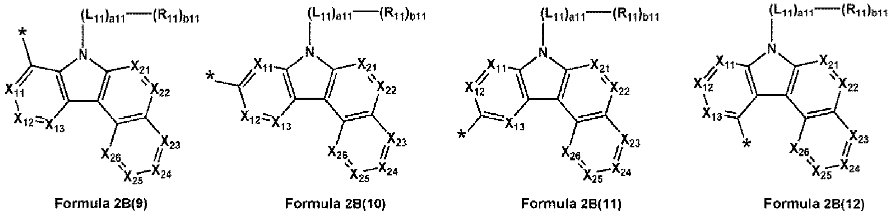

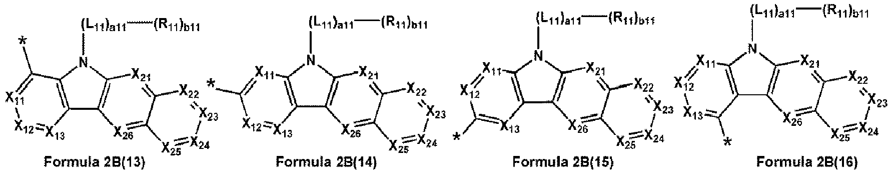

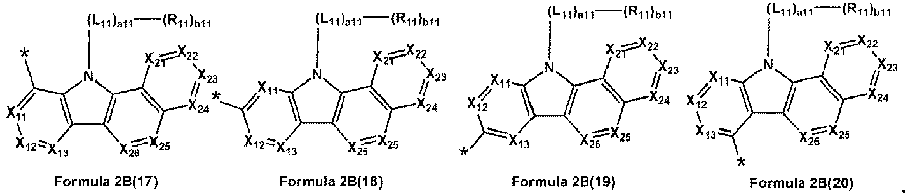

In Formulae 2-1(1), 2-2(1) to 2-2(18), 2A(1) to 2A(4), and 2B(1) to 2B(2O),
L₁₁, a11, R₁₁, b11, and R₁₃ may each independently be the same as described above,
X₁₁ may be N or C(R₂₁), X₁₂ may be N or C(R₂₂), X₁₃ may be N or C(R₂₃), X₁₄ may be N or C(R₂₄), X₁₅ may be N or C(R₂₅), X₁₆ may be N or C(R₂₆), X₁₇ may be N or C(R₂₇), X₁₈ may be N or C(R₂₈), X₂₁ may be N or C(R₃₁), X₂₂ may be N or C(R₃₂), X₂₃ may be N or C(R₃₃), X₂₄ may be N or C(R₃₄), X₂₅ may be N or C(R₃₅), and X₂₆ may be N or C(R₃₆),
R₂₁ to R₂₈ may each independently be a group *-(L₁₂)ₐ₁₂-(R₁₂)_{b12}, and R₃₁ to R₃₆ may each independently be a group *-(L₁₃)ₐ₁₃-(R₁₃)_{b13}, whereinL₁₂ L₁₃ a12 a13 R₁₂ R₁₃ b₁₂ and b₁₃ may each independently be the same as described elsewhere herein, and
* may indicate a binding site to a neighboring atom.

In one or more embodiments, the emission layer may comprise at least one compound represented by one selected from Formulae 2-1(1) and 2-2(1) to 2-2(18), X₁₁ in Formulae 2-1(1) and 2-2(1) to 2-2(18) may be C(R₂₁), X₁₂ may be C(R₂₂), X₁₃ may be C(R₂₃), X₁₄ may be C(R₂₄), X₁₅ may be C(R₂₅), X₁₆ may be C(R₂₆), X₁₇ may be C(R₂₇), X₁₈ may be C(R₂₈), X₂₁ may be C(R₃₁), X₂₂ may be C(R₃₂), X₂₃ may be C(R₃₃), X₂₄ may be C(R₃₄), X₂₅ may be C(R₃₅), and X₂₆ may be C(R₃₆).

In one or more embodiments, the emission layer may comprise at least one compound represented by one selected from Formulae 2-1(1) and 2-2(1) to 2-2(18), and
1) one selected from X₁₁ to X₁₄ in Formulae 2-1(1) and 2-2(6) may be N, and the others may not be N,
2) one or two selected from X₁₁ to X₁₆ and X₂₁ to X₂₄ in Formulae 2-2(2) to 2-2(4) may be N, and the others may not be N,
3) one or two selected from X₁₁ to X₁₈ and X₂₁ to X₂₄ in Formula 2-2(5) may be N, and the others may not be N,
4) one or two selected from X₁₁ to X₁₆ in Formulae 2-2(7) to 2-2(9) may be N, and the others may not be N, or
5) one or two selected from X₁₁ to X₁₆ and X₂₁ to X₂₆ in Formulae 2-2(10) to 2-2(18) may be N, and the others may not be N, but embodiments of the present disclosure are not limited thereto.

In one or more embodiments, the emission layer may comprise at least one compound represented by Formula 2-3, and at least one selected from the c1 Cz₁(s) in Formula 2-3 may be selected from groups represented by Formulae 2A(1) to 2A(4) and 2B(1) to 2B(2O), wherein in Formulae 2A(1) to 2A(4) and 2B(1) to 2B(2O), X₁₁ may be C(R₂₁), X₁₂ may be C(R₂₂), X₁₃ may be C(R₂₃), X₁₄ may be C(R₂₄), X₂₁ may be C(R₃₁), X₂₂ may be C(R₃₂), X₂₃ may be C(R₃₃), X₂₄ may be C(R₃₄), X₂₅ may be C(R₃₅), and X₂₆ may be C(R₃₆).

In one or more embodiments, the emission layer may comprise at least one compound may be represented by Formula 2-3, and at least one selected from the c1 Cz₁(s) in Formula 2-3 may be selected from groups represented by Formulae 2A(1) to 2A(4) and 2B(1) to 2B(2O), wherein:
1) one selected from X₁₁ to X₁₃ in Formulae 2A(1) to 2A(4) and 2B(5) to 2B(8) may be N, and the others may not be N,
2) one or two selected from X₁₁ to X₁₃ and X₂₁ to X₂₄ in Formulae 2B(1) to 2B(4) may be N, and the others may not be N, or
3) one or two selected from X₁₁ to X₁₃ and X₂₁ to X₂₆ in Formulae 2B(9) to 2B(20) may be N, and the others may not be N, but embodiments of the present disclosure are not limited thereto.

In one or more embodiments,
the emission layer may comprise at least one compound represented by one selected from Formulae 2-2-N1 to 2-2-N23, or
the emission layer may comprise at least one compound represented by Formula 2-3, and at least one selected from the c1 Cz₁(s) in Formula 2-3 may be selected from groups represented by Formulae 2B-N1 to 2B-N24:

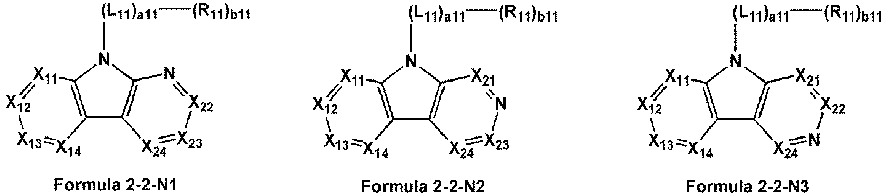

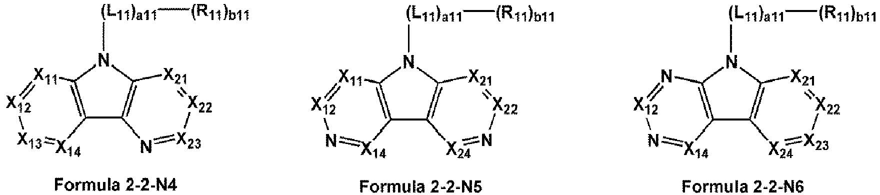

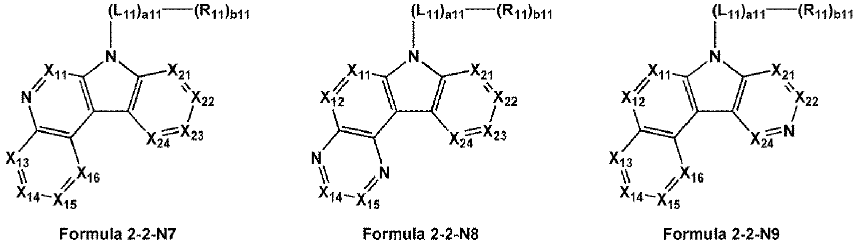

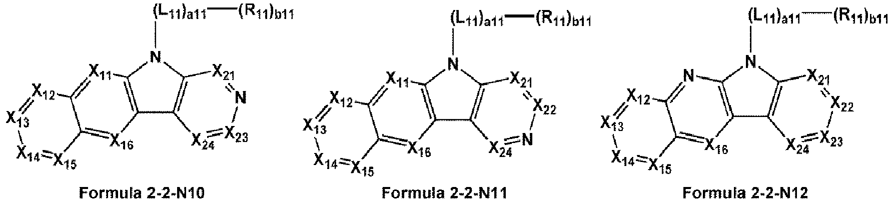

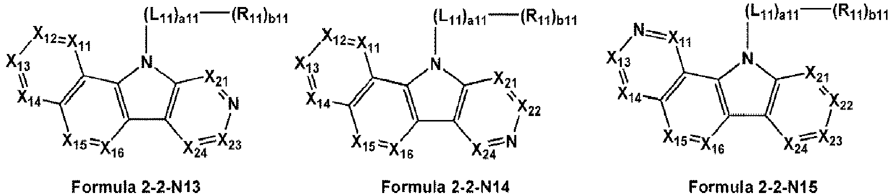

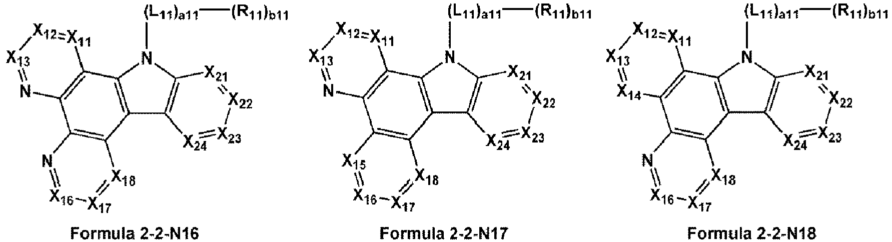

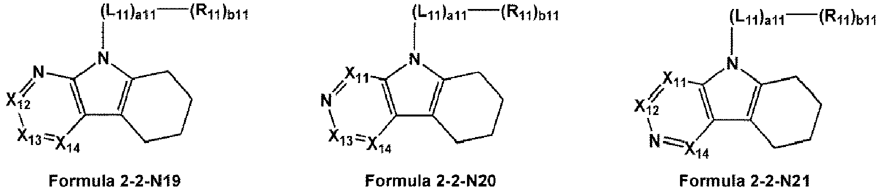

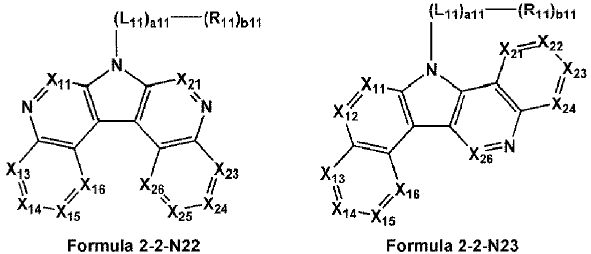

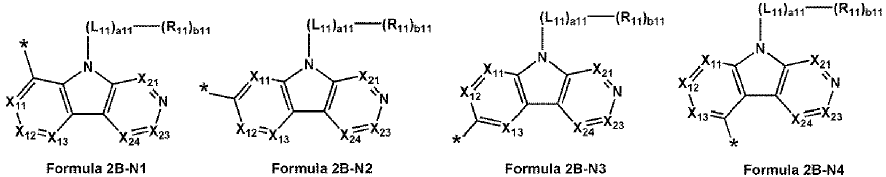

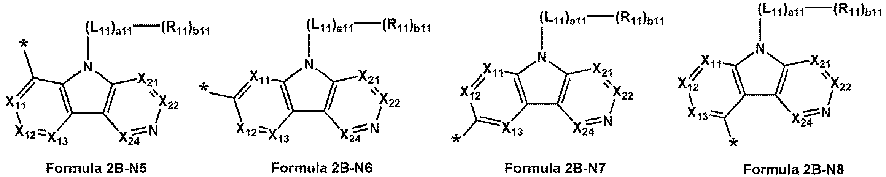

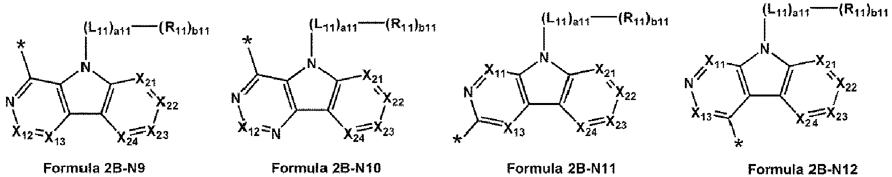

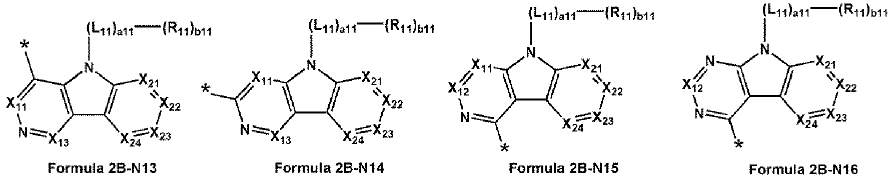

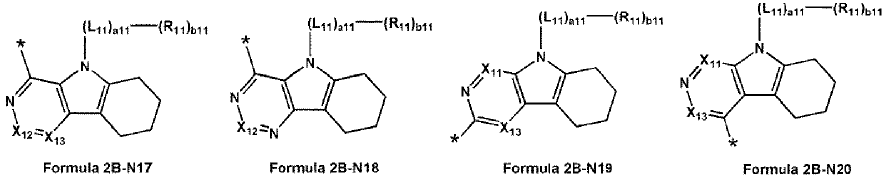

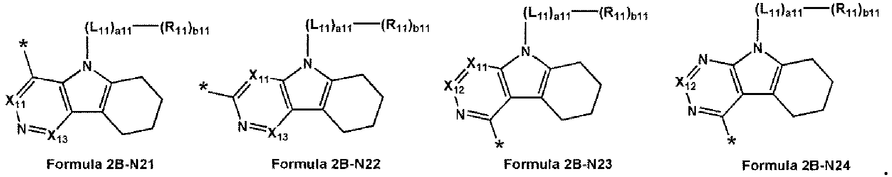

In Formulae 2-2-N1 to 2-2-N23 and 2B-N1 to 2B-N24,
L₁₁, a11, R₁₁, and b11 may each independently be the same as described above,
X₁₁ may be C(R₂₁), X₁₂ may be C(R₂₂), X₁₃ may be C(R₂₃), X₁₄ may be C(R₂₄), X₁₅ may be C(R₂₅), X₁₆ may be C(R₂₆), X₁₇ may be C(R₂₇), X₁₈ may be C(R₂₈), X₂₁ may be C(R₃₁), X₂₂ may be C(R₃₂), X₂₃ may be C(R₃₃), and X₂₄ may be C(R₃₄),
R₂₁ to R₂₈ may each independently be the same as described above in connection with *-(L₁₂)ₐ₁₂-(R₁₂)_{b12}, and R₃₁ to R₃₄ may each independently be the same as described above in connection with *-(L₁₃)ₐ₁₃-(R₁₃)_{b13}, and
* may indicate a binding site to a neighboring atom.

Any combination of X₁ to X₃, L₁ to L₃, a1 to a3, Ar₁ to Ar₃, b1 to b3, rings A₁₁, A₁₂, A₂₁, and A₂₂, Z₁ to Z₇, Z₁₁ to Z₁₇, rings A₁ and A₂, L₁₁ to L₁₃, L₂₁, a11 to a13, a21, R₁₁ to R₁₃, b11 to b13, c11, and c12 in Formulae 1, 2-1 to 2-3, 2A, 2B, 3A to 3G, and 4A to 4G may be suitably used within the scope described herein.

The compound represented by one selected from Formulae 2-1, 2-2, and 2-3 is not CBP:

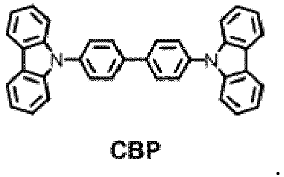

The electron transport region may comprise at least one compound selected from Compounds 1-1 to 1-225, and the emission layer may comprise at least one compound selected from Compounds 2-1 to 2-198, but embodiments of the present disclosure are not limited thereto:

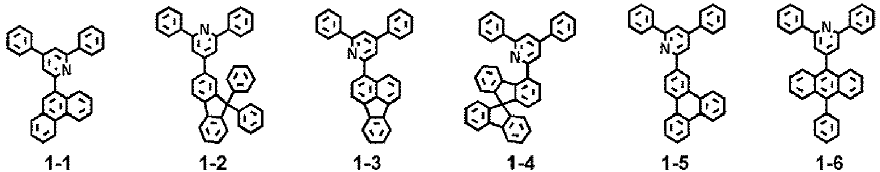

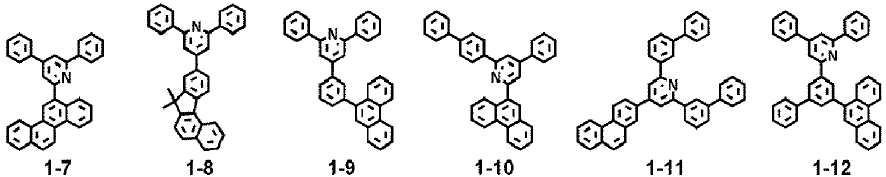

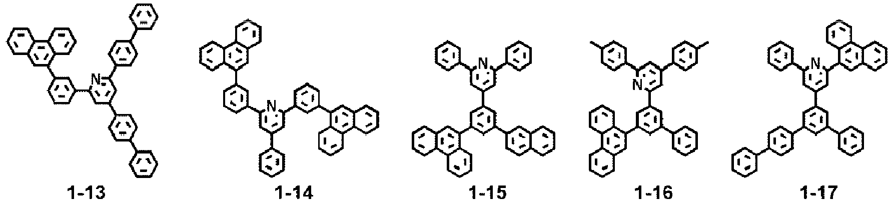

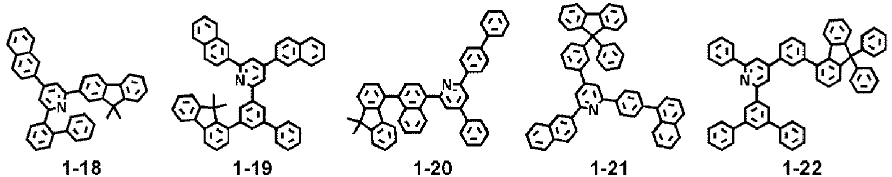

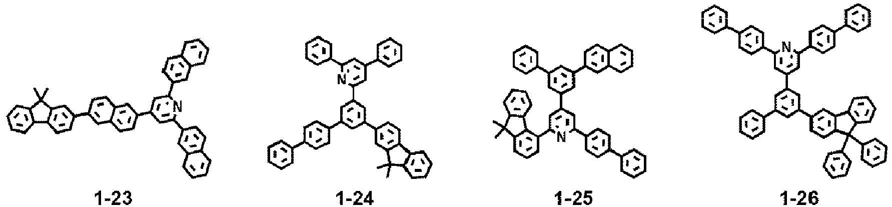

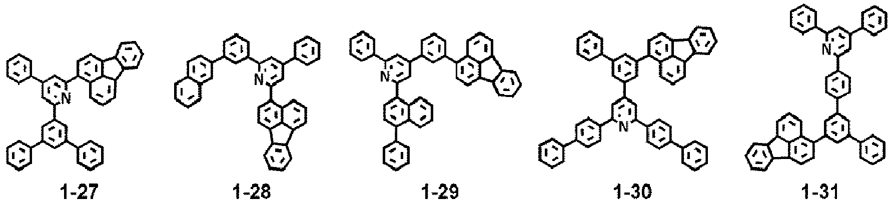

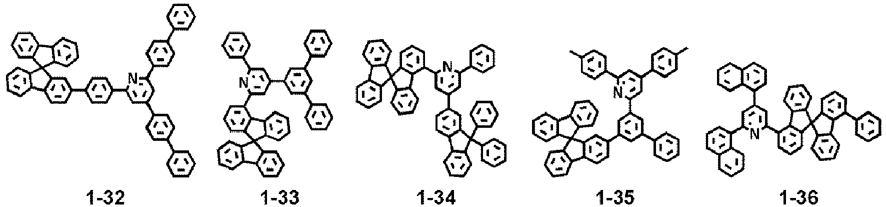

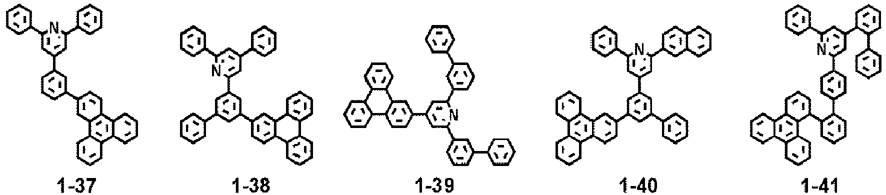

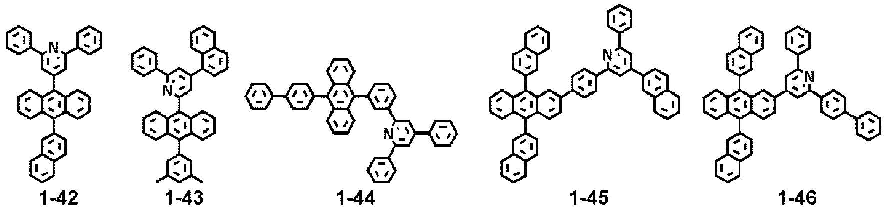

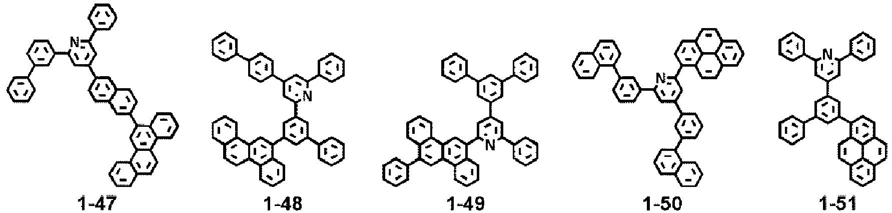

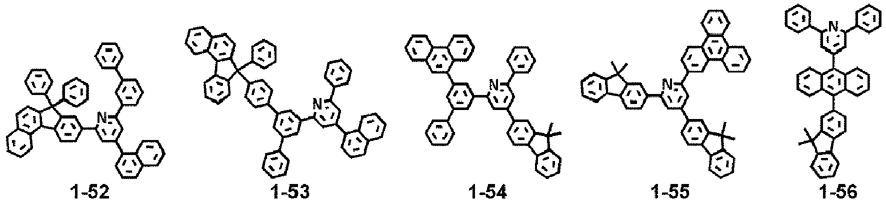

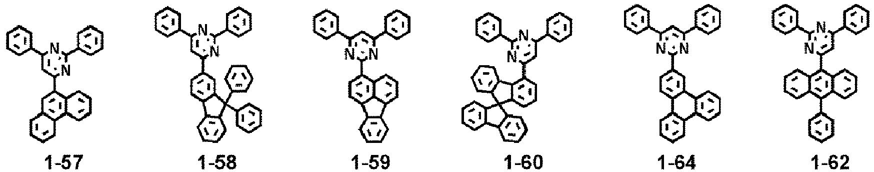

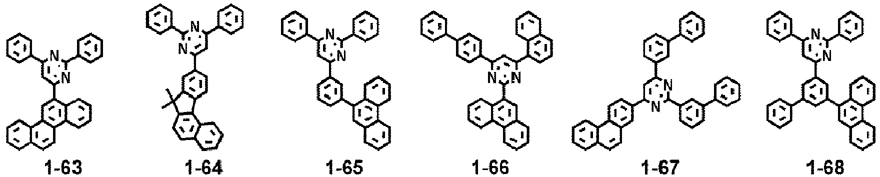

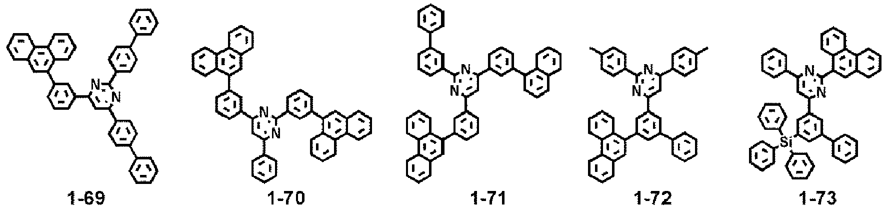

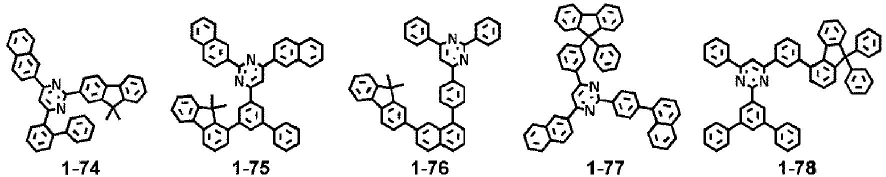

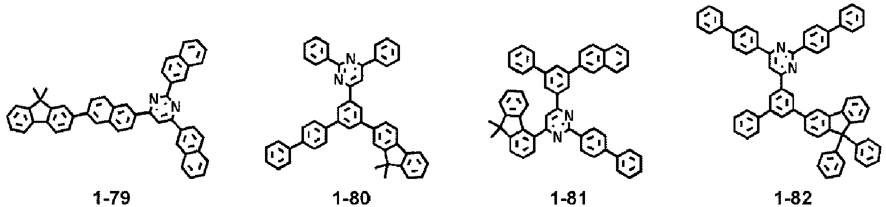

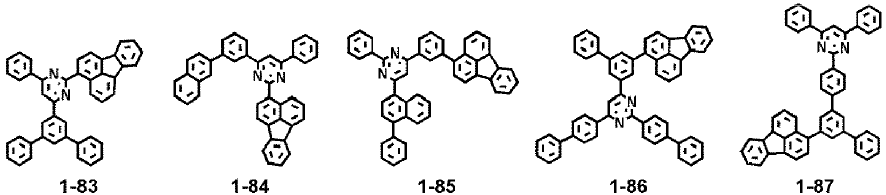

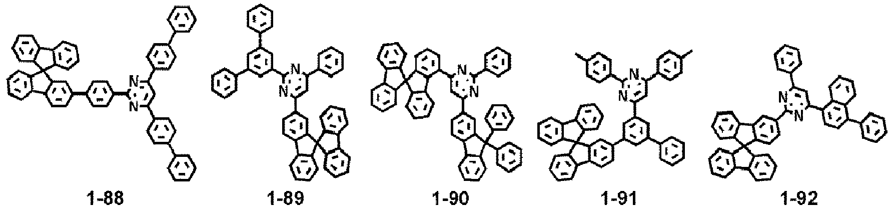

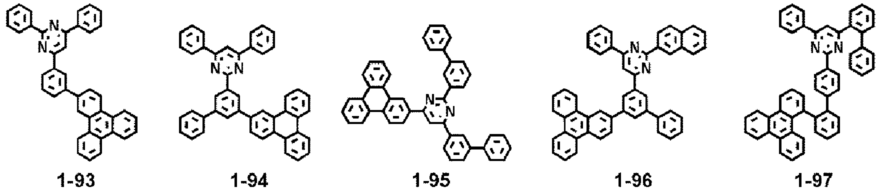

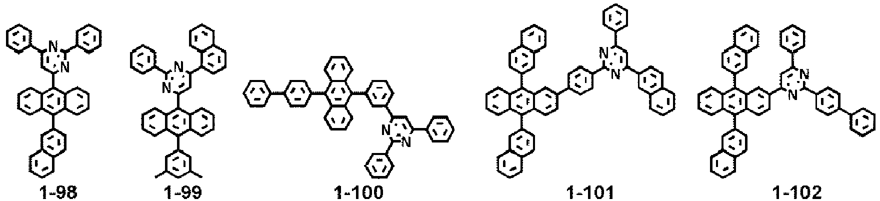

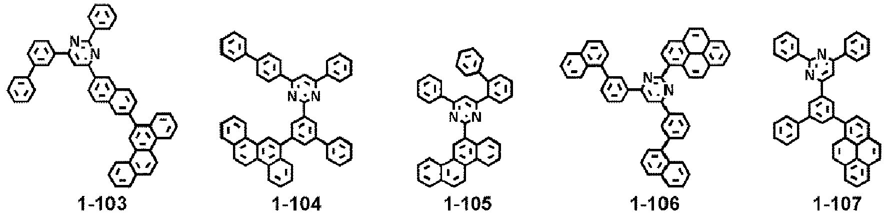

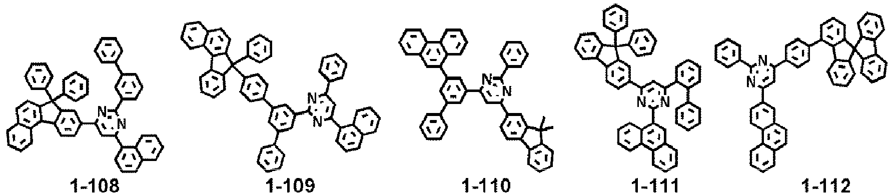

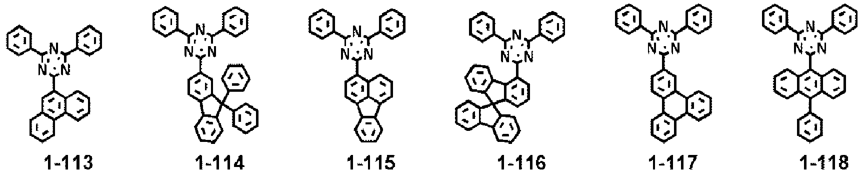

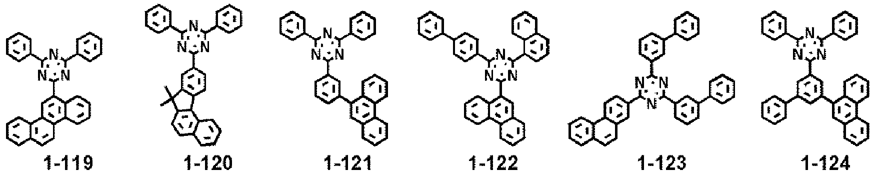

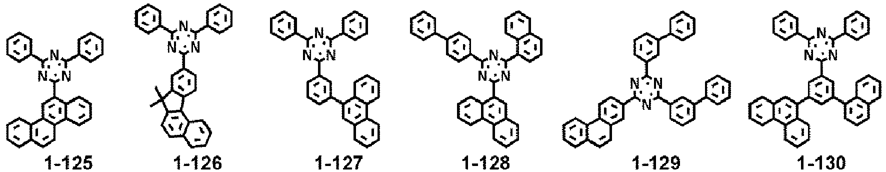

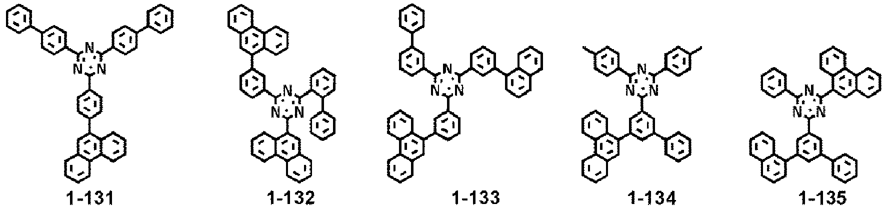

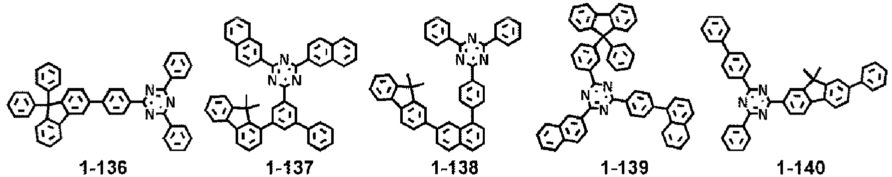

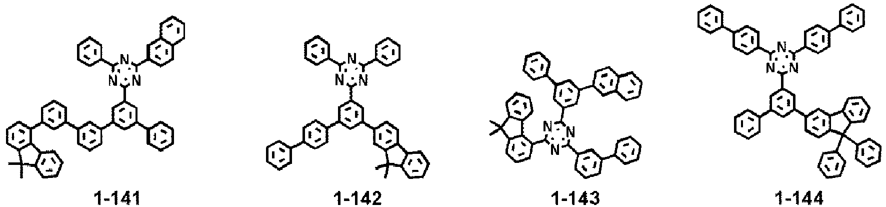

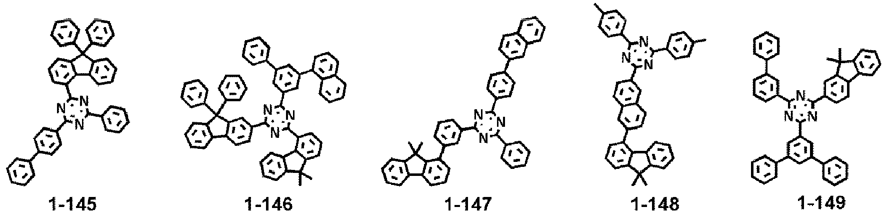

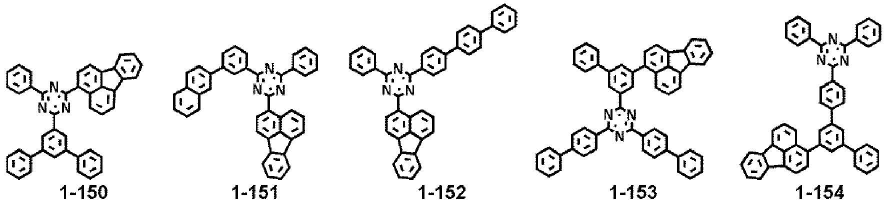

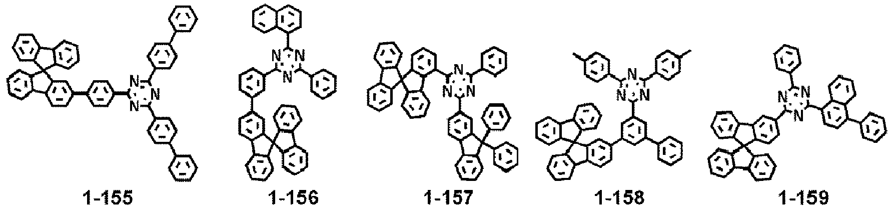

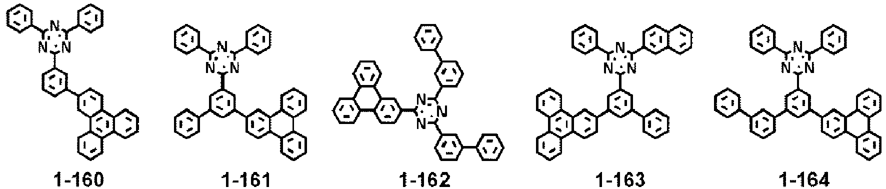

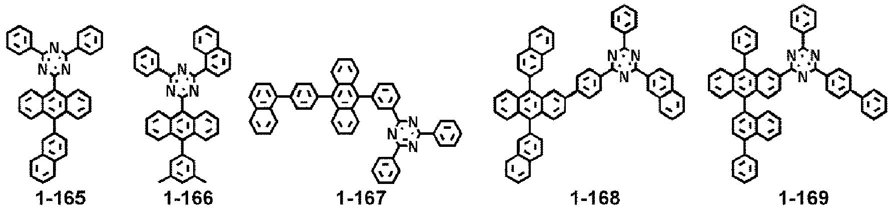

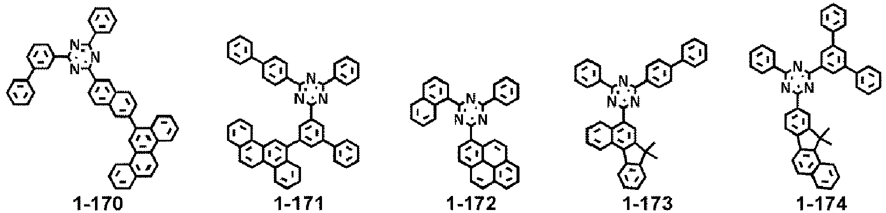

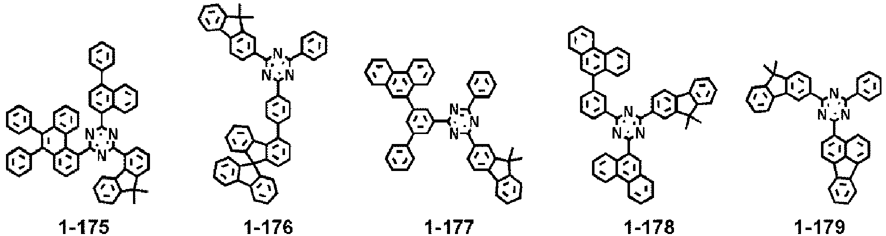

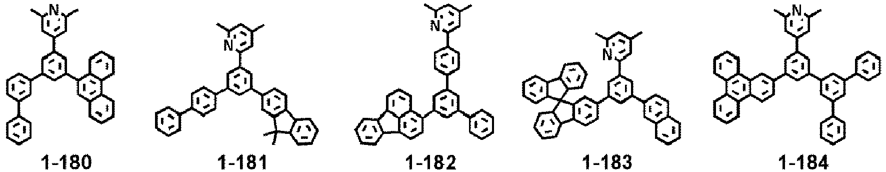

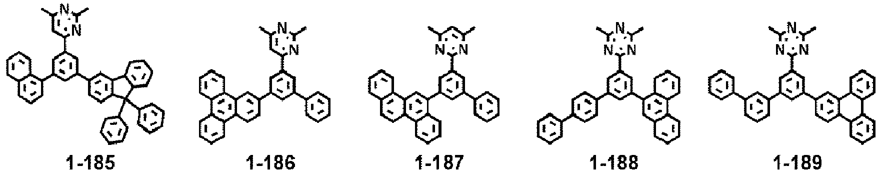

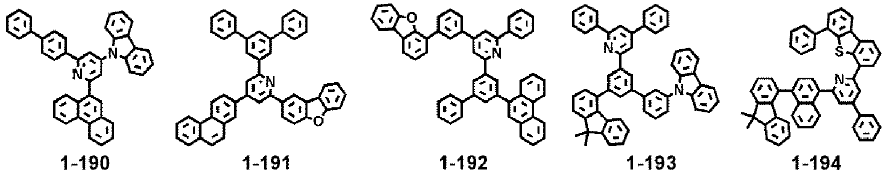

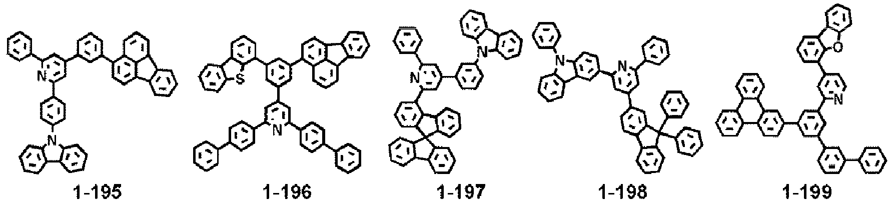

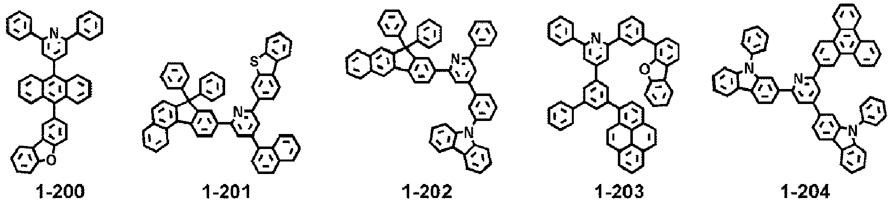

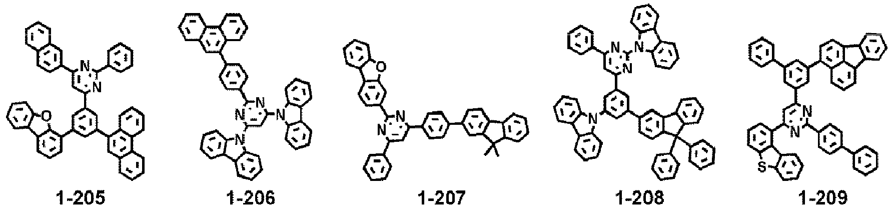

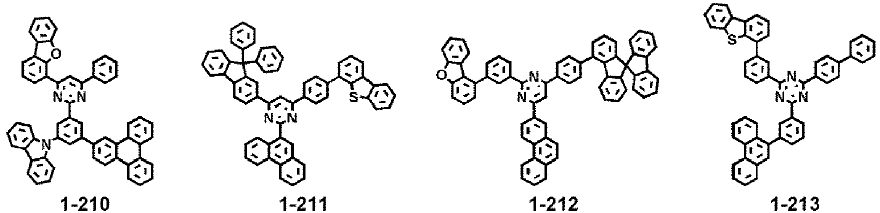

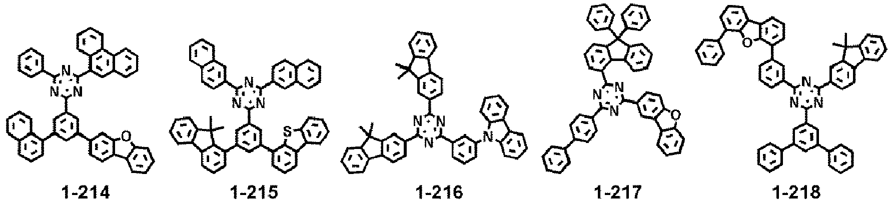

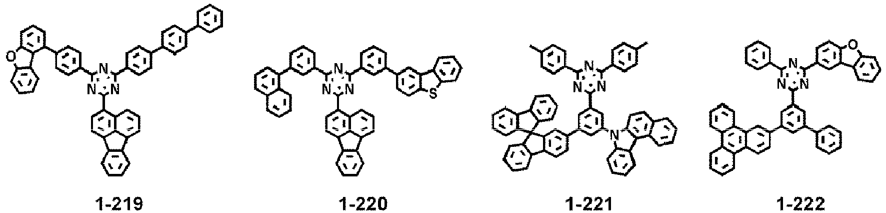

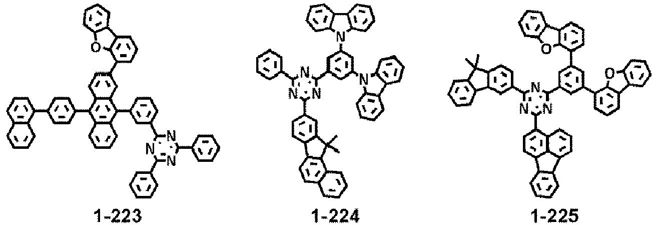

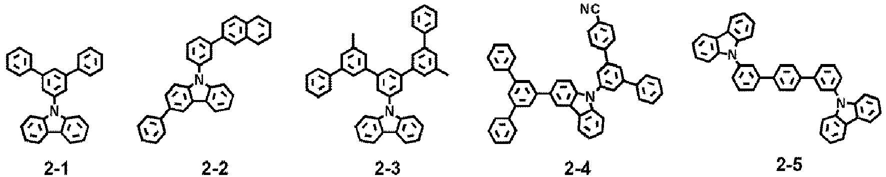

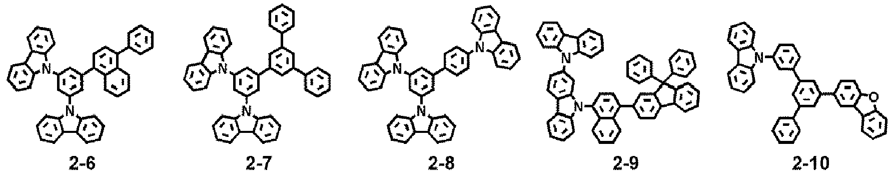

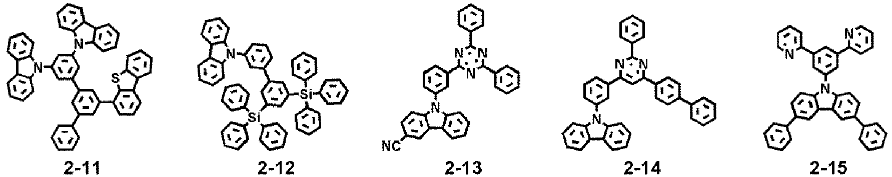

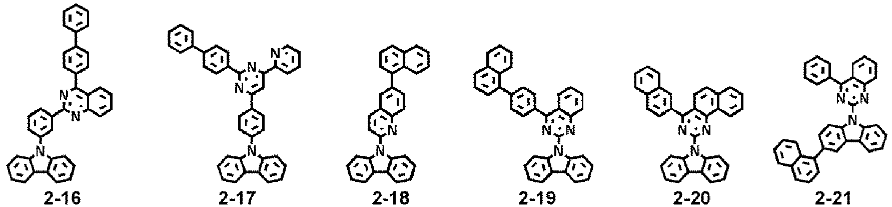

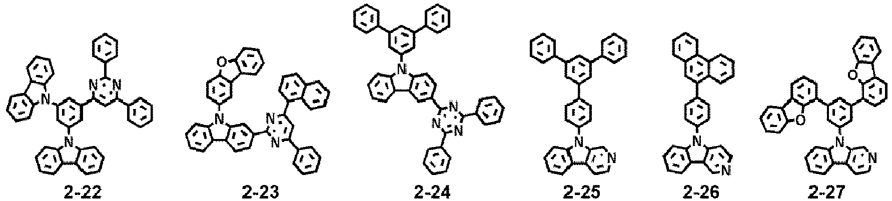

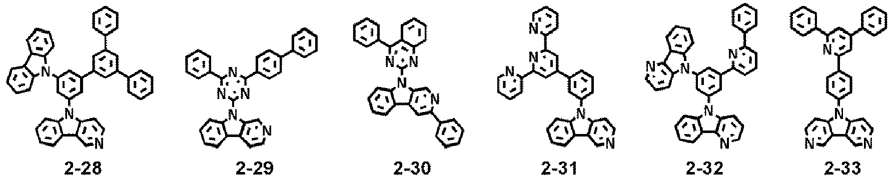

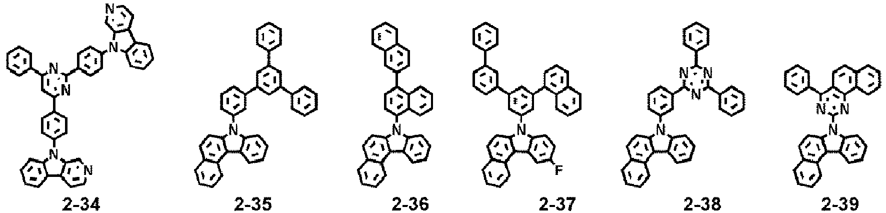

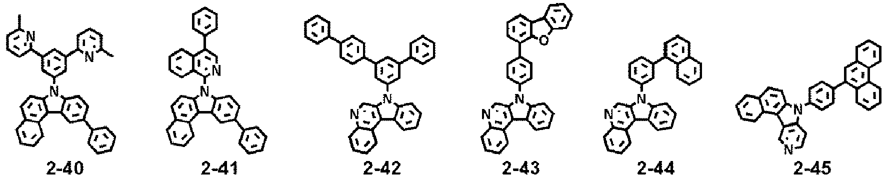

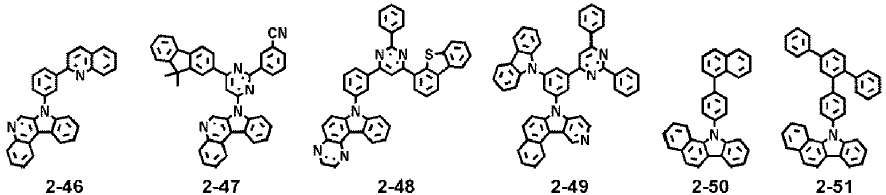

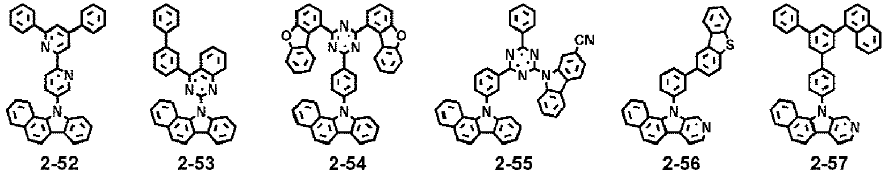

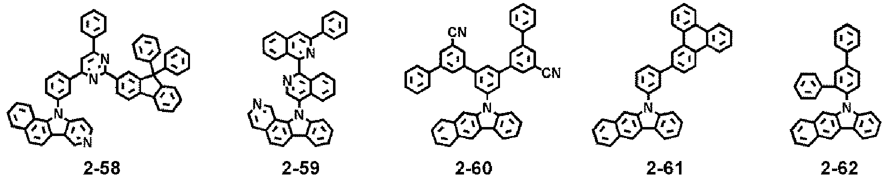

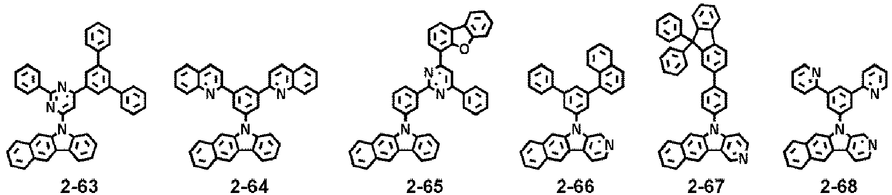

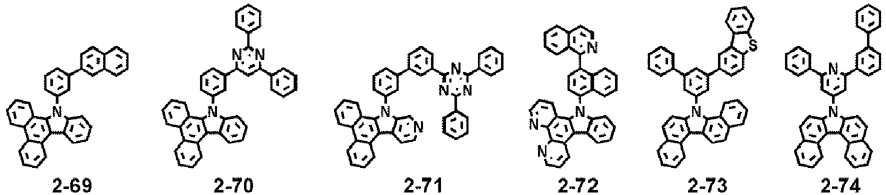

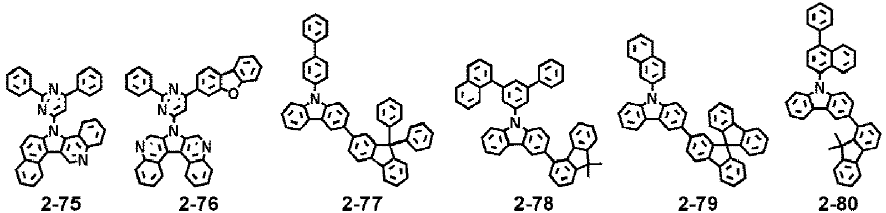

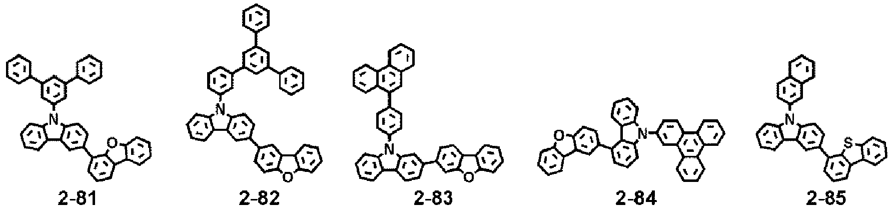

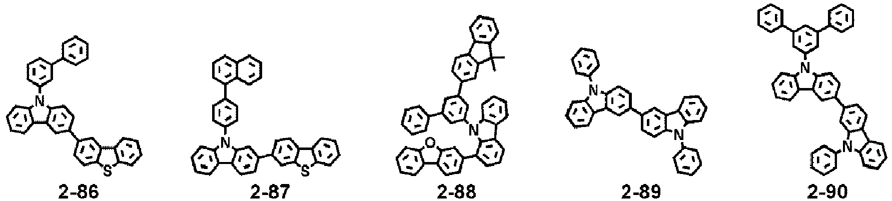

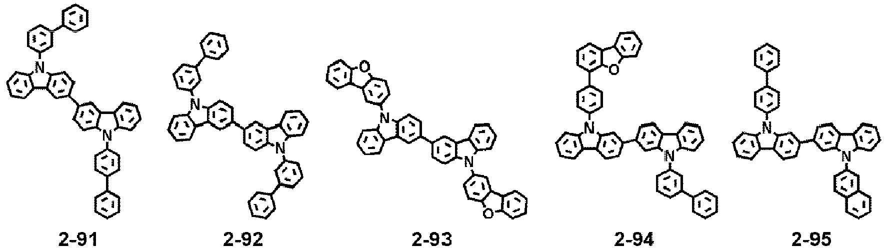

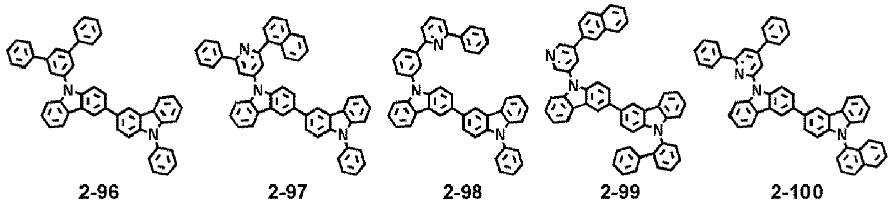

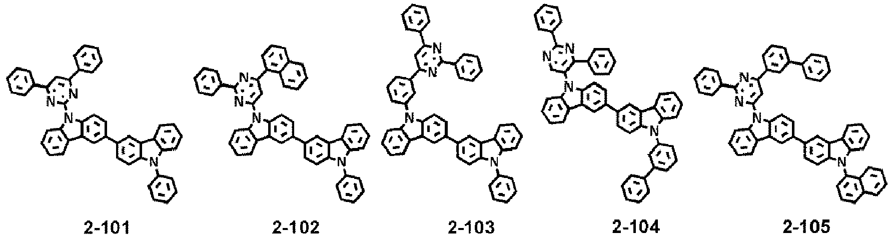

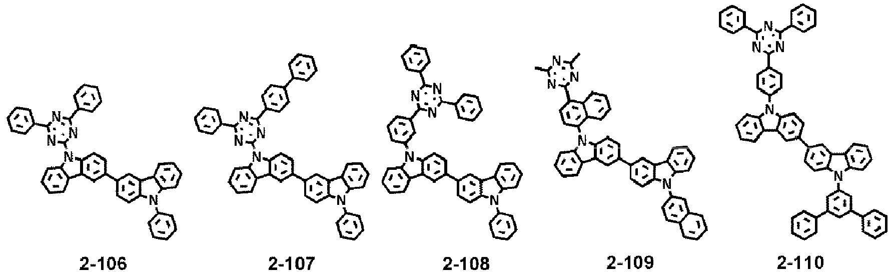

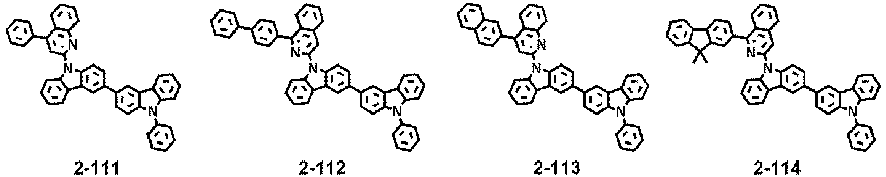

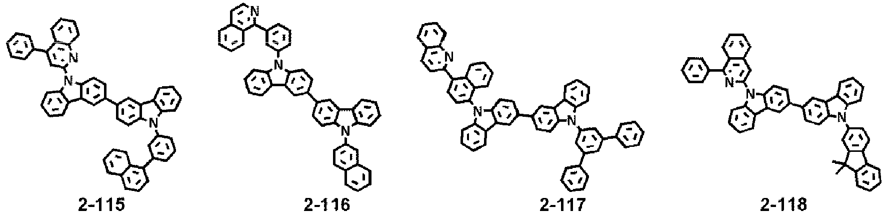

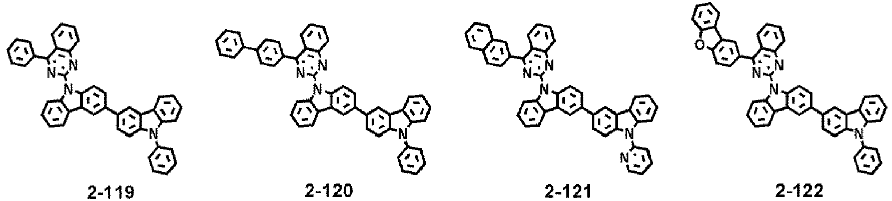

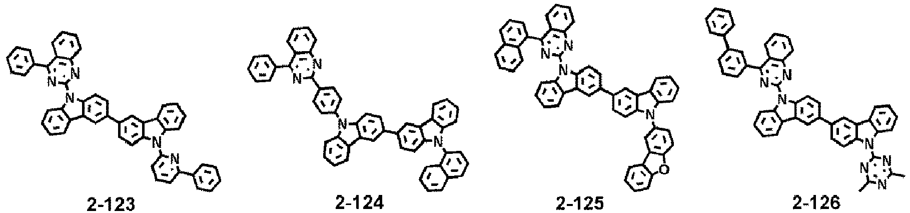

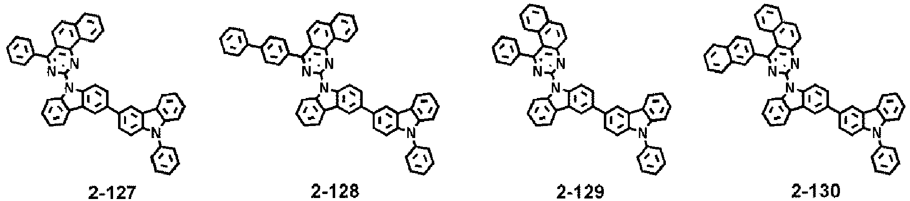

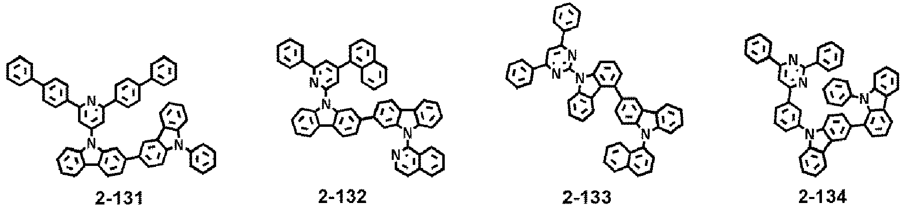

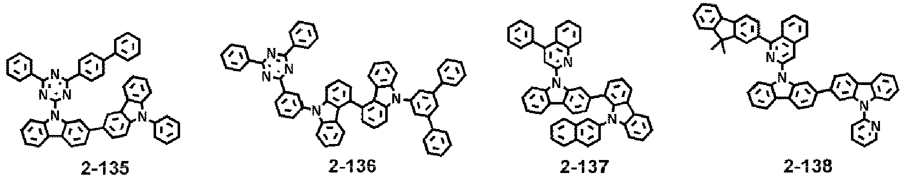

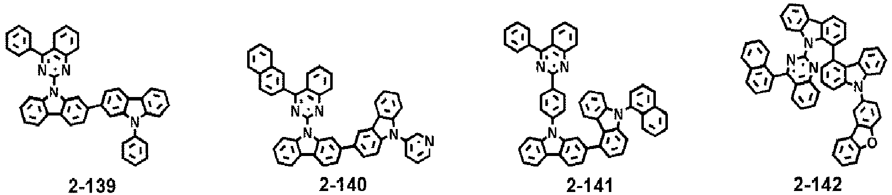

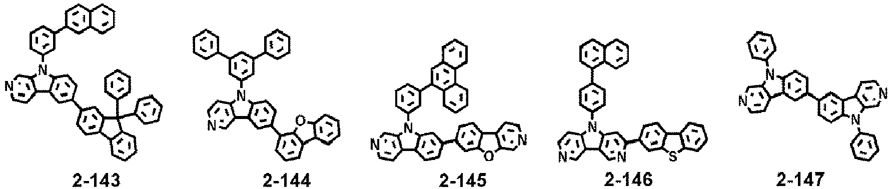

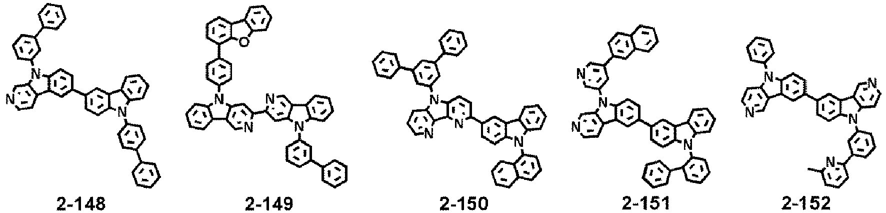

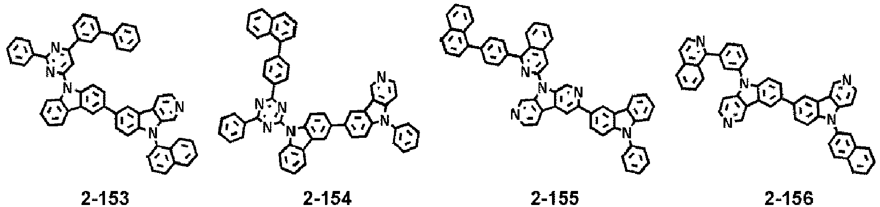

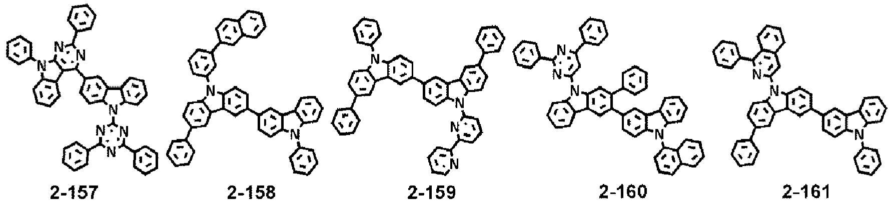

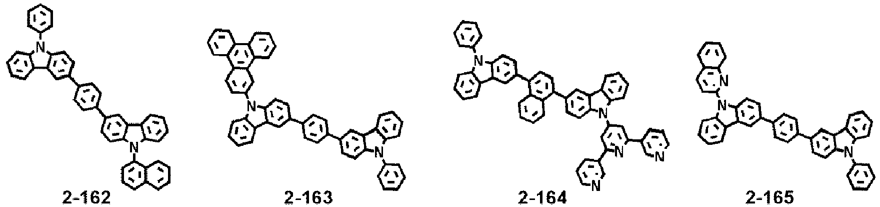

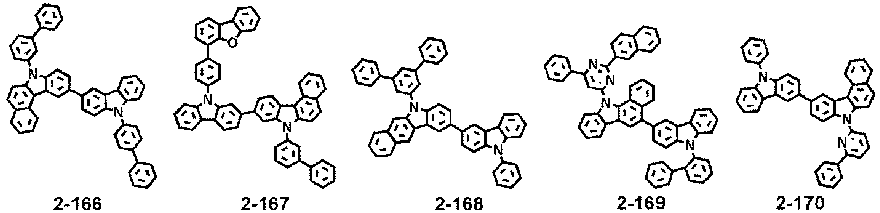

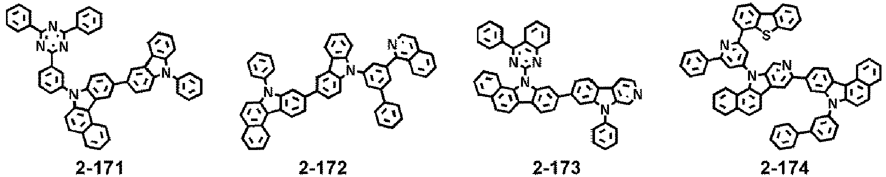

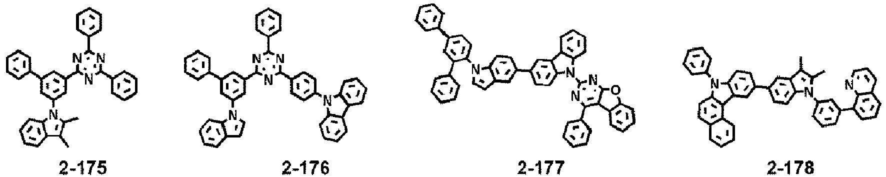

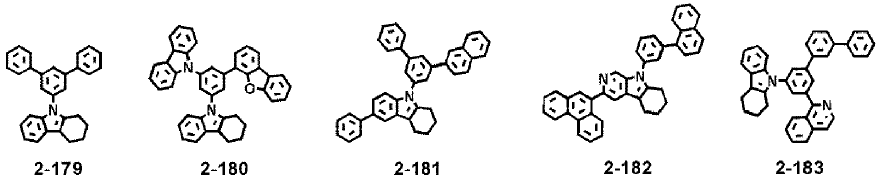

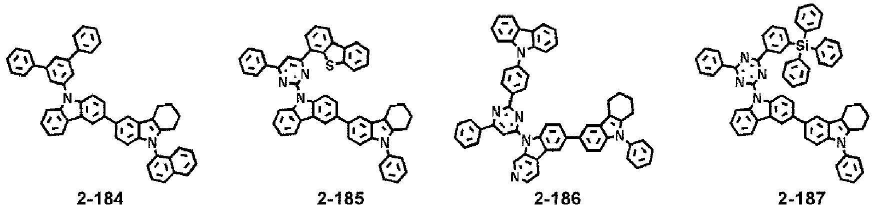

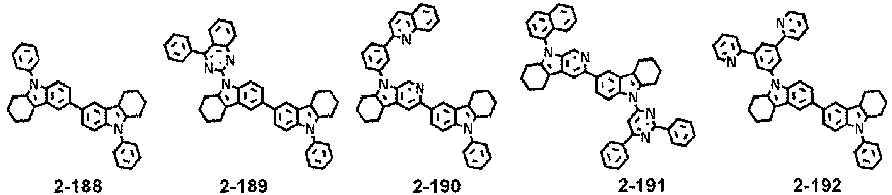

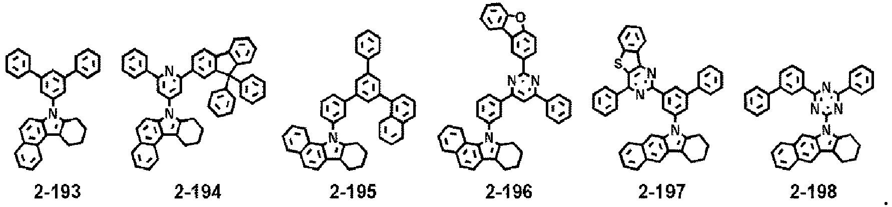

The electron transport region comprises at least one compound represented by Formula 1. For example, the electron transport region may comprise, as the compound represented by Formula 1: i) only one compound represented by Formula 1 (for example, the electron transport region may comprise Compound 1-17), or ii) two different compounds, each represented by Formula 1 (for example, the electron transport region may comprise Compounds 1-17 and 1-200).

The emission layer comprises at least one compound represented by one selected from Formulae 2-1, 2-2, and 2-3. For example, the emission layer may comprise as the compound represented by one selected from Formulae 2-1, 2-2, and 2-3: i) only one compound represented by Formula 2-1, 2-2, or 2-3 (for example, the emission layer may comprise Compound 2-14), or ii) two different compounds, each represented by Formula 2-1, 2-2, or 2-3 (for example, the emission layer may comprise Compounds 2-14 and 2-22).

In one or more embodiments, the electron transport region may comprise an electron transport layer and an electron injection layer, and the at least one compound represented by Formula 1 may be comprised in the electron transport layer.

At least one selected from the electron transport layer and the electron injection layer may further comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

In one or more embodiments, the electron transport region may comprise a first electron transport layer, a second electron transport layer, and an electron injection layer, the first electron transport layer may be between the emission layer and the second electron transport layer, the second electron transport layer may be between the first electron transport layer and the electron injection layer, and the at least one compound represented by Formula 1 may be comprised in at least one selected from the first electron transport layer and the second electron transport layer.

In one or more embodiments, the first electron transport layer may directly contact the emission layer, and the second electron transport layer may directly contact the first electron transport layer.

In one or more embodiments, as described above, each of the first electron transport layer and the second electron transport layer may comprise the compound represented by Formula 1, and the compound represented by Formula 1 comprised in the first electron transport layer and the compound represented by Formula 1 comprised in the second electron transport layer may be identical to or different from each other.

At least one selected from the first electron transport layer, the second electron transport layer, and the electron injection layer may further comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

The emission layer may further comprise a dopant, in addition to the at least one compound represented by one selected from Formulae 2-1, 2-2, and 2-3. The dopant may be a fluorescent dopant or a phosphorescent dopant. In one or more embodiments, the emission layer may further comprise a phosphorescent dopant, in addition to the at least one compound represented by one selected from Formulae 2-1, 2-2, and 2-3.

### Description of FIG. 1

FIG. 1 is a schematic view of an organic light-emitting device 10 according to an embodiment of the present disclosure. The organic light-emitting device 10 comprises a first electrode 110, an organic layer 150, and a second electrode 190.

Hereinafter, the structure of the organic light-emitting device 10 according to an embodiment of the present disclosure and a method of manufacturing the organic light-emitting device 10 will be described in connection with FIG. 1.

### First electrode 110

In FIG. 1, a substrate may be under the first electrode 110 or above the second electrode 190. The substrate may be a glass substrate or a plastic substrate, each having excellent mechanical strength, thermal stability, transparency, surface smoothness, ease of handling, and/or water-resistance.

The first electrode 110 may be formed by depositing and/or sputtering a material for forming the first electrode 110 on the substrate. When the first electrode 110 is an anode, the material for forming a first electrode may be selected from materials with a high work function in order to facilitate hole injection.

The first electrode 110 may be a reflective electrode, a semi-transmissive electrode, or a transmissive electrode. When the first electrode 110 is a transmissive electrode, a material for forming the first electrode may be selected from indium tin oxide (ITO), indium zinc oxide (IZO), tin oxide (SnO₂), zinc oxide (ZnO), and combinations thereof, but embodiments of the present disclosure are not limited thereto. When the first electrode 110 is a semi-transmissive electrode or a reflective electrode, a material for forming the first electrode may be selected from magnesium (Mg), silver (Ag), aluminum(Al), aluminum-lithium(Al-Li), calcium (Ca), magnesium-indium(Mg-In), magnesium-silver (Mg-Ag), and combinations thereof. However, embodiments of the material for forming the first electrode 110 are not limited thereto.

The first electrode 110 may have a single-layered structure, or a multi-layered structure comprising two or more layers. For example, the first electrode 110 may have a three-layered structure of ITO/Ag/ITO, but embodiments of the structure of the first electrode 110 are not limited thereto.

### Organic layer 150

The organic layer 150 is on the first electrode 110. The organic layer 150 may comprise an emission layer.

The organic layer 150 may comprise a hole transport region between the first electrode 110 and the emission layer, and an electron transport region between the emission layer and the second electrode 190.

### Hole transport region in organic layer 150

The hole transport region may have: i) a single-layered structure including (e.g., consisting of) a single layer including (e.g., consisting of) a single material, ii) a single-layered structure including (e.g., consisting of) a single layer comprising a plurality of different materials, or iii) a multi-layered structure having a plurality of layers comprising a plurality of different materials.

The hole transport region may comprise at least one selected from a hole injection layer, a hole transport layer, an emission auxiliary layer, and an electron blocking layer.

For example, the hole transport region may have a single-layered structure including (e.g., consisting of) a single layer comprising a plurality of different materials, or a multi-layered structure having a structure of hole injection layer/hole transport layer, hole injection layer/hole transport layer/emission auxiliary layer, hole injection layer/emission auxiliary layer, hole transport layer/emission auxiliary layer, or hole injection layer/hole transport layer/electron blocking layer, wherein layers of each structure are sequentially stacked on the first electrode 110 in each stated order, but embodiments of the structure of the hole transport region are not limited thereto.

The hole transport region may comprise at least one selected from m-MTDATA, TDATA, 2-TNATA, NPB(NPD), β-NPB, TPD, Spiro-TPD, Spiro-NPB, methylated NPB, TAPC, HMTPD, 4,4',4"-tris(*N*-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, and a compound represented by Formula 202:

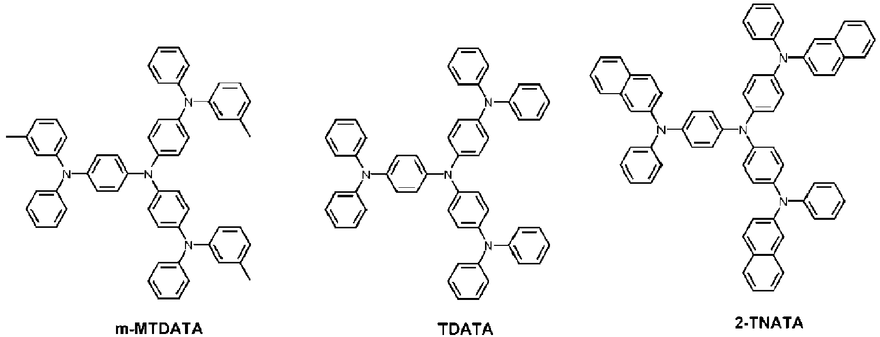

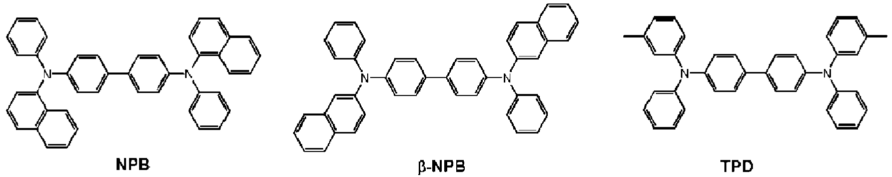

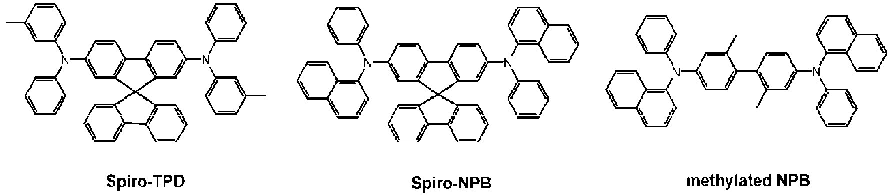

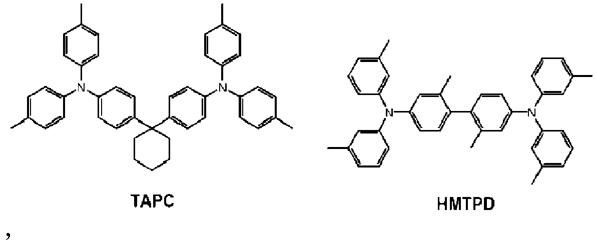

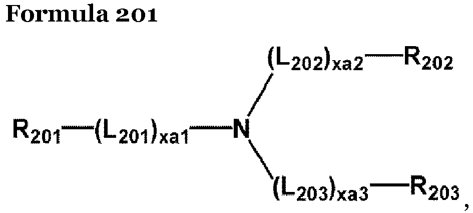

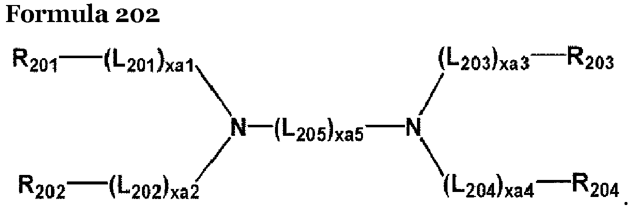

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xa1 to xa4 may each independently be an integer selected from o to 3,
xa5 may be an integer selected from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group.

For example, R₂₀₁ and R₂₀₂ in Formula 202 may optionally be linked (e.g., coupled) via a single bond, a dimethyl-methylene group, or a diphenyl-methylene group, and R₂₀₃ and R₂₀₄ in Formula 202 may optionally be linked (e.g., coupled) via a single bond, a dimethyl-methylene group, or a diphenyl-methylene group.

In one or more embodiments, in Formulae 201 and 202,

L₂₀₁ to L₂₀₅ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be o, 1, or 2.

In one or more embodiments, xa5 may be 1, 2, 3, or 4.

In one or more embodiments, R₂₀₁ to R₂₀₄ and Q₂₀₁ may each independently be selected from the group consisting of:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be the same as described above.

In one or more embodiments, at least one selected from R₂₀₁ to R₂₀₃ in Formula 201 may be selected from the group consisting of:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one or more embodiments, in Formula 202, i) R₂₀₁ and R₂₀₂ may be linked (e.g., coupled) via a single bond and/or ii) R₂₀₃ and R₂₀₄ may be linked (e.g., coupled) via a single bond.

In one or more embodiments, at least one selected from R₂₀₁ to R₂₀₄ in Formula 202 may be selected from the group consisting of:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group;
but embodiments of the present disclosure are not limited thereto.

The compound represented by Formula 201 may be represented by Formula 201A:

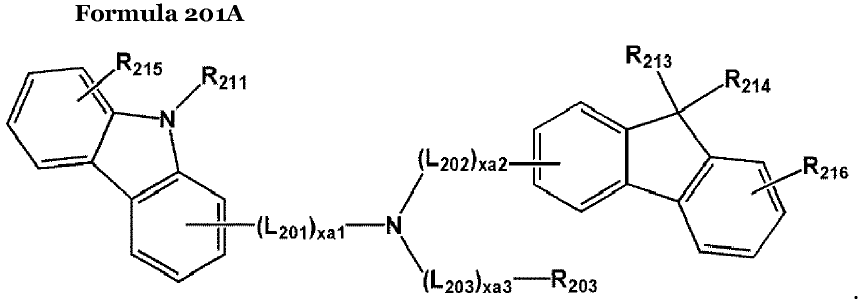

In one or more embodiments, the compound represented by Formula 201 may be represented by Formula 201A(1), but embodiments of the present disclosure are not limited thereto:

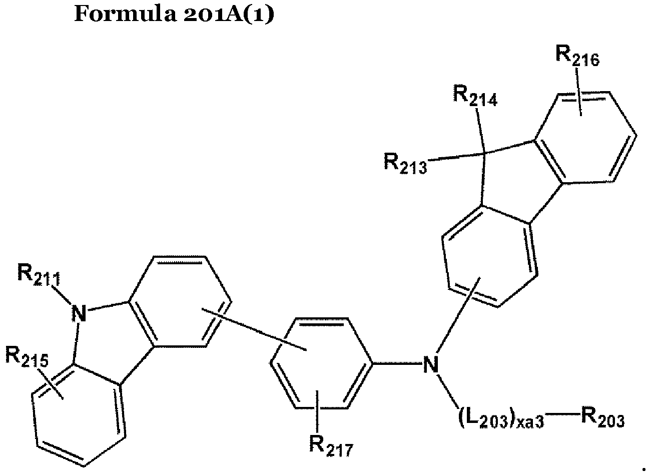

In one or more embodiments, the compound represented by Formula 201 may be represented by Formula 201A-1, but embodiments of the present disclosure are not limited thereto:

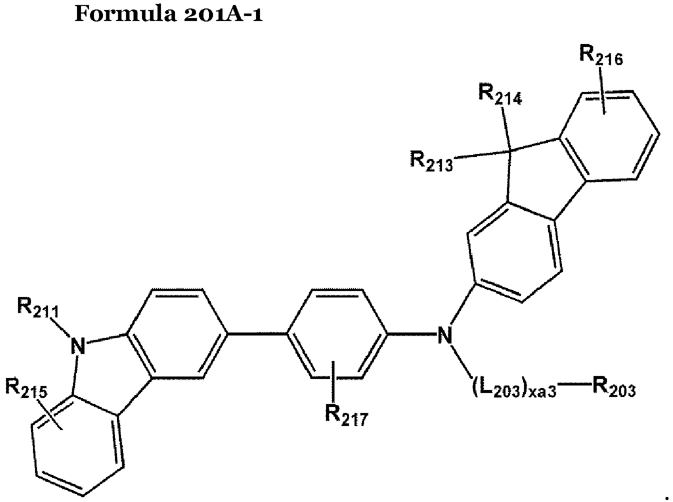

In one or more embodiments, the compound represented by Formula 202 may be represented by Formula 202A:

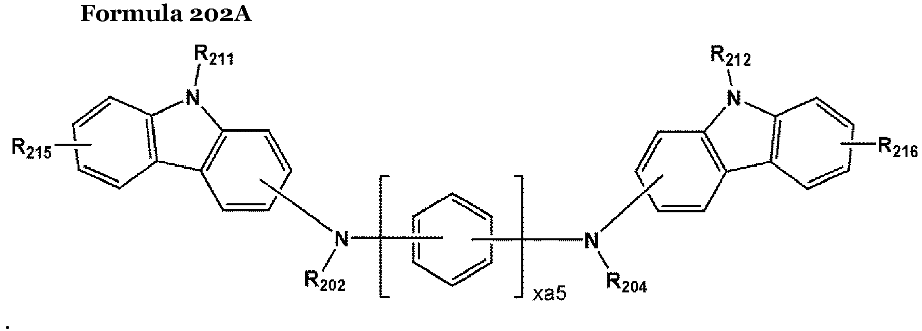

In one or more embodiments, the compound represented by Formula 202 may be represented by Formula 202A-1:

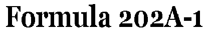

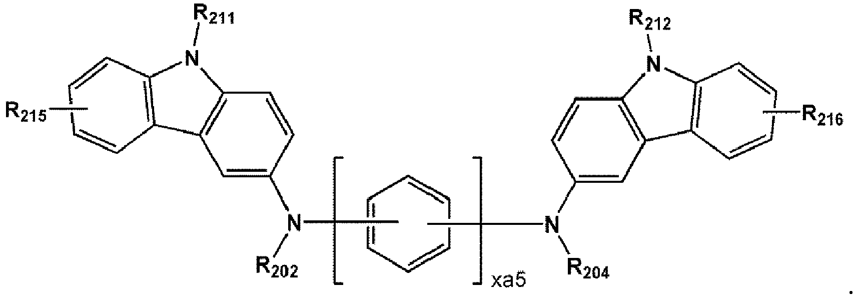

In Formulae 201A, 201A(1), 201A-1, 202A, and 202A-1,
L₂₀₁ to L₂₀₃, xa1 to xa3, xa5, and R₂₀₂ to R₂₀₄ may each independently be the same as described above,
R₂₁₁ and R₂₁₂ may each independently be the same as described herein in connection with R₂₀₃, and
R₂₁₃ to R₂₁₇ may each independently be selected from hydrogen, deuterium, -F,-Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may comprise at least one compound selected from Compounds HT1 to HT39, but embodiments of the material to be comprised in the hole transport region are not limited thereto:

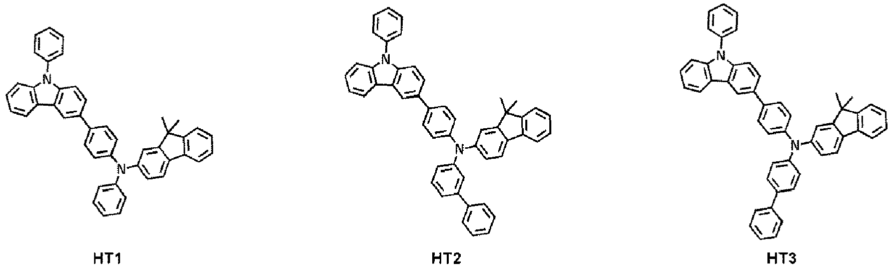

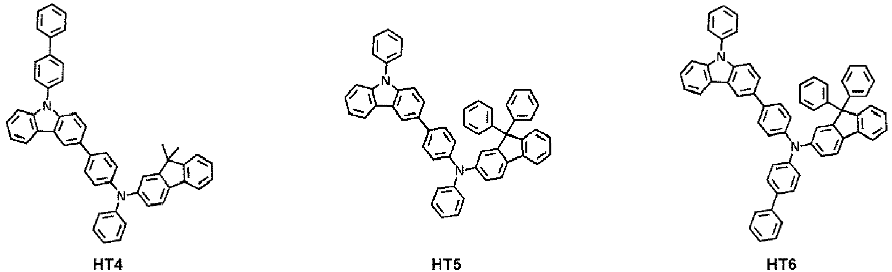

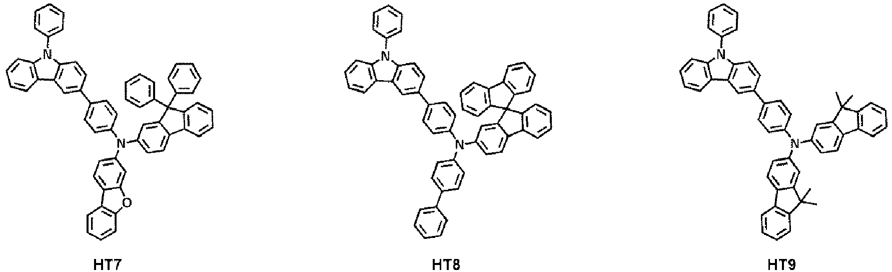

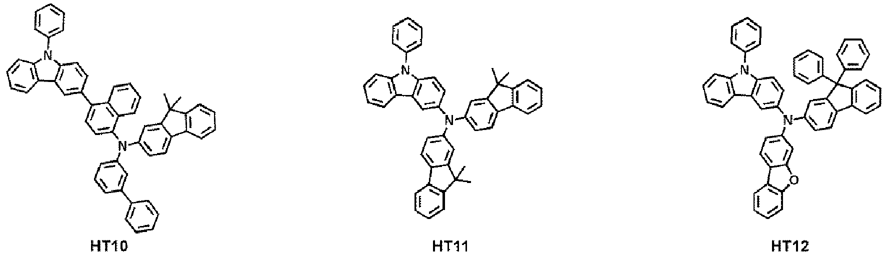

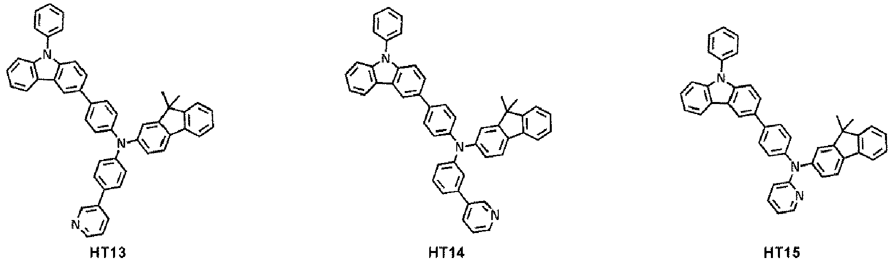

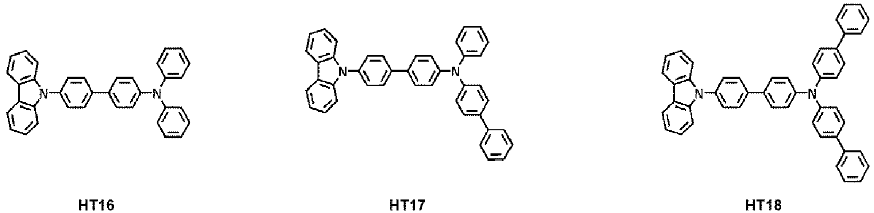

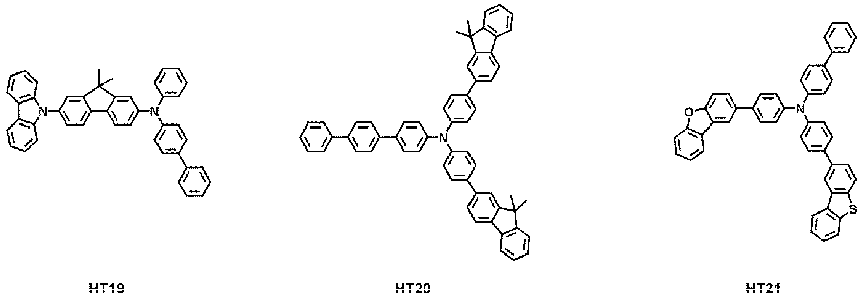

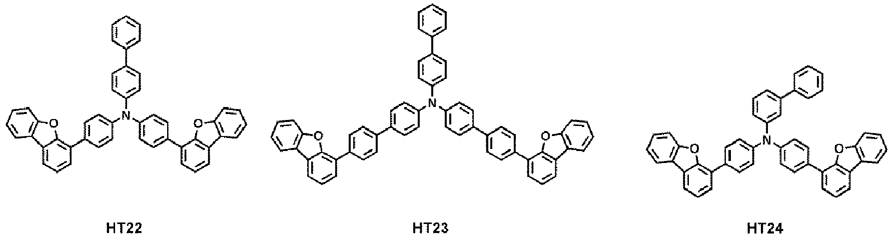

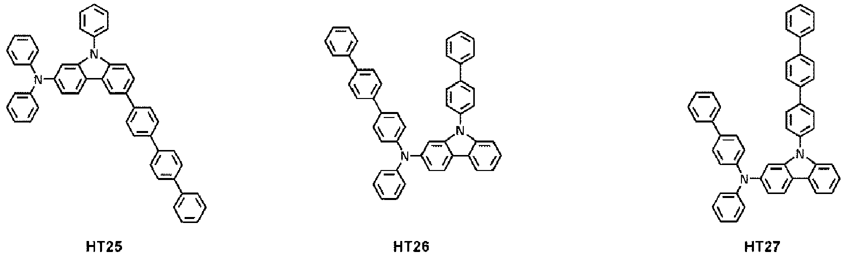

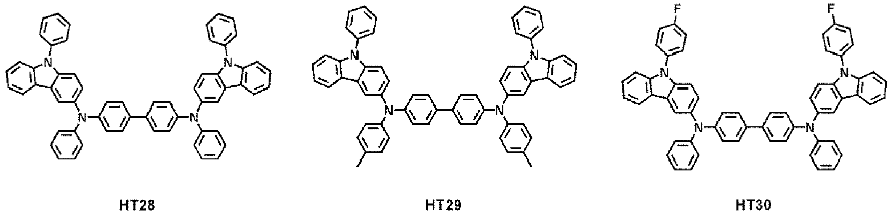

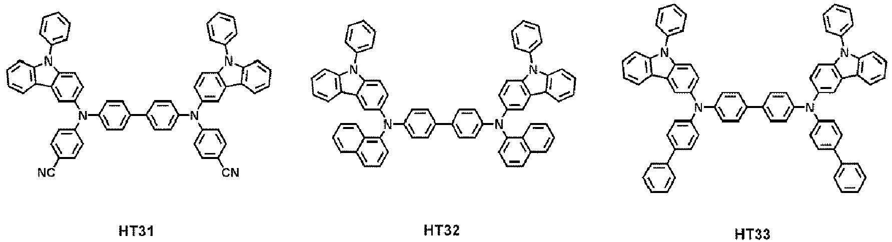

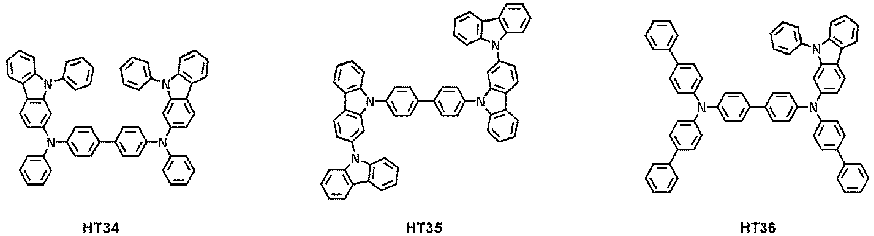

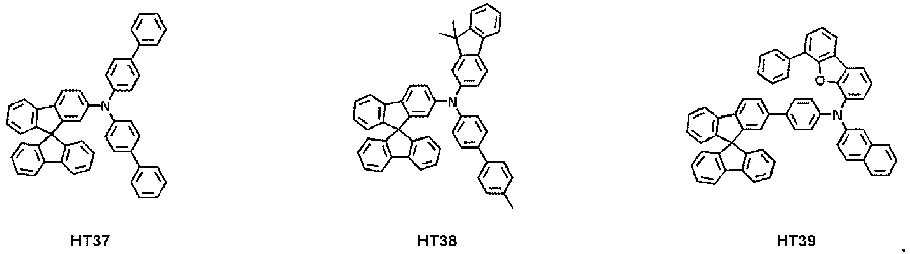

The thickness of the hole transport region may be about 100 Å to about 10,000 Å, and in some embodiments, about 100 Å to about 1,000 Å. When the hole transport region comprises at least one selected from a hole injection layer and a hole transport layer, the thickness of the hole injection layer may be about 100 Å to about 9,000 Å, and in some embodiments, about 100 Å to about 1,000 Å. The thickness of the hole transport layer may be about 50 Å to about 2,000 Å, and in some embodiments, about 100 Å to about 1,500 Å. When the thicknesses of the hole transport region, the hole injection layer, and the hole transport layer are each within these ranges, satisfactory hole transporting characteristics may be obtained without a substantial increase in driving voltage.

The emission auxiliary layer may increase the light-emission efficiency of the device by compensating for an optical resonance distance according to the wavelength of light emitted by an emission layer (e.g., adjusting the optical resonance distance to match the wavelength of light emitted from the emission layer), and the electron blocking layer may block or reduce the flow of electrons from an electron transport region. The emission auxiliary layer and the electron blocking layer may each comprise the materials as described above.

### p-dopant

The hole transport region may further comprise, in addition to these materials, a charge-generation material for the improvement of conductive properties. The charge-generation material may be homogeneously or non-homogeneously dispersed in the hole transport region.

The charge-generation material may be, for example, a p-dopant.

In one or more embodiments, the p-dopant may have a lowest unoccupied molecular orbital (LUMO) energy level of -3.5 eV or less.

The p-dopant may comprise at least one selected from a quinone derivative, a metal oxide, and a cyano group-containing compound, but embodiments of the present disclosure are not limited thereto.

For example, the p-dopant may comprise at least one selected from the group consisting of:
a quinone derivative (such as tetracyanoquinodimethane (TCNQ) and/or 2,3,5,6-tetrafluoro-7,7,8,8-tetracyanoquinodimethane (F4-TCNQ));
a metal oxide (such as tungsten oxide and/or molybdenum oxide);
1,4,5,8,9,11-hexaazatriphenylene-hexacarbonitrile (HAT-CN); and
a compound represented by Formula 221,
but embodiments of the present disclosure are not limited thereto:

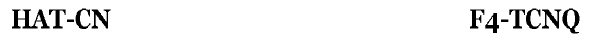

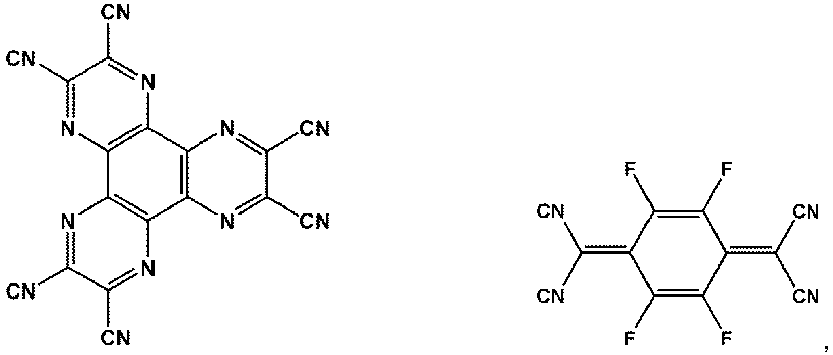

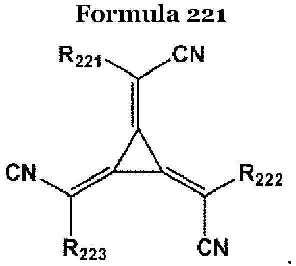

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group, wherein at least one selected from R₂₂₁ to R₂₂₃ has at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Emission layer in organic layer 150

When the organic light-emitting device 10 is a full color organic light-emitting device, the emission layer may be patterned into a red emission layer, a green emission layer, or a blue emission layer, according to a sub-pixel. In one or more embodiments, the emission layer may have a stacked structure of two or more layers selected from a red emission layer, a green emission layer, and a blue emission layer, in which the two or more layers may contact each other or may be separated from each other. In one or more embodiments, the emission layer may comprise two or more materials selected from a red-light emission material, a green-light emission material, and a blue-light emission material, in which the two or more materials are mixed together in a single layer to thereby emit white light.

In one or more embodiments, the emission layer of the organic light-emitting device 10 may be a first-color-light emission layer,
the organic light-emitting device 10 may further comprise: i) at least one second-color-light emission layer, or ii) at least one second-color-light emission layer and at least one third-color-light emission layer, both between the first electrode 110 and the second electrode 190,
wherein a maximum emission wavelength of the first-color-light emission layer, a maximum emission wavelength of the second-color-light emission layer, and a maximum emission wavelength of the third-color-light emission layer are identical to or different from each other, and
the organic light-emitting device 10 may emit mixed light comprising a first-color-light and a second-color-light, or mixed light comprising the first-color-light, the second-color-light, and a third-color-light, but embodiments of the present disclosure are not limited thereto.

For example, the maximum emission wavelength of the first-color-light emission layer may be different from the maximum emission wavelength of the second-color-light emission layer, and the mixed light comprising first-color-light and second-color-light may be white light, but embodiments of the present disclosure are not limited thereto.

In one or more embodiments, the maximum emission wavelength of the first-color-light emission layer, the maximum emission wavelength of the second-color-light emission layer, and the maximum emission wavelength of the third-color-light emission layer may be different from one another, and the mixed light comprising first-color-light, second-color-light, and third-color-light may be white light. However, embodiments of the present disclosure are not limited thereto.

As used herein the maximum emission wavelength of an emission layer is the wavelength of light emitted by the emission layer with maximum intensity.

The emission layer comprises at least one compound represented by one selected from Formulae 2-1, 2-2, and 2-3.

In one or more embodiments, the emission layer may comprise a host and a dopant, and the host may comprise the at least one compound represented by one selected from Formulae 2-1, 2-2, and 2-3.

The dopant may comprise at least one selected from a phosphorescent dopant and a fluorescent dopant.

The amount of the dopant in the emission layer may be about 0.01 to about 15 parts by weight based on 100 parts by weight of the host, but embodiments of the present disclosure are not limited thereto.

The thickness of the emission layer may be about 100 Å to about 1,000 Å, and in some embodiments, about 200 Å to about 600 Å. When the thickness of the emission layer is within these ranges, excellent light-emission characteristics may be obtained without a substantial increase in driving voltage.

### Host in emission layer

The host may comprise at least one compound represented by one selected from Formulae 2-1, 2-2, and 2-3.

In one or more embodiments, the host may comprise (e.g., consist of) the compound represented by one selected from Formulae 2-1, 2-2, and 2-3.

In one or more embodiments, the host may further comprise, in addition to the at least one compound represented by one selected from Formulae 2-1, 2-2, and 2-3, any suitable host (as described in Example 2-15, for example).

### Phosphorescent dopant included in emission layer in organic layer 150

The phosphorescent dopant may comprise an organometallic complex represented by Formula 401:

### Formula 401

### M(L₄₀₁)_{xc1}(L₄₀₂)X_{c2},

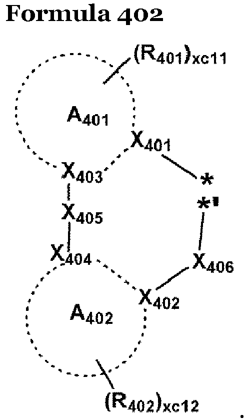

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
L₄₀₁ may be selected from ligands represented by Formula 402, and xc1 may be 1, 2, or 3, wherein when xc1 is two or more, two or more L₄₀₁(s) may be identical to or different from each other,
L₄₀₂ may be an organic ligand, and xc2 may be an integer selected from o to 4, wherein when xc2 is two or more, two or more L₄₀₂(s) may be identical to or different from each other,
X₄₀₁ to X₄₀₄ may each independently be nitrogen or carbon,
X₄₀₁ and X₄₀₃ may be linked (e.g., coupled) via a single bond or a double bond, and X₄₀₂ and X₄₀₄ may be linked (e.g., coupled) via a single bond or a double bond,
A₄₀₁ and A₄₀₂ may each independently be selected from a C₅-C₆₀ carbocyclic group or a C₁-C₆₀ heterocyclic group,
X₄₀₅ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)=*', wherein Q₄₁₁ and Q₄₁₂ may be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₄₀₁)(Q₄₀₂)(Q₄₀₃), -N(Q₄₀₁)(Q₄₀₂), -B(Q₄₀₁)(Q₄₀₂),-C(=O)(Q₄₀₁), -S(=O)2(Q₄₀₁), and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer selected from o to 10, and
* and *' in Formula 402 may each independently indicate a binding site to M in Formula 401.

In one or more embodiments, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402: i) X₄₀₁ may be nitrogen and X₄₀₂ may be carbon, or ii) X₄₀₁ and X₄₀₂ may both be nitrogen at the same time (e.g., simultaneously).

In one or more embodiments, R₄₀₂ and R₄₀₁ in Formula 402 may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantyl group, a norbornanyl group, and a norbornenyl group;
a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, when xc1 in Formula 401 is two or more, two A₄₀₁(s) in two or more L₄₀₁(s) may be optionally linked (e.g., coupled) via X₄₀₇, and/or two A₄₀₂(s) in two or more L₄₀₁(s) may be optionally linked (e.g., coupled) via X₄₀₈ (see Compounds PD1 to PD4 and PD7). X₄₀₇ and X₄₀₈ may each independently be a single bond, *-O-*', *-S-*', *-C(=O)-*', *-N(Q₄₁₃)-*', *-C(Q₄₁₃)(Q₄₁₄)-*', or *-C(Q₄₁₃)=C(Q₄₁₄)-*' (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but embodiments of the present disclosure are not limited thereto.

L₄₀₂ in Formula 401 may be a monovalent, divalent, or trivalent organic ligand. For example, L₄₀₂ may be selected from a halogen, a diketone (for example, acetylacetonate), a carboxylic acid (for example, picolinate), -C(=O), an isonitrile, -CN, and a phosphorus-based ligand (for example, phosphine and/or phosphite), but embodiments of the present disclosure are not limited thereto.

In one or more embodiments, the phosphorescent dopant may be selected from, for example, Compounds PD1 to PD25, but embodiments of the present disclosures are not limited thereto:

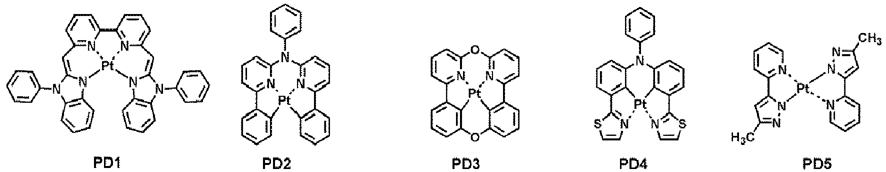

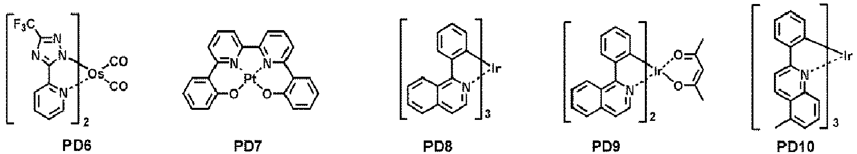

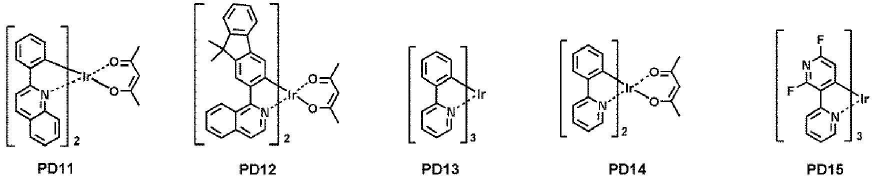

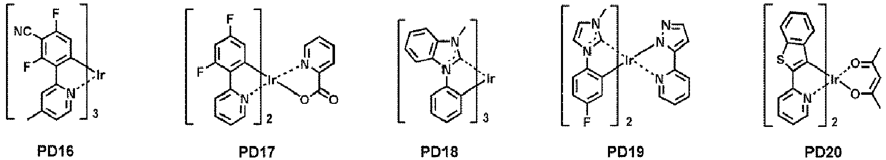

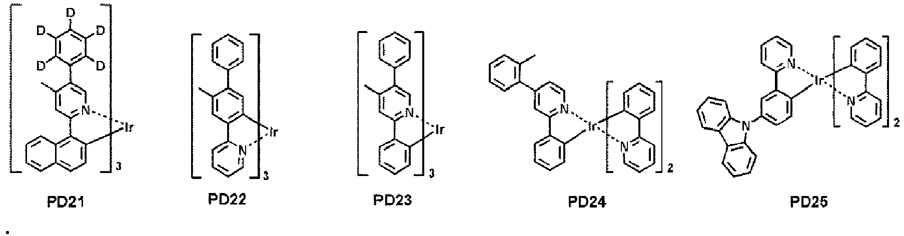

### Fluorescent dopant in emission layer

The fluorescent dopant may comprise an arylamine compound or a styrylamine compound.

In one or more embodiments, the fluorescent dopant may comprise a compound represented by Formula 501:

### Formula 501

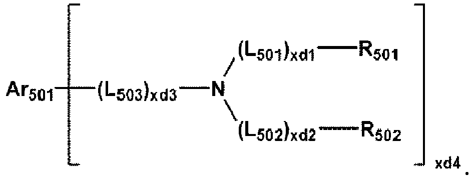

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xd1 to xd3 may each independently be an integer selected from o to 3;
R₅₀₁ and R₅₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group, and
xd4 may be an integer selected from 1 to 6.

In one or more embodiments, Ar₅₀₁ in Formula 501 may be selected from the group consisting of:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, L₅₀₁ to L₅₀₃ in Formula 501 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R₅₀₁ and R₅₀₂ in Formula 501 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

For example, the fluorescent dopant may be selected from Compounds FD1 to FD22:

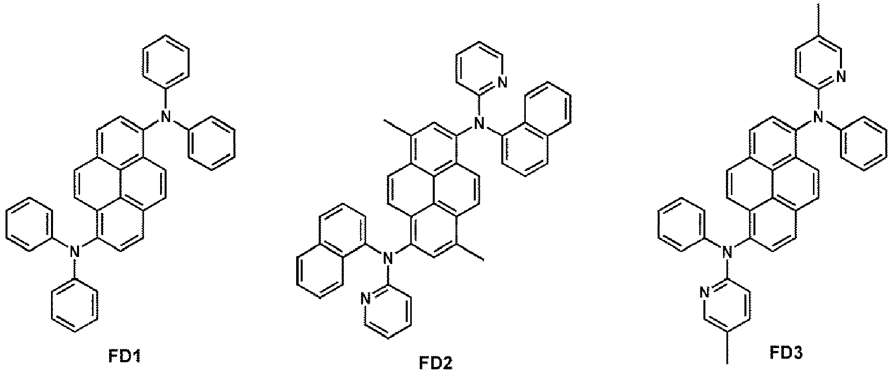

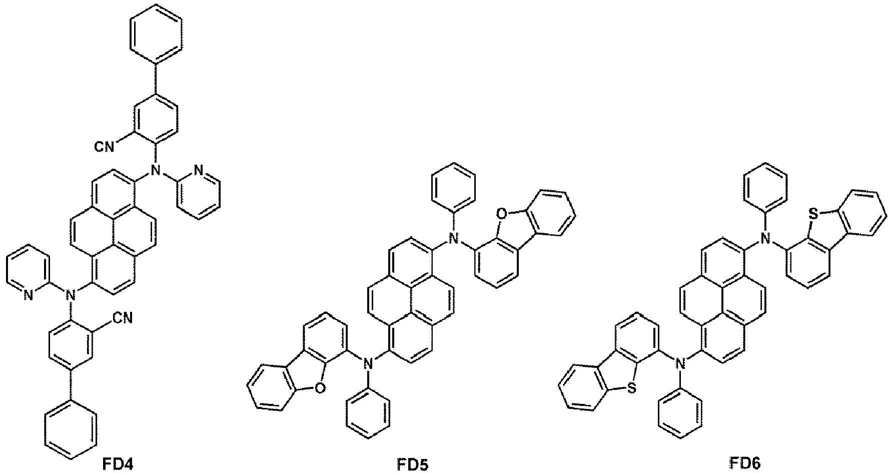

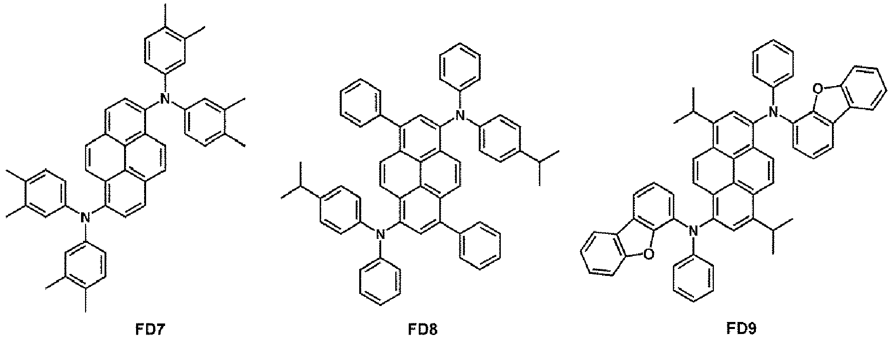

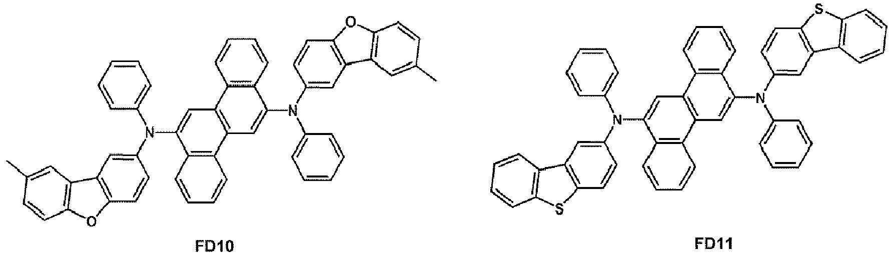

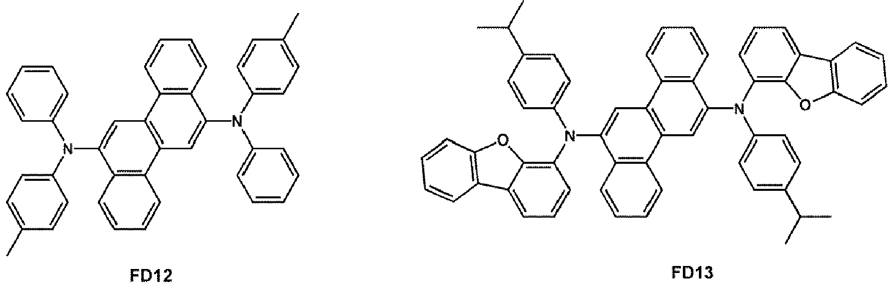

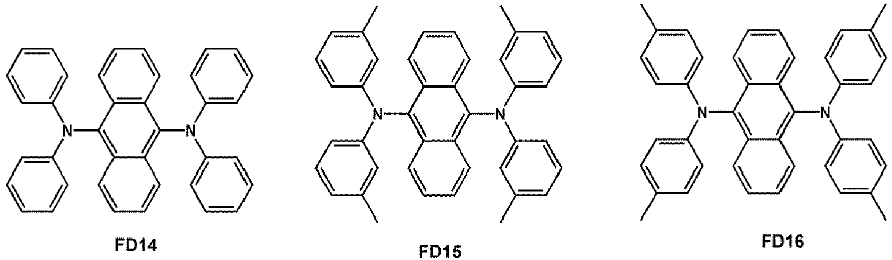

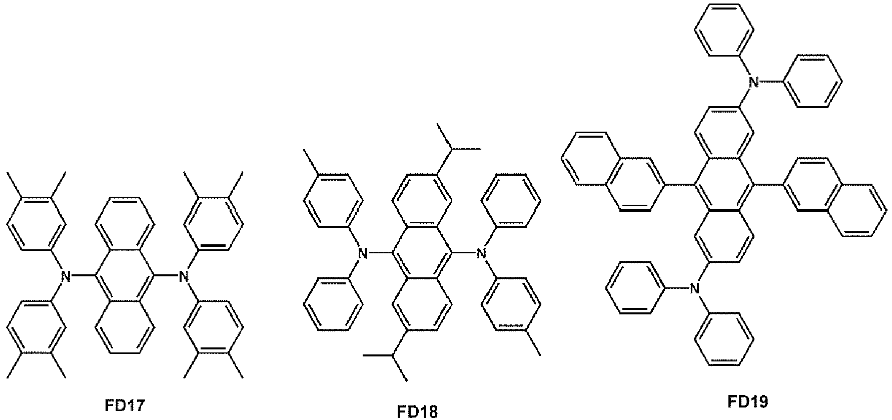

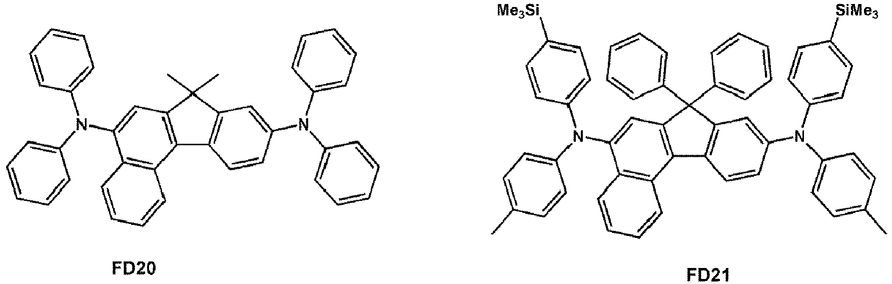

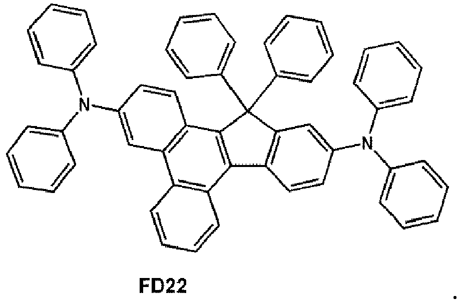

In one or more embodiments, the fluorescent dopant may be selected from the following compounds, but embodiments of the present disclosure are not limited thereto:

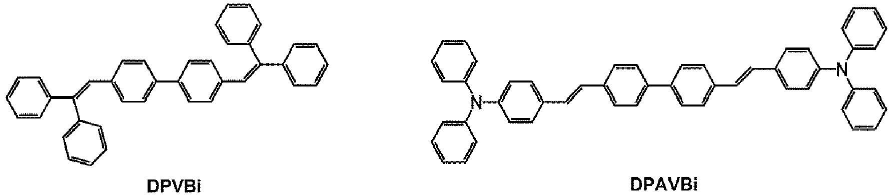

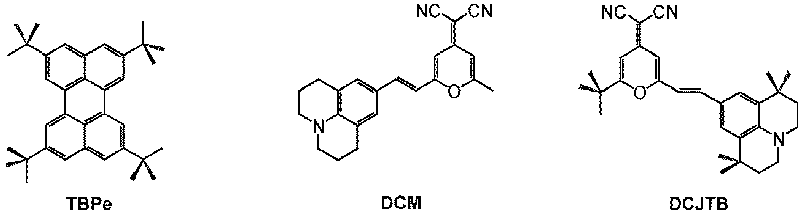

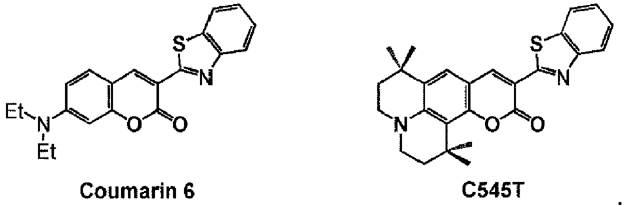

### Electron transport region in organic layer 150

The electron transport region may have: i) a single-layered structure including (e.g., consisting of) a single layer including (e.g., consisting of) a single material, ii) a single-layered structure including (e.g., consisting of) a single layer comprising a plurality of different materials, or iii) a multi-layered structure having a plurality of layers comprising a plurality of different materials.

The electron transport region may comprise at least one selected from a buffer layer, a hole blocking layer, an electron control layer, an electron transport layer, and an electron injection layer, but embodiments of the present disclosure are not limited thereto. The electron transport layer may have a single-layered structure or a multi-layered structure (for example, a first electron transport layer and a second electron transport layer).

For example, the electron transport region may have a structure of electron transport layer/electron injection layer, hole blocking layer/electron transport layer/electron injection layer, electron control layer/electron transport layer/electron injection layer, buffer layer/electron transport layer/electron injection layer, or first electron transport layer/second electron transport layer/electron injection layer, wherein layers of each structure may be sequentially stacked in each stated order on the emission layer. However, embodiments of the structure of the electron transport layer are not limited thereto.

The electron transport region comprises at least one compound represented by Formula 1.

In one or more embodiments, the electron transport region may comprise an electron transport layer and an electron injection layer sequentially stacked in this stated order on the emission layer, and the electron transport layer may comprise the at least one compound represented by Formula 1.

In one or more embodiments, the electron transport region may comprise a first electron transport layer, a second electron transport layer, and an electron injection layer sequentially stacked in this stated order on the emission layer, and at least one selected from the first electron transport layer and the second electron transport layer may comprise the at least one compound represented by Formula 1.

In one or more embodiments, the electron transport region may comprise, in addition to the at least one compound represented by Formula 1, at least one selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-*tert*-butylphenyl)-4-phenyl-4H-1,2,4-triazole (TAZ), and NTAZ:

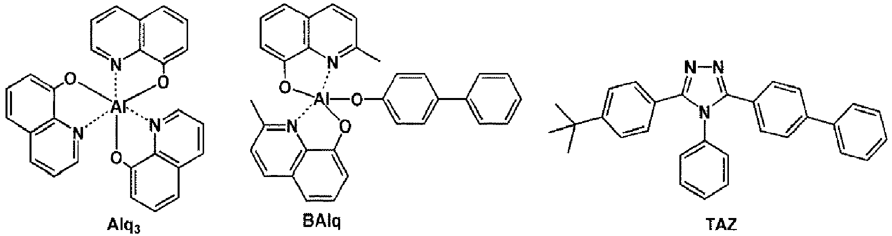

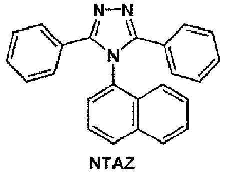

The thicknesses of the buffer layer, the hole blocking layer, and the electron control layer may each independently be about 20 Å to about 1,000 Å, and in some embodiments, about 30 Å to about 300 Å. When the thicknesses of the buffer layer, the hole blocking layer, and the electron control layer are each within these ranges, the electron blocking layer may have excellent electron blocking characteristics and/or electron control characteristics without a substantial increase in driving voltage.

The thickness of the electron transport layer may be about 100 Å to about 1,000 Å, and in some embodiments, about 150 Å to about 500 Å. When the thickness of the electron transport layer is within these ranges, the electron transport layer may have satisfactory electron transport characteristics without a substantial increase in driving voltage.

The electron transport region (for example, the electron transport layer in the electron transport region) may further comprise, in addition to the materials described above, a metal-containing material.

The metal-containing material may comprise at least one selected from an alkali metal complex and an alkaline earth metal complex. The alkali metal complex may comprise a metal ion selected from an Li ion, a Na ion, a K ion, a Rb ion, and a Cs ion, and the alkaline earth metal complex may comprise a metal ion selected from a Be ion, a Mg ion, a Ca ion, an Sr ion, and a Ba ion. Each ligand coordinated with the metal ion of the alkali metal complex or the alkaline earth metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may comprise a Li complex. The Li complex may comprise, for example, Compound ET-D₁ (8-hydroxyquinolinolatolithium, LiQ) or ET-D2.

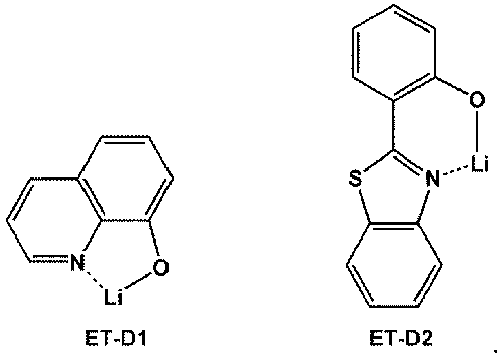

The electron transport region may comprise an electron injection layer that facilitates injection of electrons from the second electrode 190. The electron injection layer may directly contact the second electrode 190.

The electron injection layer may have: i) a single-layered structure including (e.g., consisting of) a single layer including (e.g., consisting of)a single material, ii) a single-layered structure including (e.g., consisting of) a single layer comprising a plurality of different materials, or iii) a multi-layered structure having a plurality of layers comprising a plurality of different materials.

The electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

In one or more embodiments, the electron injection layer may comprise lithium (Li), sodium (Na), potassium (K), rubidium (Rb), cesium (Cs), magnesium (Mg), calcium (Ca), erbium (Er), thulium (Tm), ytterbium (Yb), or a combination thereof. However, embodiments of the material comprised in the electron injection layer are not limited thereto.

The alkali metal may be selected from Li, Na, K, Rb, and Cs. In one or more embodiments, the alkali metal may be Li, Na, or Cs. In one or more embodiments, the alkali metal may be Li or Cs, but embodiments of the present disclosure are not limited thereto.

The alkaline earth metal may be selected from Mg, Ca, strontium (Sr), and barium (Ba).

The rare earth metal may be selected from scandium (Sc), yttrium (Y), cerium (Ce), Yb, gadolinium (Gd), and terbium (Tb).

The alkali metal compound, the alkaline earth metal compound, and the rare earth metal compound may be selected from oxides and halides (for example, fluorides, chlorides, bromides, and/or iodides) of the alkali metal, the alkaline earth metal, and rare earth metal, respectively.

The alkali metal compound may be selected from alkali metal oxides (such as Li₂O, Cs₂O, and/or K₂O), and alkali metal halides (such as LiF, NaF, CsF, KF, LiI, NaI, CsI, and/or KI). In one or more embodiments, the alkali metal compound may be selected from LiF, Li₂O, NaF, LiI, NaI, CsI, and KI, but embodiments of the present disclosure are not limited thereto.

The alkaline earth metal compound may be selected from alkaline earth metal compounds (such as BaO, SrO, CaO, BaₓSr₁₋ₓO (o<x<1), and/or BaxCa₁₋ₓO (o<x<1)). In one or more embodiments, the alkaline earth metal compound may be selected from BaO, SrO, and CaO, but embodiments of the present disclosure are not limited thereto.

The rare earth metal compound may be selected from YbF₃, ScF₃, ScO₃, Y₂O₃, Ce₂O₃, GdF₃, and TbF₃. In one or more embodiments, the rare earth metal compound may be selected from YbF₃, ScF₃, TbF₃, YbI₃, ScI₃, and TbI₃, but embodiments of the present disclosure are not limited thereto.

The alkali metal complex, the alkaline earth metal complex, and the rare earth metal complex may comprise an alkali metal ion, alkaline earth metal ion, and rare earth metal ion as described above, and each ligand coordinated with a metal ion of the alkali metal complex, the alkaline earth metal complex, and the rare earth metal complex may independently be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

The electron injection layer may comprise (e.g., consist of) an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof, as described above. In one or more embodiments, the electron injection layer may further comprise an organic material. When the electron injection layer further comprises an organic material, the alkali metal, the alkaline earth metal, the rare earth metal, the alkali metal compound, the alkaline earth metal compound, the rare earth metal compound, the alkali metal complex, the alkaline earth metal complex, the rare earth metal complex, or the combination thereof may be homogeneously or non-homogeneously dispersed in a matrix comprising the organic material.

The thickness of the electron injection layer may be about 1 Å to about 100 Å, and in some embodiments, about 3 Å to about 90 Å. When the thickness of the electron injection layer is within these ranges, the electron injection layer may have satisfactory electron injection characteristics without a substantial increase in driving voltage.

In one or more embodiments, the electron transport region of the organic light-emitting device 10 may comprise a buffer layer, an electron transport layer, and an electron injection layer, and
at least one selected from the electron transport layer and the electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

### Second electrode 190

The second electrode 190 may be on the organic layer 150. The second electrode 190 may be a cathode that is an electron injection electrode, and in this regard, the material for forming the second electrode 190 may be a material having a low work function (such as a metal, an alloy, an electrically conductive compound, or a mixture thereof).

The second electrode 190 may comprise at least one selected from lithium (Li), silver (Si), magnesium (Mg), aluminum (Al), aluminum-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layered structure, or a multi-layered structure comprising two or more layers.

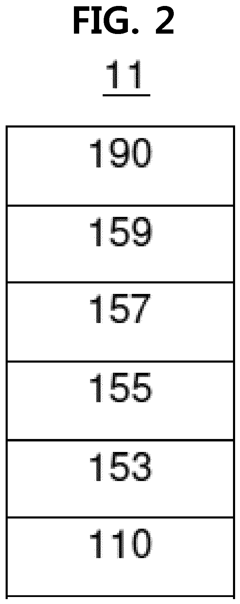

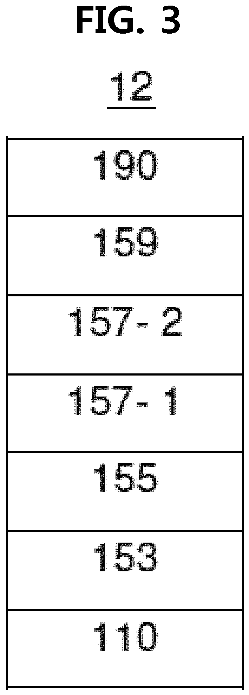

### Description of FIGS. 2 and 3

FIG. 2 is a schematic view of an organic light-emitting device 11 according to an embodiment of the present disclosure. The organic light-emitting device 11 may comprise a first electrode 110, a hole transport layer 153, an emission layer 155, an electron transport layer 157, an electron injection layer 159, and a second electrode 190, which may be sequentially stacked in this stated order.
FIG. 3 is a schematic view of an organic light-emitting device 12 according to an embodiment of the present disclosure. The organic light-emitting device 12 may comprise a first electrode 110, a hole transport layer 153, an emission layer 155, a first electron transport layer 157-1, a second electron transport layer 157-2, an electron injection layer 159, and a second electrode 190, which may be sequentially stacked in this stated order.

The respective layers constituting the organic light-emitting devices 11 and 12 of FIGS. 2 and 3 may be understood by referring to the descriptions above.

Hereinbefore, the organic light-emitting device according to an embodiment of the present disclosure has been described in connection with FIGS. 1-3. However, embodiments of the present disclosure are not limited thereto.

The layers constituting the hole transport region, the emission layer, and the layers constituting the electron transport region may be formed in a specific region of the device using one or more suitable methods selected from vacuum deposition, spin coating, casting, Langmuir-Blodgett (LB) deposition, ink-jet printing, laser-printing, and laser-induced thermal imaging.

When the respective layers of the hole transport region, the emission layer, and the respective layers of the electron transport region are formed by deposition, the deposition may be performed at a deposition temperature of about 100°C to about 500°C, at a vacuum degree of about 10⁻⁸ to about 10⁻³ torr, and at a deposition rate of about 0.01 to about 100 Å/sec, depending on the compound to be deposited in each layer and the structure of each layer to be formed.

When the layers constituting the hole transport region, the emission layer, and the layers constituting the electron transport region are formed by spin coating, the spin coating may be performed at a coating speed of about 2,000 rpm to about 5,000 rpm and at a heat treatment temperature of about 80°C to 200°C, depending on the compound to be comprised in a layer and the structure of each layer to be formed.

### General definition of substituents

The term "C₁-C₆₀ alkyl group" as used herein refers to a linear or branched saturated aliphatic hydrocarbon monovalent group having 1 to 60 carbon atoms, e.g. 1 to 30 carbon atoms, 1 to 20 carbon atoms, 1 to 10 carbon atoms, 1 to 6 carbon atoms or 1 to 4 carbon atoms. N on-limiting examples thereof may include a methyl group, an ethyl group, a propyl group, an isobutyl group, a *sec*-butyl group, a *tert*-butyl group, a pentyl group, an iso-amyl group, and a hexyl group. The term "C₁-C₆₀ alkylene group" as used herein refers to a divalent group having substantially the same structure as the C₁-C₆₀ alkyl group.

The term "C₂-C₆₀ alkenyl group" as used herein refers to a hydrocarbon group formed by substituting at least one carbon-carbon double bond in the body (e.g., middle) or at the terminus of the C₂-C₆₀ alkyl group, and non-limiting examples thereof may include an ethenyl group, a propenyl group, and a butenyl group. The term "C₂-C₆₀ alkenylene group" as used herein refers to a divalent group having substantially the same structure as the C₂-C₆₀ alkenyl group.

The term "C₂-C₆₀ alkynyl group" as used herein refers to a hydrocarbon group formed by substituting at least one carbon-carbon triple bond in the body (e.g., middle) or at the terminus of the C₂-C₆₀ alkyl group, and non-limiting examples thereof may include an ethynyl group and a propynyl group. The term "C₂-C₆₀ alkynylene group" as used herein refers to a divalent group having substantially the same structure as the C₂-C₆₀ alkynyl group.

The term "C₁-C₆₀ alkoxy group" as used herein refers to a monovalent group represented by -O-A₁₀₁ (wherein A₁₀₁ is a C₁-C₆₀ alkyl group), and non-limiting examples thereof may include a methoxy group, an ethoxy group, and an isopropyloxy group.

The term "C₃-C₁₀" cycloalkyl group" as used herein refers to a monovalent saturated hydrocarbon monocyclic group having 3 to 10 carbon atoms, and non-limiting examples thereof may include a cyclopropyl group, a cyclobutyl group, a cyclopentyl group, a cyclohexyl group, and a cycloheptyl group. The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a monovalent saturated monocyclic group having at least one heteroatom (e.g. 1, 2, 3, 4 or 5 hereoatoms) selected from N, O, Si, P, and S as a ring-forming atom and 1 to 10 carbon atoms e.g. 1, 2, 3, 4 or 5 ring carbon atoms, and non-limiting examples thereof may include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent unsaturated monocyclic group that has 3 to 10 carbon atoms and at least one carbon-carbon double bond in the ring thereof and does not have aromaticity, and non-limiting examples thereof may include a cyclopentenyl group, a cyclohexenyl group, and a cycloheptenyl group. The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent unsaturated monocyclic group that has at least one heteroatom (e.g. 1, 2, 3, 4 or 5 hereoatoms) selected from N, O, Si, P, and S as a ring-forming atom, 1 to 10 carbon atoms e.g. 1, 2, 3, 4 or 5 ring carbon atoms, and at least one carbon-carbon double bond in its ring. Non-limiting examples of the C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having an aromatic system having 6 to 60 carbon atoms, e.g. 6 to 20 ring carbon atoms, 6 to 14 ring cabon atoms or 6 to 10 ring carbon atoms. The term "C₆-C₆₀ arylene group" as used herein refers to a divalent group having an aromatic system having 6 to 60 carbon atoms e.g. 6 to 20 ring carbon atoms, 6 to 14 ring cabon atoms or 6 to 10 ring carbon atoms.. Non-limiting examples of the C₆-C₆₀ aryl group may include a phenyl group, a naphthyl group, an anthracenyl group, a phenanthrenyl group, a pyrenyl group, and a chrysenyl group. When the C₆-C₆₀ aryl group and the C₆-C₆₀ arylene group each comprise two or more rings, the rings may be fused (e.g., condensed).

The term "C₁-C₆₀ heteroaryl group" as used herein refers to a monovalent group having an aromatic system that has at least one heteroatom (e.g. 1, 2, 3, 4 or 5 hereoatoms) selected from N, O, silicon (Si), phosphorus (P), and sulfur (S) as a ring-forming atom, in addition to 1 to 60 carbon atoms e.g. 1 to 19 ring carbon atoms, 1 to 13 ring cabon atoms or 1 to 9 ring carbon atoms. The term "C₁-C₆₀ heteroarylene group" as used herein refers to a divalent group having a heterocyclic aromatic system that has at least one heteroatom (e.g. 1, 2, 3, 4 or 5 hereoatoms) selected from N, O, Si, P, and S as a ring-forming atom, in addition to 1 to 60 carbon atoms e.g. 1 to 19 ring carbon atoms, 1 to 13 ring cabon atoms or 1 to 9 ring carbon atoms. Non-limiting examples of the C₁-C₆₀ heteroaryl group may include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each comprise two or more rings, the rings may be fused (e.g., condensed).

The term "C₆-C₆₀ aryloxy group" as used herein refers to -O-A₁₀₂ (wherein A₁₀₂ is a C₆-C₆₀ aryl group), and the term "C₆-C₆₀ arylthio group" as used herein refers to -S-A₁₀₃ (wherein A₁₀₃ is a C₆-C₆₀ aryl group).

The term "monovalent non-aromatic condensed C8-C60 polycyclic group" as used herein refers to a monovalent group that has two or more rings condensed (e.g., fused), 8 to 60 carbon atoms (for example, 8 to 20, 8 to 14 or 8 to 10 ring carbon atoms) as the only ring-forming atoms, and non-aromaticity in the entire molecular structure. A monovalent non-aromatic condensed C8 to C60 polycyclic group may comprise two rings linked via a spiro atom, in addition to the two or more rings fused (e.g. condensed) to each other. Non-limiting examples of the monovalent non-aromatic condensed C8-C60 polycyclic group include a fluorenyl group and a spiro-bifluorenyl group. The term "divalent non-aromatic condensed C8-C60 polycyclic group" as used herein refers to a divalent group having substantially the same structure as the monovalent non-aromatic condensed C8-C60 polycyclic group.

The term "monovalent non-aromatic condensed 8- to 60-membered heteropolycyclic group" as used herein refers to a monovalent group having 8- to 60-ring-forming atoms that has two or more rings condensed (e.g., fused), has at least one heteroatom (e.g. 1, 2, 3, 4 or 5 hereoatoms) selected from N, O, Si, P, and S, other than carbon atoms (for example, 1 to 59, 2 to 59, 2 to 19, 2 to 13 or 2 to 9 ring carbon atoms), as ring-forming atoms, and has non-aromaticity in the entire molecular structure. A monovalent non-aromatic condensed 8- to 60-membered heteropolycyclic group may comprise two rings linked via a spiro atom, in addition to the two or more rings fused (e.g. condensed) to each other. A non-limiting example of the monovalent non-aromatic condensed 8- to 60-membered heteropolycyclic group may be a carbazolyl group. The term "divalent non-aromatic condensed 8- to 60-membered heteropolycyclic group" as used herein refers to a divalent group having substantially the same structure as the monovalent non-aromatic condensed 8- to 60-membered heteropolycyclic group.

The term "C₅-C₆₀ carbocyclic group" as used herein refers to a monocyclic or polycyclic group having 5 to 60 carbon atoms e.g. 5 to 20 ring carbon atoms, 5 to 14 ring cabon atoms or 5 to 10 ring carbon atoms as the only ring-forming atoms. The C₅-C₆₀ carbocyclic group may be an aromatic carbocyclic group or a non-aromatic carbocyclic group. The C₅-C₆₀ carbocyclic group may be a saturated carbocyclic group or an unsaturated carbocyclic group. The C₅-C₆₀ carbocyclic group may be a ring (such as a benzene ring), a monovalent group (such as a phenyl group), or a divalent group (such as a phenylene group). In one or more embodiments, depending on the number of substituents connected to the C₅-C₆₀ carbocyclic group, the C₅-C₆₀ carbocyclic group may be a trivalent group or a quadrivalent group.

The term "C₁-C₆₀ heterocyclic group" as used herein refers to a group having substantially the same structure as the C₁-C₆₀ carbocyclic group, except that at least one heteroatom (e.g. 1, 2, 3, 4 or 5 hereoatoms) selected from N, O, Si, P, and S is used in addition to 1 to 60 carbon atoms (for example, 1 to 20 ring carbon atoms, 1 to 14 ring cabon atoms or 1 to 10 ring carbon atoms) as ring-forming atoms.

The term "C₂-C₆₀ heterocyclic group" as used herein refers to a group having substantially the same structure as the C₂-C₆₀ carbocyclic group, except that at least one heteroatom (e.g. 1, 2, 3, 4 or 5 hereoatoms) selected from N, O, Si, P, and S is used in addition to 2 to 60 carbon atoms (for example, 2 to 20 ring carbon atoms, 2 to 14 ring cabon atoms or 2 to 10 ring carbon atoms) as ring-forming atoms.

Certain groups are specified herein as being substituted or unsubstituted. Unless otherwise specified, when a group is substituted it is typically substituted with 1, 2, 3 or 4 substituents. For example, when a group is substituted it may substituted with 1, 2 or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from the group consisting of:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂),
wherein Q₁ to Q₃, Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C8-C60 polycyclic group, and a monovalent non-aromatic condensed 8- to 60-membered heteropolycyclic group.

The term "Ph" as used herein may refer to a phenyl group; the term "Me" as used herein may refer to a methyl group; the term "Et" as used herein may refer to an ethyl group; the terms "ter-Bu" and "But" as used herein may refer to a *tert*-butyl group; and the term "OMe" as used herein may refer to a methoxy group.

The term "biphenyl group" as used herein refers to "a phenyl group substituted with a phenyl group." In other words, a "biphenyl group" is a substituted phenyl group having a C₆-C₆₀ aryl group as a substituent.

The term "terphenyl group" as used herein refers to "a phenyl group substituted with a biphenyl group." In other words, a "terphenyl group" is a substituted phenyl group having a C₆-C₆₀ aryl group substituted with a C₆-C₆₀ aryl group as a substituent.
* and *' used herein, unless defined otherwise, each refer to a binding site to a neighboring atom in a corresponding formula.

Hereinafter, compounds according to an embodiment of the present disclosure and an organic light-emitting device according to an embodiment of the present disclosure will be described in more detail with reference to Synthesis Examples and Examples. The wording "B was used instead of A" used in describing Synthesis Examples refers to that an identical molar equivalent of B was used in place of A.

### Example

### Example 1-1 (Red Light-Emitting Device)

An anode was prepared from an ITO glass substrate (manufactured by Corning) comprising an ITO layer deposited to a thickness of 15 Ω/cm² (120 nm) by cutting the ITO substrate to a size of 50 mm x 50 mm x 0.5 mm, ultrasonically cleaning the ITO glass substrate (anode) using isopropyl alcohol and pure water each for 15 minutes, and exposing the ITO glass substrate (anode) to UV irradiation and ozone for 30 minutes to clean. Then, the ITO glass substrate (anode) was loaded into a vacuum deposition apparatus.

Compound HT₃ was vacuum-deposited on the ITO glass substrate (anode) to form a hole transport layer having a thickness of 70 nm.

Compound 2-14 (host) and Ir(pq)₂acac (dopant, at an amount of 2 wt%) were co-deposited on the hole transport layer to form an emission layer having a thickness of 30 nm.

Compound 1-17 was vacuum-deposited on the emission layer to form an electron transport layer having a thickness of 30 nm, and LiF was deposited on the electron transport layer to form an electron injection layer having a thickness of 1 nm. Then, Al was vacuum-deposited on the electron injection layer to form a second electrode (cathode) having a thickness of 200 nm, thereby completing the manufacture of an organic light-emitting device.

### Examples 1-2 to 1-8 and Comparative Examples 1-1 and 1-4

Organic light-emitting devices of Examples 1-2 to 1-8 and Comparative Examples 1-1 to 1-4 were manufactured in substantially the same manner as in Example 1-1, except that the host material unsed in each emission layer and an electron transport layer material were changed, as shown in Table 1.

### Examples 1-9 to 1-16

Additional organic light-emitting devices of Examples 1-9 to 1-16 were manufactured in substantially the same manner as in Example 1-1, except that: 1) the host material used in each emission layer was changed as shown in Table 1, and 2) each "First ETL layer" compound shown in Table 1 was vacuum-deposited on the emission layer to form a first electron transport layer having a thickness of 10 nm, each "Second ETL layer" compound shown in Table 1 was vacuum-deposited on the first electron transport layer to form a second electron transport layer having a thickness of 20 nm, and an electron injection layer was formed on each second electron transport layer.

### Examples 1-17 and 1-18

Additional organic light-emitting devices of Examples 1-17 and 1-18 were manufactured in substantially the same manner as in Example 1-1, except that: 1) the host material used in each emission layer was changed as shown in Table 1, and 2) each "ETL layer" compound shown in Table 1 and LiQ were co-deposited at a weight ratio of 5:5 to form each electron transport layer.

### Examples 1-19 and 1-20

Additional organic light-emitting devices of Examples 1-19 and 1-20 were manufactured in substantially the same manner as in Example 1-9, except that: 1) the host material used in each emission layer was changed as shown in Table 1, and 2) each "ETL" compound shown in Table 1 and LiQ were co-deposited at a weight ratio of 5:5 to form each second electron transport layer.

### Evaluation Example 1 (Evaluation of Red Light-Emitting Device)

The efficiency (cd/A) and lifespan (T₉₀) of each of the organic light-emitting devices of Examples 1-1 to 1-20 and Comparative Examples 1 to 4 were measured at 5 mA/cm² using a Keithley SMU 236 and a PR650 luminance measuring meter. The results thereof are shown in Table 1.

The lifespan (T₉₀) was measured as the period of time elapsed when the luminance of the organic light-emitting device became 90% of the initial luminance.

**Table 1**

| Device | Host | First ETL (10 nm) | Second ETL (20 nm) | Efficiency (cd/A) | Lifespan (T₉₀, hr) |
|---|---|---|---|---|---|
| Example 1-1 | 2-14 | 1-17 | | 23.1 | 410 |
| Example 1-2 | 2-22 | 1-80 | | 23.3 | 480 |
| Example 1-3 | 2-27 | 1-145 | | 24.0 | 420 |
| Example 1-4 | 2-55 | 1-182 | | 23.7 | 450 |
| Example 1-5 | 2-70 | 1-131 | | 22.8 | 410 |
| Example 1-6 | 2-75 | 1-140 | | 23.5 | 400 |
| Example 1-7 | 2-123 | 1-131 | | 23.9 | 450 |
| Example 1-8 | 2-178 | 1-52 | | 22.5 | 430 |
| Example 1-9 | 2-16 | 1-164 | Alq₃ | 23.3 | 420 |
| Example 1-10 | 2-123 | 1-176 | Alq₃ | 24.1 | 430 |
| Example 1-11 | 2-22 | 1-205 | Alq₃ | 24.3 | 430 |
| Example 1-12 | 2-55 | 1-207 | Alq₃ | 24.0 | 470 |
| Example 1-13 | 2-16 | BAlq | 1-130 | 22.9 | 430 |
| Example 1-14 | 2-106 | BAlq | 1-76 | 22.9 | 420 |
| Example 1-15 | 2-120 | 1-200 | 1-17 | 23.8 | 480 |
| Example 1-16 | 2-153 | 1-205 | 1-145 | 24.3 | 450 |
| Example 1-17 | 2-183 | 1-131:LiQ (5:5) | | 23.7 | 440 |
| Example 1-18 | 2-123 | 1-92:LiQ (5:5) | | 24.0 | 420 |
| Example 1-19 | 2-120 | 1-200 | 1-145:LiQ (5:5) | 24.2 | 500 |
| Example 1-20 | 2-183 | 1-205 | 1-164:LiQ (5:5) | 23.6 | 480 |
| Comparative Example 1-1 | CBP | 1-131 | | 20.7 | 240 |
| Comparative Example 1-2 | 2-70 | Alq₃ | | 21.6 | 280 |
| Comparative Example 1-3 | PGH₂ | ET1 | | 21.8 | 340 |
| Comparative Example 1-4 | PGH3 | ET2 | | 22.1 | 320 |

Referring to Table 1, it was confirmed that the organic light-emitting devices of Examples 1-1 to 1-20 each had high efficiency and a long lifespan, compared to those of Comparative Examples 1-1 to 1-4.

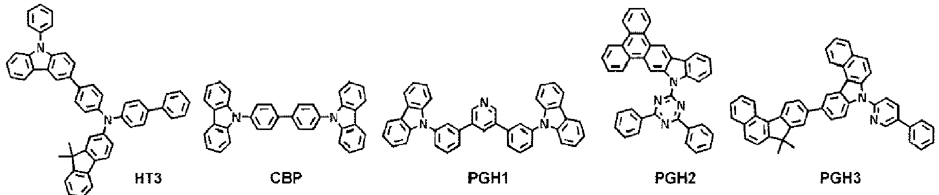

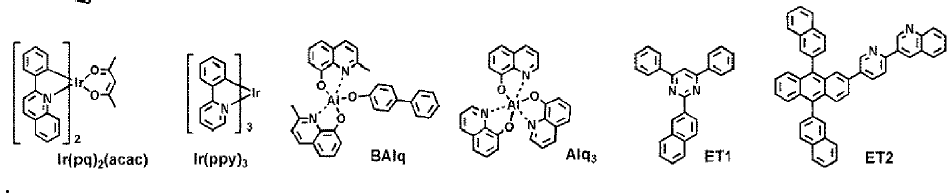

### Example 2-1 (Green Light-Emitting Device)

An organic light-emitting device was manufactured in substantially the same manner as in Example 1-1, except that Ir(ppy)₃ was used as a dopant (instead of Ir(pq)₂acac) in forming an emission layer.

### Examples 2-2 to 2-8 and Comparative Examples 2-1 and 2-4

Additional organic light-emitting devices of Examples 2-2 to 2-8 and Comparative Examples 2-1 to 2-4 were manufactured in substantially the same manner as in Example 2-1, except that the host and an electron transport layer materials in an emission layer were each changed as shown in Table 2.

### Examples 2-9 to 2-12

Additional organic light-emitting devices of Examples 2-9 to 2-12 were manufactured in substantially the same manner as in Example 2-1, except that: 1) the host material in each emission layer was changed as shown in Table 2, and 2) each "first ETL" compound shown in Table 2 was vacuum-deposited on the emission layer to form a first electron transport layer having a thickness of 10 nm, each "second ETL" compound shown in Table 2 was vacuum-deposited on the first electron transport layer to form a second electron transport layer having a thickness of 20 nm, and an electron injection layer was formed on each second electron transport layer.

### Examples 2-13 and 2-14

Additional organic light-emitting devices of Examples 2-13 and 2-14 were manufactured in substantially the same manner as in Example 2-1, except that: 1) the host material in each emission layer was changed as shown in Table 2, and 2) each "ETL" compound shown in Table 2 and LiQ were co-deposited at a weight ratio of 5:5 to form an electron transport layer.

### Examples 2-15 to 2-20

Additional organic light-emitting devices of Examples 2-15 to 2-20 were manufactured in substantially the same manner as in Example 2-1, except that: 1) two compounds as shown in Table 2 were used as a host at a weight ratio of 5:5 in forming each emission layer, and 2) the material of each electron transport layer was changed as shown in Table 2.

### Examples 2-21 and 2-23

Additional organic light-emitting devices of Examples 2-21 to 2-23 were manufactured in substantially the same manner as in Example 2-13, except that: 1) two compounds as shown in Table 2 were used as a host at a weight ratio of 5:5 in forming each emission layer, and 2) each "Second ETL" compound shown in Table 2 and LiQ were co-deposited at a weight ratio of 5:5 to form a second electron transport layer.

### Evaluation Example 2 (Evaluation of Green Light-Emitting Device)

The efficiency and lifespan of each of the organic light-emitting devices of Examples 2-1 to 2-23 and Comparative Examples 2-1 to 2-4 were evaluated in substantially the same manner as described in Evaluation Example 1. The results thereof are shown in Table 2:

**Table 2**

| Device | Host | First ETL (10 nm) | Second ETL (20 nm) | Efficiency (cd/A) | Lifespan (T90, hr) |
|---|---|---|---|---|---|
| Example 2-1 | 2-14 | 1-17 | | 42.7 | 290 |
| Example 2-2 | 2-22 | 1-80 | | 43.1 | 270 |
| Example 2-3 | 2-34 | 1-145 | | 43.5 | 310 |
| Example 2-4 | 2-106 | 1-147 | | 42.5 | 270 |
| Example 2-5 | 2-131 | 1-182 | | 42.8 | 300 |
| Example 2-6 | 2-146 | 1-17 | | 43.3 | 290 |
| Example 2-7 | 2-152 | 1-141 | | 41.9 | 280 |
| Example 2-8 | 2-176 | 1-131 | | 42.1 | 300 |
| Example 2-9 | 2-14 | 1-164 | Alq₃ | 43.5 | 280 |
| Example 2-10 | 2-107 | 1-205 | Alq₃ | 43.1 | 290 |
| Example 2-11 | 2-176 | BAlq | 1-71 | 42.7 | 320 |
| Example 2-12 | 2-159 | BAlq | 1-173 | 42.5 | 300 |
| Example 2-13 | 2-176 | 1-147:LiQ(5:5) | | 43.3 | 330 |
| Example 2-14 | 2-192 | 1-146:LiQ (5:5) | | 42.9 | 310 |
| Example 2-15 | 2-6:PGH1 | 1-131 | | 43.7 | 370 |
| Example 2-16 | 2-92:PGH1 | 1-136 | | 43.4 | 360 |
| Example 2-17 | 2-106:1-130 | 1-172 | | 44.2 | 380 |
| Example 2-18 | 2-7:2-13 | 1-17 | | 43.9 | 380 |
| Example 2-19 | 2-84:2-108 | 1-80 | | 44.1 | 350 |
| Example 2-20 | 2-91:1-164 | 1-145 | | 44.5 | 400 |
| Example 2-21 | 2-7:2-13 | 2-108 | 1-17:LiQ(5:5) | 44.1 | 370 |
| Example 2-22 | 2-84:2-108 | 2-101 | 1-80:LiQ(5:5) | 44.4 | 350 |
| Example 2-23 | 2-91:1-164 | 1-198 | 1-145:LiQ(5:5) | 44.7 | 420 |
| Comparative Example 2-1 | CBP | 1-131 | | 37.1 | 170 |
| Comparative Example 2-2 | 2-176 | Alq₃ | | 38.3 | 200 |
| Comparative Example 2-3 | PGH2 | ET1 | | 40.1 | 220 |
| Comparative Example 2-4 | PGH3 | ET2 | | 39.5 | 220 |

Referring to Table 2, it was confirmed that the organic light-emitting devices of Examples 2-1 to 2-23 had high efficiency and a long lifespan, compared to those of Comparative Examples 2-1 to 2-4.

An organic light-emitting device according to one or more embodiments may have both (e.g., simultaneously exhibit) high efficiency and a long lifespan.

As used herein, the terms "use", "using", and "used" may be considered synonymous with the terms "utilize", "utilizing", and "utilized", respectively. Further, the use of "may" when describing embodiments of the present disclosure refers to "one or more embodiments of the present disclosure".

As used herein, the terms "substantially", "about", and similar terms are used as terms of approximation and not as terms of degree, and are intended to account for the inherent deviations in measured or calculated values that would be recognized by those of ordinary skill in the art.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

It should be understood that the embodiments described herein should be considered in a descriptive sense only and not for purposes of limitation. Descriptions of features or aspects within each embodiment should typically be considered as being available for other similar features or aspects in other embodiments.

While one or more embodiments have been described with reference to the drawings, it will be understood by those of ordinary skill in the art that various changes in form and details may be made therein without departing from the scope of the present disclosure, as defined by the following claims.

## Claims

1. An organic light-emitting device comprising:
a first electrode;
a second electrode facing the first electrode;
an emission layer between the first electrode and the second electrode;
a hole transport region between the first electrode and the emission layer; and
an electron transport region between the emission layer and the second electrode,
wherein:
the electron transport region comprises at least one compound represented by Formula 1, and
the emission layer comprises at least one compound represented by one selected from Formulae 2-1, 2-2, and 2-3: 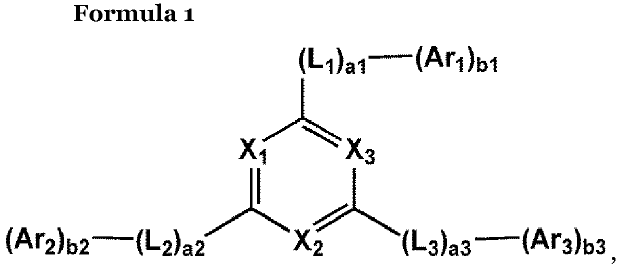 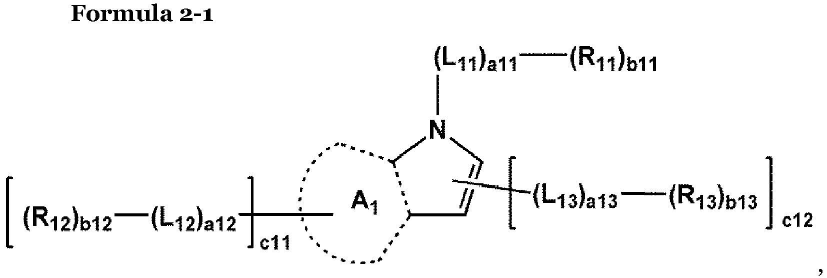 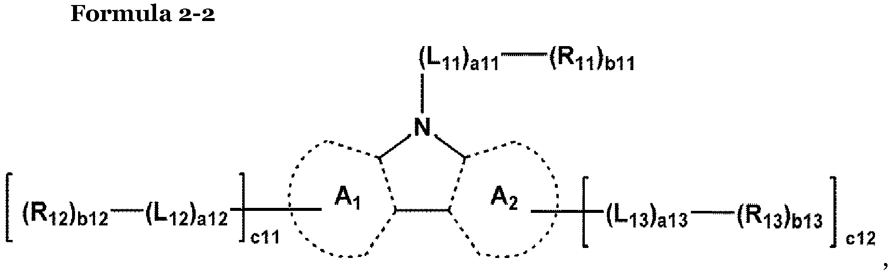 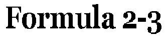 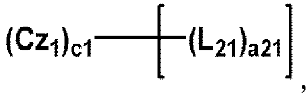 in which Cz₁ is a group represented by Formula 2A or 2B, 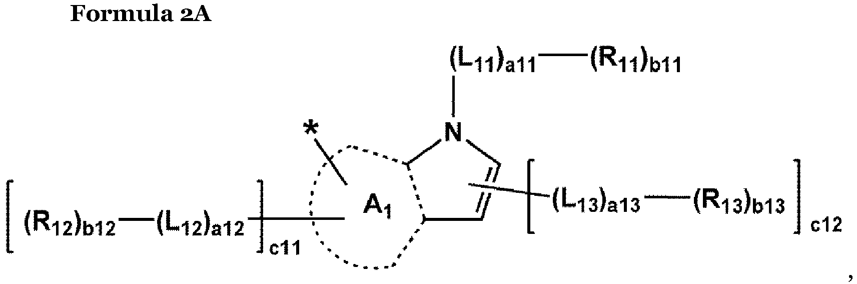 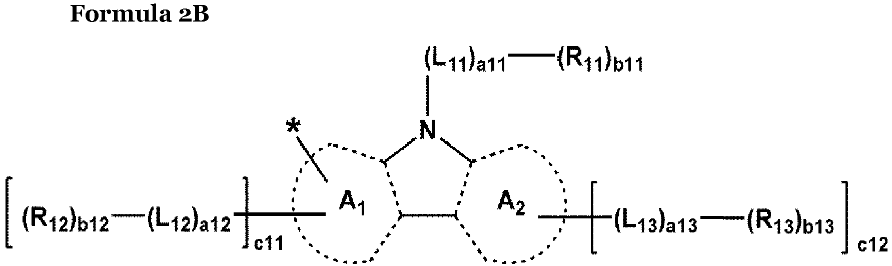
wherein, in Formula 1, X₁ is N or C(R₁), X₂ is N or C(R₂), X₃ is N or C(R₃), and at least one selected from X₁ to X₃ is N,
R₁ to R₃ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₃-C₁₀ cycloalkenyl group, a substituted or unsubstituted C₆-C₆₀ aryl group, and -Si(Q₁)(Q₂)(Q₃),
L₁ to L₃ in Formula 1 are each independently selected from a substituted or unsubstituted C₃-C₁₀ cycloalkylene group, a substituted or unsubstituted C₃-C₁₀ cycloalkenylene group, a substituted or unsubstituted C₆-C₆₀ arylene group, a substituted or unsubstituted divalent non-aromatic condensed C8-C60 polycyclic group, and a group represented by any of Formulae 3A to 3G, 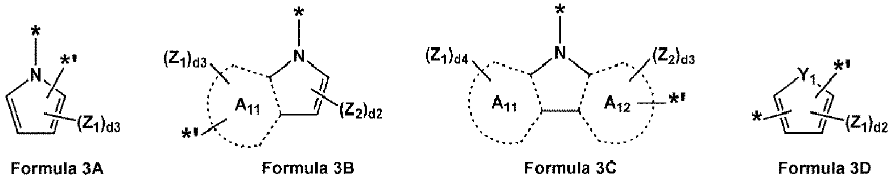 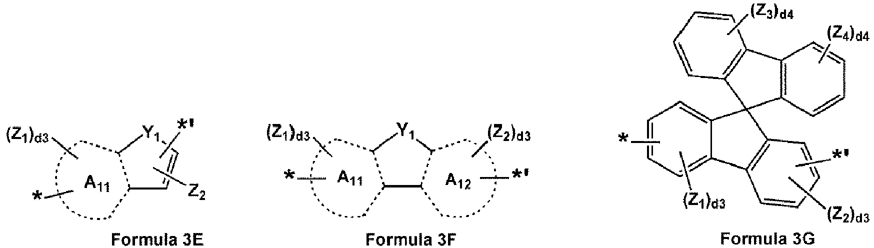
a1 to a3 in Formula 1 are each independently 0, 1, 2, 3, 4, or 5,
Ar₁ to Ar₃ in Formula 1 are each independently selected from a substituted or unsubstituted C₁-C₆₀ alkyl group, a substituted or unsubstituted C₃-C₁₀ cycloalkyl group, a substituted or unsubstituted C₃-C₁₀ cycloalkenyl group, a substituted or unsubstituted C₆-C₆₀ aryl group, a substituted or unsubstituted monovalent non-aromatic condensed C8-C60 polycyclic group, -Si(Q₁)(Q₂)(Q₃) and a group represented by any of Formulae 4A to 4G, 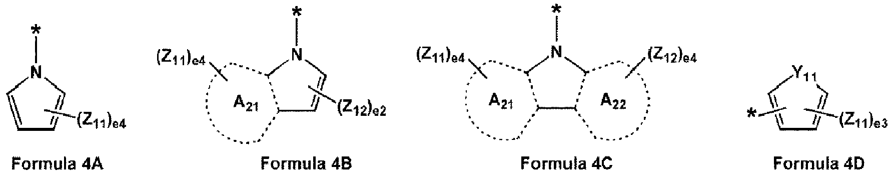 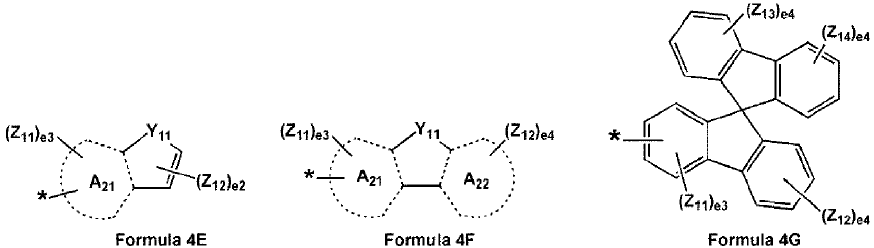
provided that at least one selected from Ar₁ to Ar₃ is a substituted or unsubstituted aryl group having three or more rings condensed with one another or a substituted or unsubstituted monovalent non-aromatic condensed C8-C60 polycyclic group having three or more rings condensed with one another,
b1 to b3 in Formula 1 are each independently 1, 2, or 3, provided that each of b1 to b3 is 1 when each respective a1 to a3 is zero,rings A₁₁, A₁₂, A₂₁, and A₂₂ in Formulae 3B, 3C, 3E, 3F, 4B, 4C, 4E, and 4F are each independently a C₅-C₆₀ carbocyclic group,
Y₁ in Formulae 3D to 3F is O, S, C(Z₃)(Z₄), N(Z₅), or Si(Z₆)(Z₇),
Y₁₁ in Formulae 4D to 4F is O, S, C(Z₁₃)(Z₁₄), N(Z₁₅), or Si(Z₁₆)(Z₁₇),
Z₁ to Z₇ and Z₁₁ to Z₁₇ in Formulae 3A to 3G and 4A to 4G are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃),
* and *' in Formulae 3A to 3G and 4A to 4G each indicate a binding site to a neighboring atom,
c1 is 2, 3, 4, or 5, and two or more Cz₁(s) are identical to or different from each other, provided that c1 is 2 when a2i is zero,
in Formulae 2-1, 2-2, 2A, and 2B, rings A₁ and A₂ are each independently a C₅-C₆₀ carbocyclic group or a C₂-C₆₀ heterocyclic group,
L₁₁ to L₁₃ and L₂₁ in Formulae 2-1 to 2-3, 2A, and 2B are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
a11 to a13 and a21 in Formulae 2-1 to 2-3, 2A, and 2B are each independently 0, 1, 2, 3, 4, or 5,
R₁₁ to R₁₃ in Formulae 2-1, 2-2, 2A, and 2B are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂),
b11 to b13 in Formulae 2-1, 2-2, 2A, and 2B are each independently 1, 2, 3, 4, or 5, provided that each of b11 to b13 is 1 when each respective a11 to a13 is zero,
c11 and c12 in Formulae 2-1, 2-2, 2A, and 2B are each independently 0, 1, or 2,
the compound represented by one selected from Formulae 2-1, 2-2, and 2-3 is not CBP,
d2 in Formulae 3B and 3D is an integer selected from 0 to 2,
d3 in Formulae 3A to 3C and 3E to 3G is an integer selected from 0 to 3,
d4 in Formulae 3C and 3G is an integer selected from 0 to 4,
e2 in Formulae 4B and 4E is an integer selected from 0 to 2,
e3 in Formulae 4D to 4G is an integer selected from 0 to 3,
e4 in Formulae 4A to 4C, 4F, and 4G is an integer selected from 0 to 4, and
the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed C8-C60 polycyclic group, the substituted divalent non-aromatic condensed 8- to 60-membered heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed C8-C60 polycyclic group, and the substituted monovalent non-aromatic condensed 8- to 60-membered heteropolycyclic group are each independently substituted with one or more substituent selected from the group consisting of:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C8-C60 polycyclic group, and a monovalent non-aromatic condensed 8- to 60-membered heteropolycyclic group.

2. The organic light-emitting device of claim 1, wherein two or three selected from X₁ to X₃ in Formula 1 are N.

3. The organic light-emitting device of claim 1 or 2, wherein:
L₁ to L₃ in Formula 1 are each independently selected from the group consisting of:
a phenylene group, a naphthylene group, a phenanthrenylene group, an anthracenylene group, a fluoranthenylene group, a triphenylenylene group, a pyrenylene group, and a chrysenylene group;
a phenylene group, a naphthylene group, a phenanthrenylene group, an anthracenylene group, a fluoranthenylene group, a triphenylenylene group, a pyrenylene group, and a chrysenylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃), and
a group represented by any of Formulae 3A to 3G,
Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group, and
a1 to a3 in Formula 1 are each independently 0, 1, or 2.

4. The organic light-emitting device of any one of the preceding claims, wherein:
Ar₁ to Ar₃ in Formula 1 are each independently selected from the group consisting of:
a phenyl group, a naphthyl group, a phenanthrenyl group, an anthracenyl group, a fluoranthenyl group, a triphenylenyl group, a pyrenyl group, and a chrysenyl group;
a phenyl group, a naphthyl group, a phenanthrenyl group, an anthracenyl group, a fluoranthenyl group, a triphenylenyl group, a pyrenyl group, and a chrysenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃);
a group represented by any of Formulae 4A to 4G; and
-Si(Q₁)(Q₂)(Q₃), and
at least one selected from Ar₁ to Ar₃ is each independently selected from the group consisting of:
a phenanthrenyl group, an anthracenyl group, a fluoranthenyl group, a triphenylenyl group, a pyrenyl group, and a chrysenyl group;
a phenanthrenyl group, an anthracenyl group, a fluoranthenyl group, a triphenylenyl group, a pyrenyl group, and a chrysenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, a benzofuranyl group, a benzothiophenyl group, a benzosilolyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, and -Si(Q₃₁)(Q₃₂)(Q₃₃), and
a group represented by any of Formulae 4C, 4F, and 4G,
wherein Q₁ to Q₃ and Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

5. The organic light-emitting device of any one of the preceding claims, wherein:
rings A₁₁, A₁₂, A₂₁, and A₂₂ in Formulae 3B, 3C, 3E, 3F, 4B, 4C, 4E, and 4F are each independently a cyclohexane group, a cyclohexene group, a benzene group, a naphthalene group, or a phenanthrene group.

6. The organic light-emitting device of any one of claims 1 to 3 or 5, wherein:
Ar₁ to Ar₃ in Formula 1 are each independently selected from groups represented by Formulae 4-1 to 4-52, and at least one selected from Ar₁ to Ar₃ is selected from groups represented by Formulae 4-4 to 4-52: 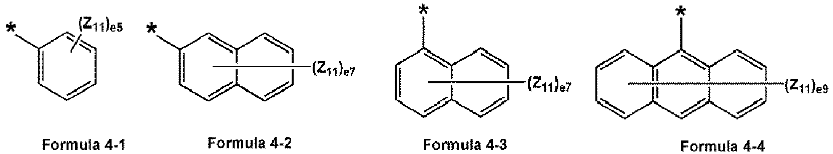 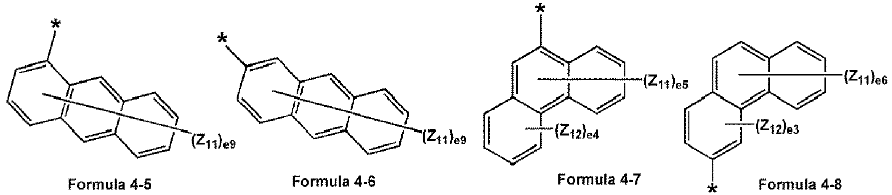 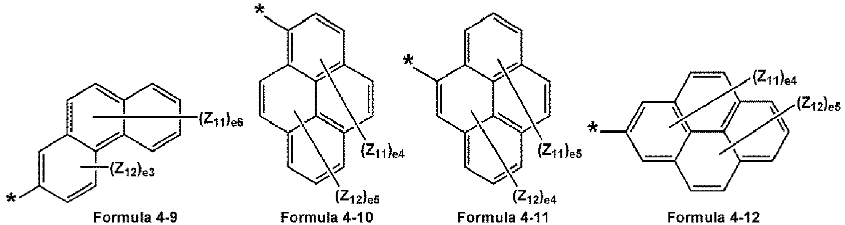 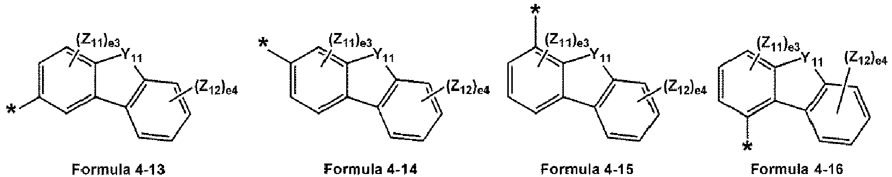 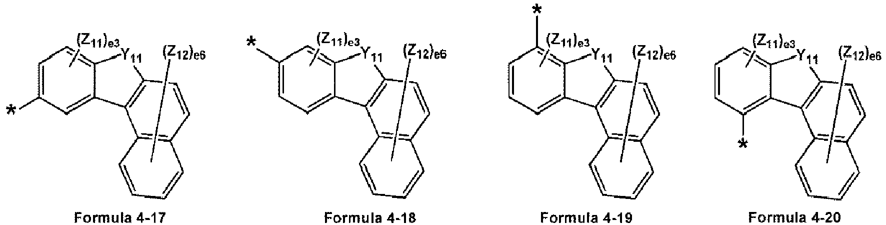 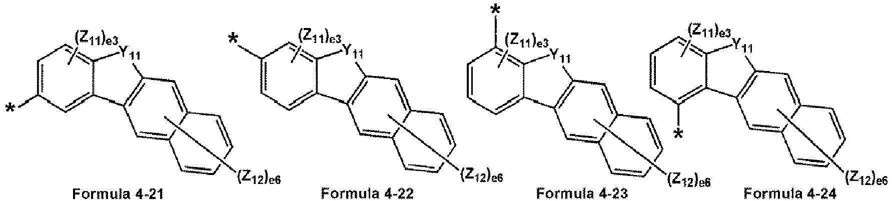 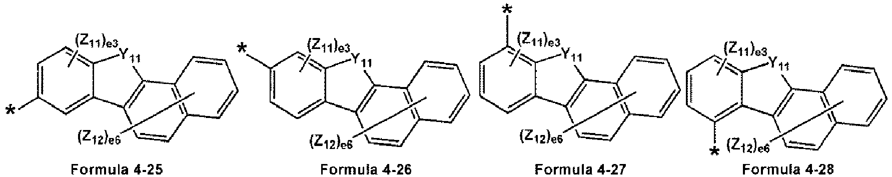 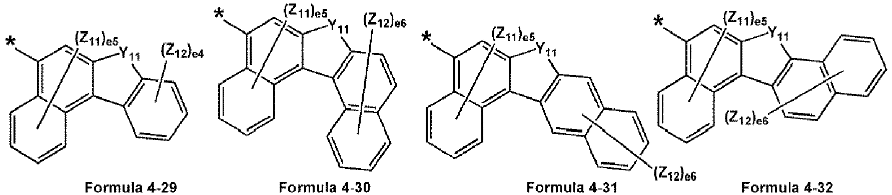 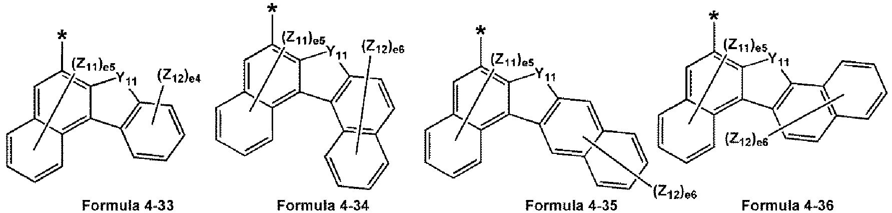 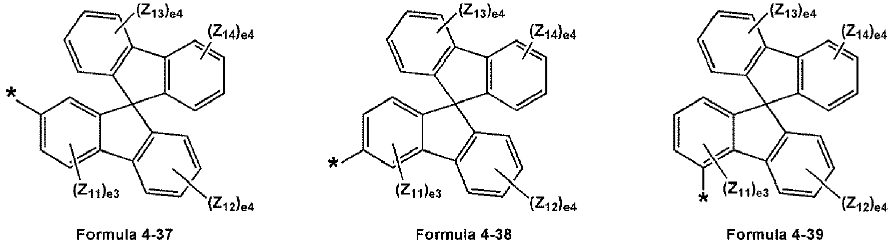 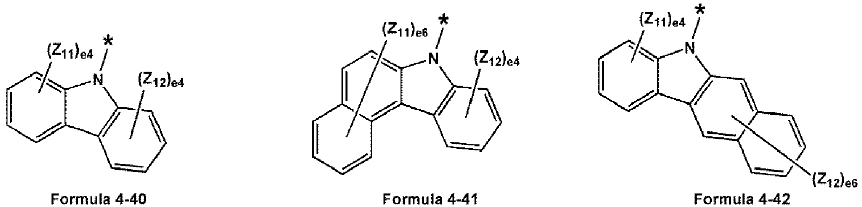 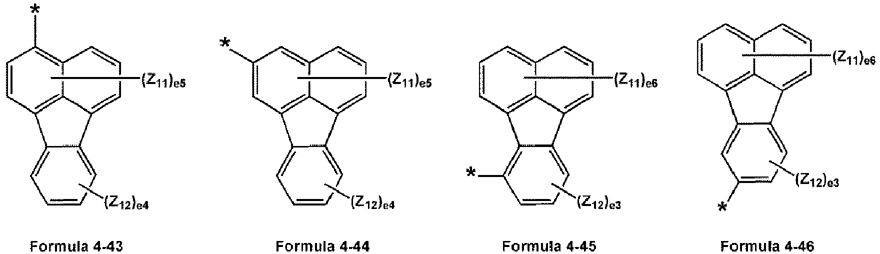 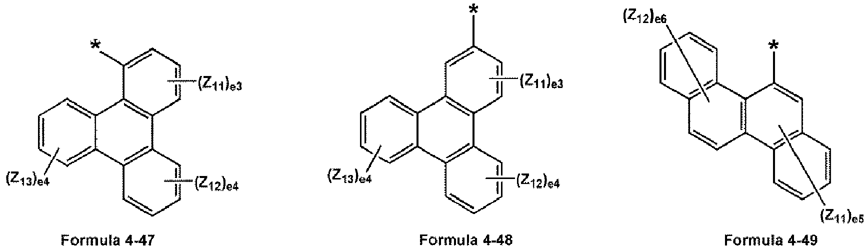 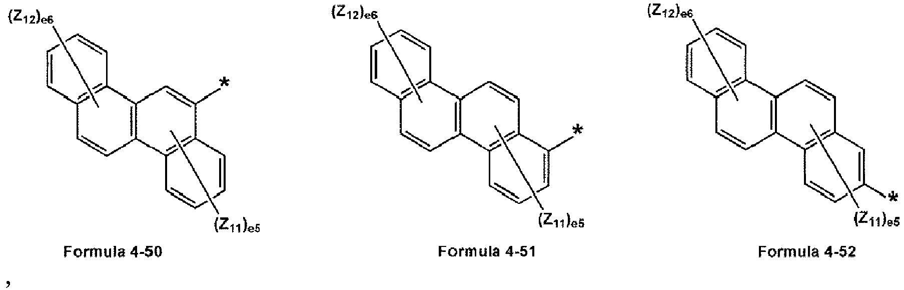
wherein, in Formulae 4-1 to 4-52,
Y₁₁, Z₁₁ to Z₁₄ and e2 to e4 are as defined in claim 1,
e5 is an integer selected from 0 to 5,
e6 is an integer selected from 0 to 6,
e7 is an integer selected from 0 to 7,
e9 is an integer selected from 0 to 9, and
* indicates a binding site to a neighboring atom;
provided that at least one selected from Ar₁ to Ar₃ is a substituted or unsubstituted aryl group having three or more rings condensed with one another or a substituted or unsubstituted monovalent non-aromatic condensed C8-C60 polycyclic group having three or more rings condensed with one another.

7. The organic light-emitting device of any one of the preceding claims, wherein:
the emission layer comprises at least one compound represented by Formula 2-3, and
c1 and a21 in Formula 2-3 are respectively two and zero.

8. The organic light-emitting device of any one of the preceding claims, wherein:
in Formulae 2-1, 2-2, 2A, and 2B, rings A₁ and A₂ are each independently a cyclohexane group, a cyclohexene group, a benzene group, a naphthalene group, a phenanthrene group, a pyridine group, a pyrimidine group, a pyrazine group, a quinoline group, an isoquinoline group, a quinoxaline group, a quinazoline group, a benzoquinoline group, a benzoisoquinoline group, a benzoquinoxaline group, a benzoquinazoline group, or a phenanthroline group.

9. The organic light-emitting device of any one of the preceding claims, wherein:
L₁₁ to L₁₃ and L₂₁ in Formulae 2-1 to 2-3, 2A, and 2B are each independently selected from the group consisting of:
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₂₀ cycloalkyl group, a C₆-C₂₀ aryl group, a C₃-C₂₀ heteroaryl group, a biphenyl group, - Si(Q₃₁)(Q₃₂)(Q₃₃), -S(=O)₂(Q₃₁), and -P(=O)(Q₃₁)(Q₃₂),
wherein Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
a11 in Formulae 2-1, 2-2, 2A, and 2B is 0, 1, 2, or 3, and
a12 and a13 in Formulae 2-1, 2-2, 2A, and 2B are each independently 0 or 1.

10. The organic light-emitting device of any one of the preceding claims, wherein:
in Formulae 2-1, 2-2, 2A, and 2B,
R₁₁ to R₁₃ are each independently selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, and a hydrazono group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₂₀ cycloalkyl group, a C₆-C₂₀ aryl group, a C₃-C₂₀ heteroaryl group, a biphenyl group, -Si(Q₃₁)(Q₃₂)(Q₃₃),-S(=O)₂(Q₃₁), and -P(=O)(Q₃₁)(Q₃₂); and
-Si(Q₁)(_{Q2})(Q₃), -S(=O)₂(Q1), and -P(=O)(Q₁)(Q₂),
wherein Q₁ to Q₃ and Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
b11 in Formulae 2-1, 2-2, 2A, and 2B is 1, 2, or 3, and
b12 and b13 in Formulae 2-1, 2-2, 2A, and 2B are each independently 0 or 1.

11. The organic light-emitting device of any one of claims 1 to 6, wherein:
the emission layer comprises at least one compound represented by one selected from Formulae 2-1(1) and 2-2(1) to 2-2(18), or at least one compound represented by Formula 2-3 in which Cz₁ is selected from groups represented by Formulae 2A(1) to 2A(4) and 2B(1) to 2B(20): 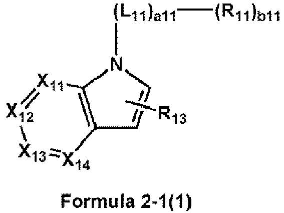 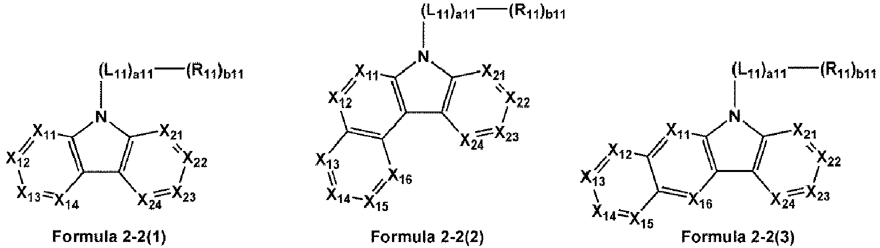 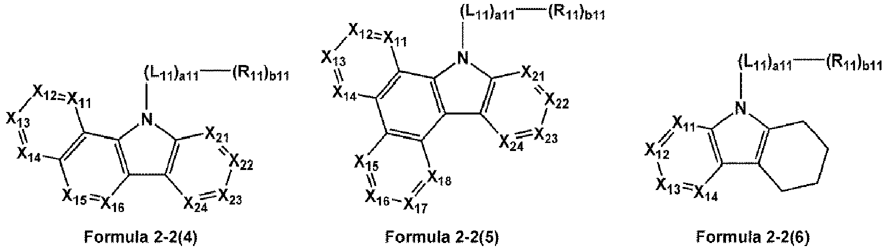 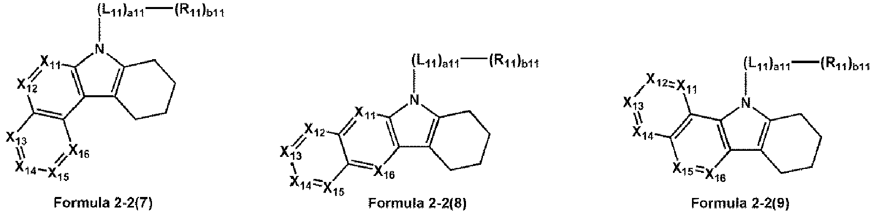 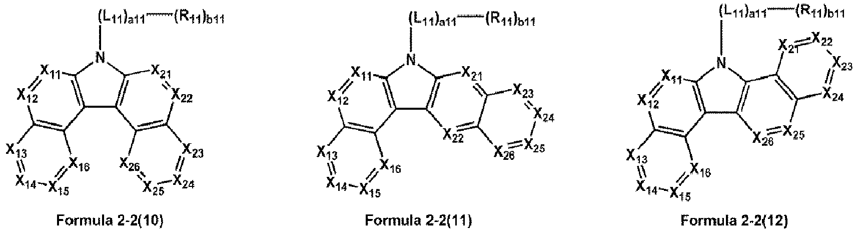 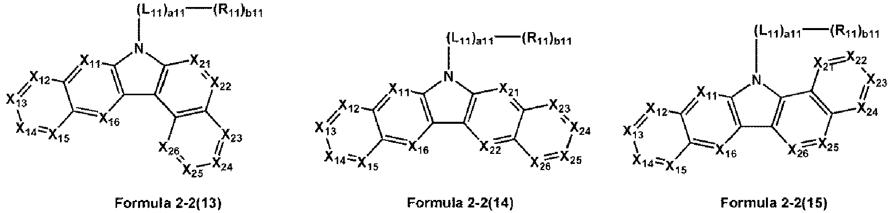 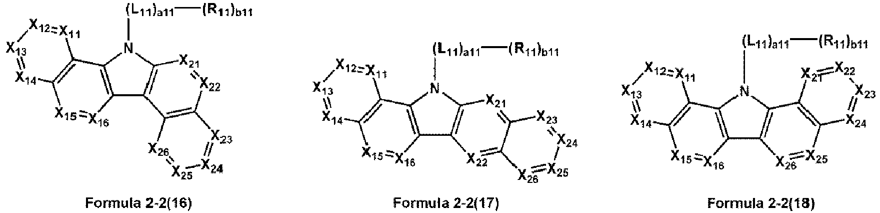 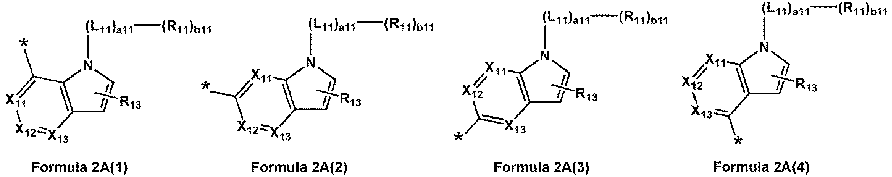 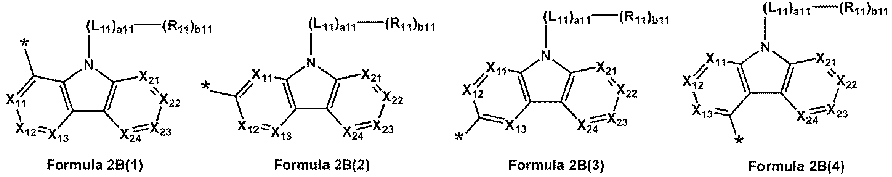 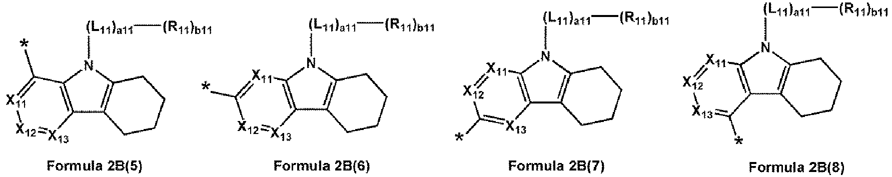 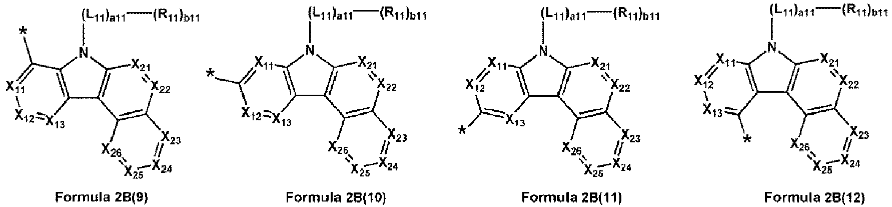 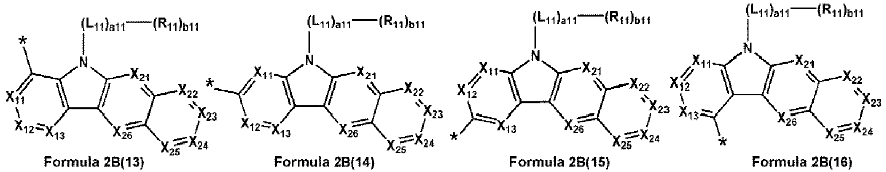 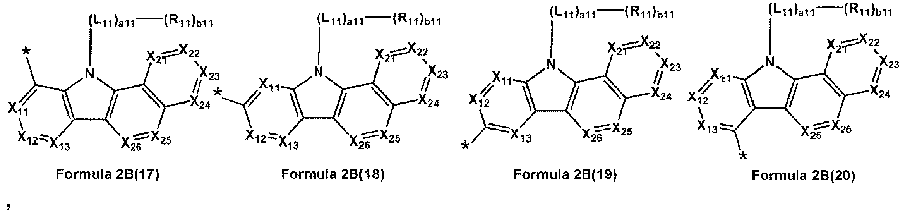
wherein, in Formulae 2-1(1), 2-2(1) to 2-2(18), 2A(1) to 2A(4), and 2B(1) to 2B(20),
L₁₁, a11, R₁₁, b11, and R₁₃ are each independently the same as described above, X₁₁ is N or C(R₂₁), X₁₂ is N or C(R₂₂), X₁₃ is N or C(R₂₃), X₁₄ is N or C(R₂₄), X₁₅ is N or C(R₂₅), X₁₆ is N or C(R₂₆), X₁₇ is N or C(R₂₇), X₁₈ is N or C(R₂₈), X₂₁ is N or C(R₃₁), X₂₂ is N or C(R₃₂), X₂₃ is N or C(R₃₃), X₂₄ is N or C(R₃₄), X₂₅ is N or C(R₃₅), and X₂₆ is N or C(R₃₆),
R₂₁ to R₂₈ are each independently a group *-(L₁₂)ₐ₁₂-(R₁₂)_{b12}, and R₃₁ to R₃₆ are each independently a group *-(L₁₃)ₐ₁₃-(R₁₃)_{b13}, wherein L₁₂, L₁₃, a12, a13, R₁₂, R₁₃, b12 and b13 are each independently as defined in one of claims 1, 9 and 10, and
* indicates a binding site to a neighboring atom.

12. The organic light-emitting device of any one of the preceding claims, wherein:
the electron transport region comprises an electron transport layer and an electron injection layer, and
the at least one compound represented by Formula 1 is comprised in the electron transport layer;
preferably wherein:
at least one layer selected from the electron transport layer and the electron injection layer comprises an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

13. The organic light-emitting device of any one of the preceding claims, wherein:
the electron transport region comprises a first electron transport layer, a second electron transport layer, and an electron injection layer,
the first electron transport layer is between the emission layer and the second electron transport layer,
the second electron transport layer is between the first electron transport layer and the electron injection layer, and
at least one selected from the first electron transport layer and the second electron transport layer comprises the at least one compound represented by Formula 1;
preferably wherein:
at least one selected from the first electron transport layer, the second electron transport layer, and the electron injection layer comprises an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

14. The organic light-emitting device of any one of the preceding claims wherein:
(a) the electron transport region comprises an electron injection layer, and the electron injection layer comprises Li, Na, K, Rb, Cs, Mg, Ca, Er, Tm, Yb, or a combination thereof; and/or
(b) the emission layer further comprises a phosphorescent dopant; and/or
(c) the hole transport region comprises a p-dopant, and the p-dopant has a lowest unoccupied molecular orbital (LUMO) energy level of -3.5 eV or less; preferably wherein the p-dopant comprises a cyano group-containing compound.

15. The organic light-emitting device of any one of the preceding claims, wherein:
the emission layer comprises a first-color-light emission layer,
the organic light-emitting device further comprises: i) at least one second-color-light emission layer, or ii) at least one second-color-light emission layer and at least one third-color-light emission layer, both between the first electrode and the second electrode,
wherein a maximum emission wavelength of the first-color-light emission layer, a maximum emission wavelength of the second-color-light emission layer, and a maximum emission wavelength of the third-color-light emission layer are identical to or different from one another, and
the organic light-emitting device emits mixed light comprising a first-color-light and a second-color-light, or mixed light comprising the first-color-light, the second-color-light, and a third-color-light.
